(19) Europäisches Patentamt
European Patent Office
Office européen des brevets

(11) EP 4 636 485 A1

(12) **EUROPEAN PATENT APPLICATION**

(43) Date of publication:
**22.10.2025 Bulletin 2025/43**

(21) Application number: **25171116.4**

(22) Date of filing: **16.04.2025**

(51) International Patent Classification (IPC):
***G03F 7/037*** *(2006.01)* ***G03F 7/038*** *(2006.01)*

(52) Cooperative Patent Classification (CPC):
**G03F 7/0388; G03F 7/027; G03F 7/031; G03F 7/037; G03F 7/0387; G03F 7/40**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **18.04.2024 JP 2024067315**

(71) Applicant: **Shin-Etsu Chemical Co., Ltd.**
**Tokyo 100-0005 (JP)**

(72) Inventors:
- **Takemura, Katsuya**
  **Niigata (JP)**
- **Iio, Masashi**
  **Niigata (JP)**
- **Urano, Hiroyuki**
  **Niigata (JP)**
- **Watanabe, Osamu**
  **Niigata (JP)**

(74) Representative: **Schicker, Silvia**
**Wuesthoff & Wuesthoff**
**Patentanwälte und Rechtsanwalt PartG mbB**
**Schweigerstraße 2**
**81541 München (DE)**

(54) **NEGATIVE PHOTOSENSITIVE RESIN COMPOSITION, PATTERNING PROCESS, METHOD FOR FORMING CURED FILM, INTERLAYER INSULATING FILM, SURFACE PROTECTIVE FILM, AND ELECTRONIC COMPONENT**

(57) The present invention is a negative photosensitive resin composition containing a nitrogen-containing organic compound represented by the following general formula (1). This can provide: a photosensitive resin composition, containing a polyimide precursor, that can undergo an imide ring-closing reaction at a low temperature, has excellent stability of the composition, and makes fine patterning possible, and after curing, can be provided with resistance to chemicals; a patterning process using the photosensitive resin composition; and an interlayer insulating film and a semiconductor device including a cured film of the photosensitive resin composition.

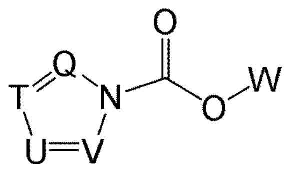

(1)

EP 4 636 485 A1

## Description

### TECHNICAL FIELD

The present invention relates to: a negative photosensitive resin composition; a patterning process using the negative photosensitive resin composition and according to which development with an organic solvent is possible; a method for forming a cured film; an interlayer insulating film; a surface protective film; and an electronic component.

### BACKGROUND ART

As miniaturization and higher performance of various electronic devices such as personal computers, digital cameras, and mobile phones advance, demands for further miniaturization, thinning, and higher density in semiconductor devices are also increasing rapidly. It is thus desired to develop a photosensitive insulation material that can accommodate an increase in surface area of a substrate for the sake of higher productivity and can form a fine pattern with high aspect ratio on a substrate, in high-density mounting technologies including chip size package or chip scale package (CSP) and three-dimensional lamination.

In a high-density mounting technology such as a three-dimensional lamination, as a photosensitive insulation material capable of forming a pattern on a substrate, a polyimide film has been utilized as a protective film or an interlayer insulating film, its insulation property, mechanical strength, adhesiveness with a substrate, and so forth have continued to draw attention, and its development is active even now.

Polyimide or the like for forming a polyimide film has low solubility in a solvent, and therefore, is used in the state of a precursor before imide ring-closing reaction. The precursor is applied or laminated onto a substrate, then heated to cyclize the polyimide precursor to form a cured film, and thus, is used for a protective film, an interlayer insulating film, etc.

Conventionally, there are proposals for a material, being a precursor of a polyimide, that allows pattern formation, for example, a material in which a photosensitive group has been introduced into a carboxy group of a polyamic acid via an ester bond (Patent Document 1, Patent Document 2). However, in these proposals, after a patterned film is formed, an imidization treatment at a high temperature of over 300°C is essential for obtaining the target polyimide film, and to withstand this high temperature, there have been problems that the underlying substrate is limited, the copper of circuits is oxidized, there are risks of electronic components or the like being thermally damaged and so forth, etc.

Patent Document 3 discloses a polyimide precursor composition containing a polyimide precursor, a thermal base generator, which generates a base due to heat, and a solvent, the polyimide precursor being a polyamic acid and the thermal base generator is a neutral compound that undergoes thermal decomposition when heated at a temperature of 200°C or lower and generates a secondary amine. It is indicated that, since the secondary amine generated by thermal decomposition promotes imide ring-closing reaction, treatment at 200°C or lower is possible.

However, a cured film using the composition disclosed in Patent Document 3 is poor in corrosion resistance and chemical resistance, which are properties needed in a protective film, an interlayer insulating film, etc. in some cases. In addition, the composition has a problem of storage stability, where cyclization reaction of the polyimide precursor resin progresses during storage of the composition and gelation or the like occurs.

Meanwhile, Patent Document 4 and Patent Document 5 disclose a composition containing an imidazole as an imidization catalyst to promote an imide ring-closing reaction with a polyimide precursor. However, there is no disclosure of a photosensitive resin composition, required in high-density mounting technology, that makes it possible to form a pattern on a substrate, and there is no disclosure of low-temperature imidization either. Furthermore, the imidazoles of the imidization catalyst disclosed in Patent Document 4 and Patent Document 5, except for N-tert-butoxycarbonylimidazole (N-Boc-imidazole), have a problem in storage stability, and undergo gelation during storage of the composition. Moreover, when the contained amount of the imidazole of the imidization catalyst is as described in Patent Document 4 and Patent Document 5, deformation (thermal flow) of the pattern due to heat occurs in a curing reaction after pattern formation and a fine pattern having a high aspect ratio cannot be hoped for, and the glass transition point (Tg.) of the obtained cured film decreases. Therefore, the composition is not suitable for use for a protective film, an interlayer insulating film, etc.

As described, from now on, there is desired rapid development of a photosensitive resin composition containing a polyimide precursor, the photosensitive resin composition having all of the following characteristics and not missing a single one: makes it possible to form a fine pattern; makes it possible to obtain a cured film by heating at a low temperature; a protective film or an interlayer insulating film, having been cured, have heat resistance in various processes and resistance to various chemicals used; and furthermore, the composition has excellent storage stability.

### CITATION LIST

PATENT LITERATURE

Patent Document 1: JP S49-115541 A
Patent Document 2: JP S55-45746 A
Patent Document 3: JP 2007-056196 A
Patent Document 4: JP 7436606 B2
Patent Document 5: JP 2022-159241 A

SUMMARY OF INVENTION

TECHNICAL PROBLEM

The present invention has been made in view of the above-described circumstances. An object of the present invention is to provide a photosensitive resin composition, containing a polyimide precursor, that can undergo an imide ring-closing reaction at a low temperature, has excellent stability of the composition, and makes fine patterning possible, and after curing, can be provided with resistance to chemicals. Another object is to provide: a patterning process using the photosensitive resin composition; and an interlayer insulating film and a semiconductor device including a cured film of the photosensitive resin composition.

SOLUTION TO PROBLEM

That is, to achieve the object, the present invention provides a negative photosensitive resin composition comprising:

(A) a polymer having a polyimide precursor structure;
(C) a photopolymerization initiator;
(D) a nitrogen-containing organic compound represented by the following general formula (1); and
(E) a solvent,

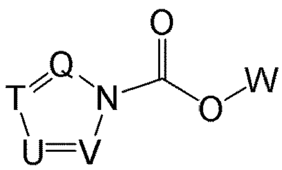
(1)

wherein Q represents a nitrogen atom or a carbon atom having an $R^q$ group, T represents a nitrogen atom or a carbon atom having an $R^t$ group, U represents a nitrogen atom or a carbon atom having an $R^u$ group, V represents a nitrogen atom or a carbon atom having an $R^v$ group, the $R^q$ group, the $R^t$ group, the $R^u$ group, and the $R^v$ group each represent a hydrogen atom, a linear, branched, or cyclic alkyl group having 1 to 15 carbon atoms, an aryl group having 6 to 15 carbon atoms, a halogen atom, or a nitro group, the $R^q$ group and the $R^t$ group, the $R^t$ group and the $R^u$ group, and the $R^u$ group and the $R^v$ group optionally being bonded to each other to form a ring together with the carbon atoms bonded to the $R^q$ group and the $R^t$ group, the $R^t$ group and the $R^u$ group, and the $R^u$ group and the $R^v$ group, and W represents an alkyl group having 1 to 15 carbon atoms or an aryl group having 6 to 15 carbon atoms and is optionally substituted with an alkoxy group.

When a negative photosensitive resin composition contains, as the component (A), a polymer having a polyimide precursor structure, excellent mechanical properties and adhesiveness to a substrate can be achieved even when the composition is cured at a low temperature, and therefore, such a composition is favorable.
When a negative photosensitive resin composition containing a polyimide precursor structure contains the nitrogen-containing organic compound represented by the general formula (1), the temperature of the curing reaction for obtaining a cured film, that is, the imide ring-closing reaction can be set to 200°C or lower.
Furthermore, the nitrogen-containing organic compound represented by the general formula (1) has a protecting group -(C=O)-O-W on the nitrogen atom, and thus, can prevent the agglomeration of the polymer including a polyimide precursor structure and the nitrogen-containing organic compound, that is, can prevent gelation.
In this case, the component (A) of the negative photosensitive resin composition is preferably a polymer having a

polyimide precursor structure represented by the following general formula (2),

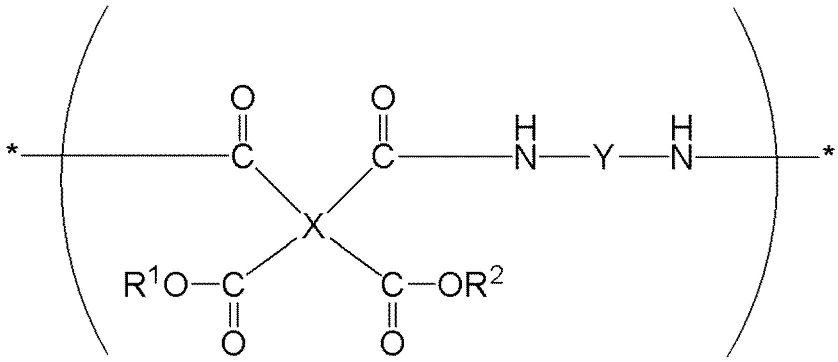

(2)

wherein X represents a tetravalent organic group; Y represents a divalent organic group; and $R^1$ and $R^2$ each independently represent a hydrogen atom or a monovalent organic group, provided that at least one of $R^1$ and $R^2$ is a group represented by the following general formula (3),

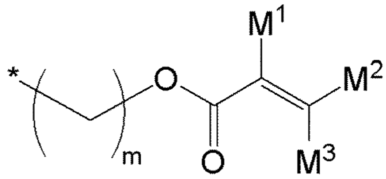

(3)

wherein $M^1$, $M^2$, and $M^3$ each independently represent a hydrogen atom or an organic group having 1 to 3 carbon atoms; "m" represents an integer of 2 to 10; and "*" represents an attachment point.

When the component (A) of the negative photosensitive resin composition contains a polymer having a polyimide precursor structure represented by the general formula (2), excellent mechanical properties and adhesiveness to a substrate can be achieved even when the composition is cured at a low temperature, and therefore, such a composition is preferable.

The composition preferably further comprises (B) a polymerizable compound having two or more ethylenically unsaturated groups.

When a crosslinking agent having two or more photopolymerizable unsaturated bonds in one molecule is contained as described above, it is possible to promote the crosslinking of the component (A) in exposed portions by photopolymerization and improve the contrast between exposed portions and unexposed portions.

In this case, the W in the general formula (1) of the component (D) is preferably a tert-butyl group.

When the W is a tert-butyl group, the general formula (1) indicates a compound in which the nitrogen atom of the nitrogen-containing organic compound represented by the general formula (1) is protected with a tert-butoxycarbonyl group (N-Boc group). A tert-butoxycarbonyl group (N-Boc group) is removed in a heating process of a curing reaction in a range of 100°C to 150°C, and an azole compound, which can promote an imide ring-closing reaction, can be generated. Thus, imidization at 200°C or lower is possible.

Alternatively, in this case, the W in the general formula (1) of the component (D) is preferably a benzyl group.

When the W is a benzyl group, the general formula (1) indicates a compound in which the nitrogen atom of the nitrogen-containing organic compound represented by the general formula (1) is protected with a benzyloxycarbonyl protecting group (Z group). A benzyloxycarbonyl protecting group (Z group) is removed in a heating process of a curing reaction in a range of 120°C to 190°C, and an azole compound, which can promote an imide ring-closing reaction, can be generated. Thus, imidization at 200°C or lower is possible.

The composition preferably contains 1 to 10 parts by mass of the component (D) based on 100 parts by mass of the component (A).

When the amount of the component (D) nitrogen-containing organic compound is 10 parts by mass or less, the contained nitrogen-containing compound does not function as a plasticizer, and therefore, deformation of a formed pattern due to heat, that is, thermal flow, does not occur and there is no risk of the pattern formation being degraded. Furthermore, after curing, there is no risk of the glass transition point (Tg.) of the obtained cured film decreasing.

The present invention preferably comprises, as (F) a heat crosslinking agent, one or more crosslinking agents selected from the group consisting of an amino condensate modified with formaldehyde or formaldehyde-alcohol, a phenol compound having two or more methylol groups or alkoxymethylol groups on average in one molecule, a compound in

which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (F-1), and a compound containing two or more nitrogen atoms each having a glycidyl group represented by the following formula (F-2),

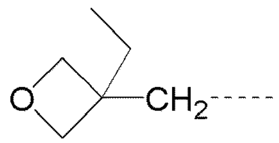

(F-1)

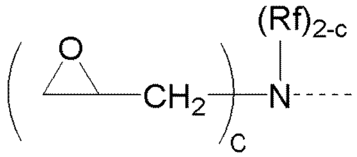

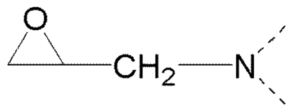

(F-2)

wherein a dotted line represents an attachment point; Rf represents a linear, branched, or cyclic alkyl group having 1 to 6 carbon atoms; and "c" represents 1 or 2.

The component (F) is a component that causes a crosslinking reaction in post-curing after patterning using the inventive negative photosensitive resin composition, and further enhances the strength of the cured product.

The negative photosensitive resin composition preferably further comprises (G) an antioxidant.

When the component (G) antioxidant is contained, it is possible to suppress unnecessary crosslinking among the component (A) or between the components (A) and (B) at the time of patterning, and contrast can be enhanced. In addition, by an anticorrosive effect to metal materials, it is possible to suppress oxidation of metal by water from outside, a photoacid generator, a thermal acid generator, etc. and accompanying adhesion degradation and delamination.

The negative photosensitive resin composition preferably further comprises (H) a silane compound.

The inventive negative photosensitive resin composition preferably contains a metal adhesion improver for enhancing adhesion to metal materials used for electrodes, wiring, etc., and as the metal adhesion improver, a silane compound can be used.

The negative photosensitive resin composition preferably further comprises (I) a polymerization inhibitor.

When the polymerization inhibitor (I) is contained, it is possible to enhance the stability of the viscosity and the photosensitivity of the composition solution during storage.

The present invention can also provide a patterning process comprising the steps of:

(1) applying the above-described negative photosensitive resin composition onto a substrate to form a photosensitive material film;
(2) subsequently performing heat treatment and then exposure of the photosensitive material film with a high-energy beam having a wavelength of 190 to 500 nm or an electron beam through a photomask; and
(3) after the exposure, performing development using a developing solution of an organic solvent.

Such a patterning process using a negative photosensitive composition is a patterning process using, in particular, a negative photosensitive resin composition that contains, as a base resin (A), a polymer having a polyimide precursor structure, being a polymer having the above-described polymerizable unsaturated bond group, or a negative photosensitive resin composition that contains, as the component (D), a nitrogen-containing organic compound represented by the general formula (1).

The patterning process using the negative photosensitive resin composition containing the component (A) allows excellent mechanical characteristics and adhesiveness to a substrate even when curing is performed at a low temperature, and is favorable. Meanwhile, the patterning process using the negative photosensitive resin composition containing, as the component (D), a nitrogen-containing organic compound represented by the general formula (1) can suppress the agglomeration of the polymer containing the polyimide precursor structure and the nitrogen-containing organic compound, that is, gelation, and is favorable.

Furthermore, the present invention can provide a method for forming a cured film, comprising heating and post-curing a patterned film obtained by the above-described patterning process at a temperature of 100 to 300°C.

By performing such a patterning process, the curing reaction after the patterning, that is, the imide ring-closing reaction can be performed at a low temperature.

The present invention also provides an interlayer insulating film, being a cured film of the above-described negative photosensitive resin composition.

The present invention also provides a surface protective film, being a cured film of the above-described negative photosensitive resin composition.

When the inventive negative photosensitive resin composition is cured, it is possible to obtain an interlayer insulating film or a surface protective film that exhibits excellent chemical resistance and a high glass transition point (Tg.).

The present invention also provides an electronic component comprising the above-described interlayer insulating film.

The present invention also provides an electronic component comprising the above-described surface protective film.

Such an electronic component has a protective film (interlayer insulating film or surface protective film) with heat resistance, chemical resistance, and insulating property, and is thus excellent in reliability.

ADVANTAGEOUS EFFECTS OF INVENTION

As described above, according to the present invention, it is possible to provide a negative photosensitive resin composition containing a polymer that enables an imide ring-closing reaction at low temperatures and has a polyimide precursor structure having high storage stability regardless of the molecular structure of the polyimide precursor. Furthermore, the composition can be cured without causing deformation in an obtained pattern, and therefore, allows the formation of a fine pattern. Furthermore, a cured film obtained by curing after patterning exhibits excellent chemical resistance and a high glass transition point (Tg.).

DESCRIPTION OF EMBODIMENTS

As described above, there have been demands for the development of a photosensitive resin composition containing a polyimide precursor that makes it possible to perform an imide ring-closing reaction at low temperatures, is excellent in the stability of the composition, and allows fine patterning, the photosensitive resin composition being capable of achieving resistance to chemicals after curing.

To achieve the object, the present inventors have earnestly studied and found out that a constitution where a photosensitive resin composition that contains a polymer having a polyimide precursor structure contains a nitrogen-containing organic compound represented by the following general formula (1) can achieve the formation of a fine patter without degradation, and makes it possible to perform a curing reaction after patterning, that is, an imide ring-closing reaction, at 200°C or lower.

The present inventors have also found out that a cured film obtained has excellent chemical resistance and has a high glass transition point (Tg.). The present inventors have further found out that the photosensitive resin composition also has excellent storage stability, and arrived at the present invention.

That is, the present invention is a negative photosensitive resin composition comprising:

(A) a polymer having a polyimide precursor structure;
(C) a photopolymerization initiator;
(D) a nitrogen-containing organic compound represented by the following general formula (1); and
(E) a solvent,

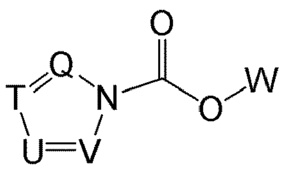

(1)

wherein Q represents a nitrogen atom or a carbon atom having an $R^q$ group, T represents a nitrogen atom or a carbon atom having an $R^t$ group, U represents a nitrogen atom or a carbon atom having an $R^u$ group, V represents a nitrogen atom or a carbon atom having an $R^v$ group, the $R^q$ group, the $R^t$ group, the $R^u$ group, and the $R^v$ group each represent a hydrogen atom, a linear, branched, or cyclic alkyl group having 1 to 15 carbon atoms, an aryl group having 6 to 15 carbon atoms, a halogen atom, or a nitro group, the $R^q$ group and the $R^t$ group, the $R^t$ group and the $R^u$ group, and the $R^u$ group and the $R^v$ group optionally being bonded to each other to form a ring together with the carbon atoms bonded to the $R^q$ group and the $R^t$ group, the $R^t$ group and the $R^u$ group, and the $R^u$ group and the $R^v$ group, and W represents an alkyl group having 1 to 15 carbon atoms or an aryl group having 6 to 15 carbon atoms and is optionally substituted with an alkoxy group.

Hereinafter, the present invention will be described in detail, but the present invention is not limited thereto.

[Component (A)]

The component (A) polymer containing the structural unit of the polyimide precursor, concerned with the present invention, is preferably a polymer represented by the following formula (2) from the viewpoint of the film strength of a cured film that is obtained.

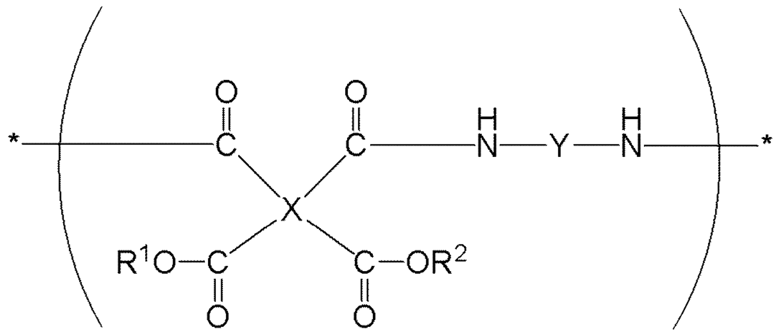

(2)

In the formula, X represents a tetravalent organic group; Y represents a divalent organic group; and $R^1$ and $R^2$ each independently represent a hydrogen atom or a monovalent organic group, provided that at least one of $R^1$ and $R^2$ is a group represented by the following general formula (3).

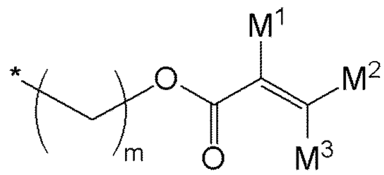

(3)

In the formula, $M^1$, $M^2$, and $M^3$ each independently represent a hydrogen atom or an organic group having 1 to 3 carbon atoms; "m" represents an integer of 2 to 10; and "*" represents an attachment point.

The X in the general formula (2) is a tetravalent organic group, and is not limited as long as it is a tetravalent organic group. X is preferably a tetravalent organic group of an alicyclic aliphatic group or aromatic group having 4 to 40 carbon atoms. X is further preferably a tetravalent organic group represented by one of the following formulae (4). In addition, the structure of X may be of one kind or a combination of two or more kinds.

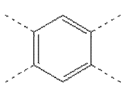
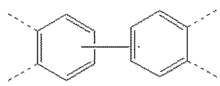
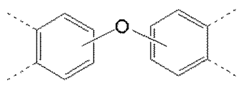
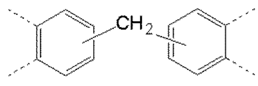
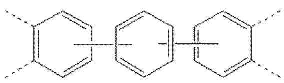
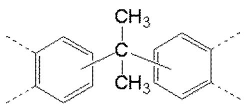
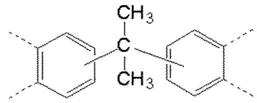
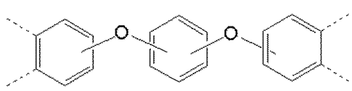
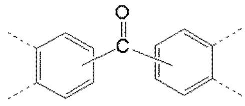
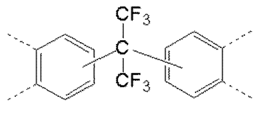
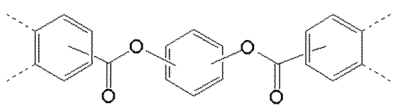
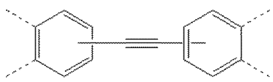
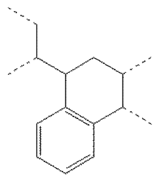
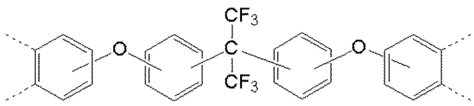
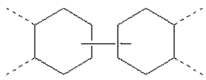
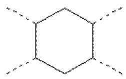
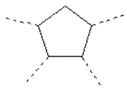
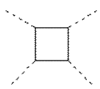
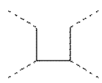
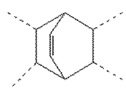
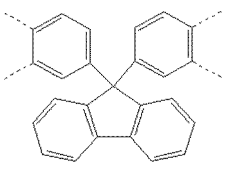
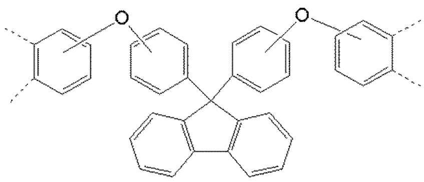
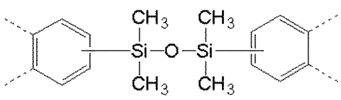
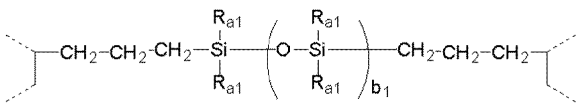
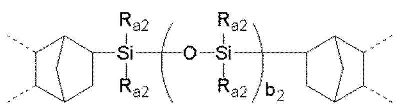

(4)

In the formulae, $R_{a1}$ and $R_{a2}$ each independently represent a methyl group or a phenyl group, "$b_1$" and "$b_2$" each represent an integer of 1 to 20, and a dotted line represents an attachment point.

The Y in the general formula (2) is a divalent organic group and is not limited as long as it is a divalent organic group. The Y is preferably a divalent organic group having 6 to 40 carbon atoms, more preferably a divalent cyclic organic group containing 1 to 4 aromatic rings or aliphatic rings each having a substituent, a divalent aliphatic group not having a cyclic structure, or a siloxane group. Further suitable examples of Y include structures represented by the following formulae (5) or (6). In addition, the structure of Y may be of one kind or a combination of two or more kinds.

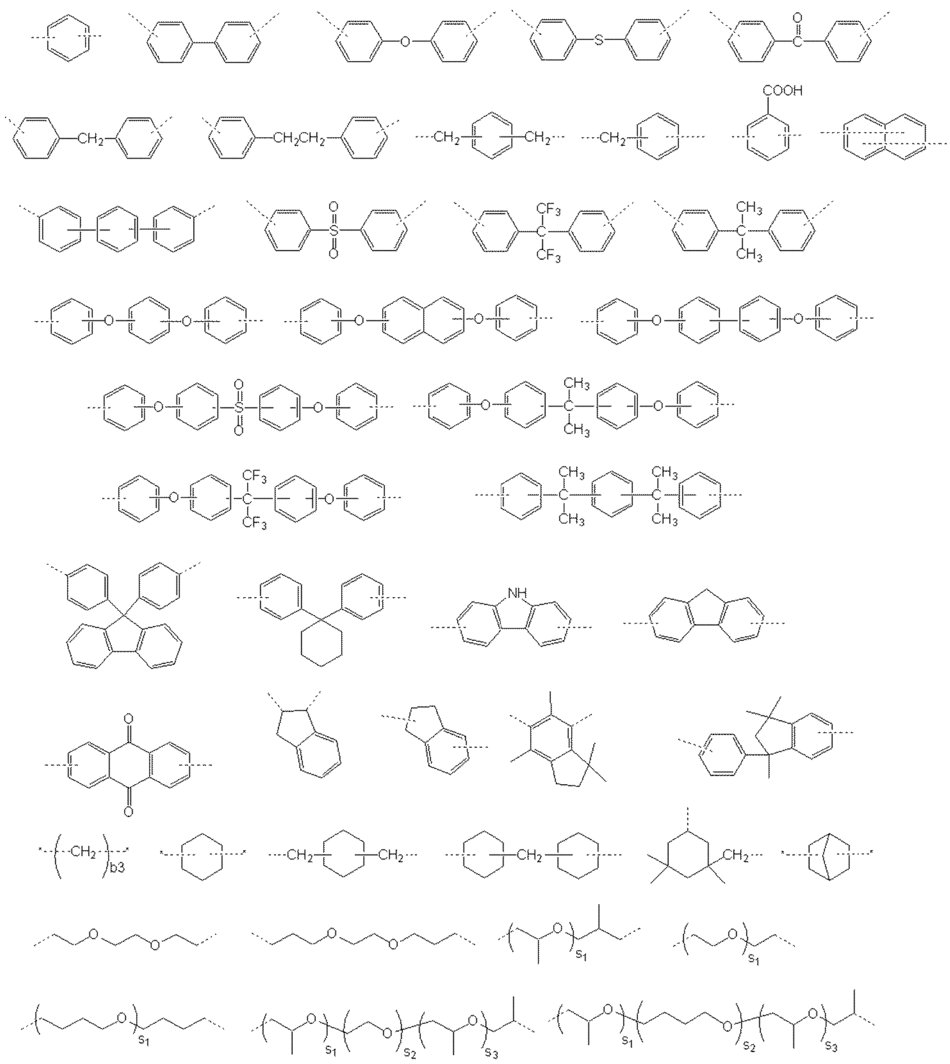

(5)

In the formulae, "b3" represents an integer of 1 to 20, "$s_1$" represents an integer of 1 to 40, "$s_2$" and "$s_3$" each independently represent an integer of 0 to 40, and a dotted line represents an attachment point.

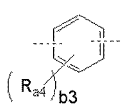
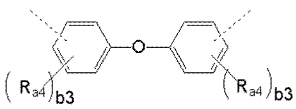
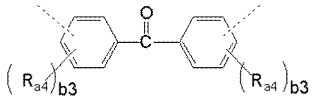
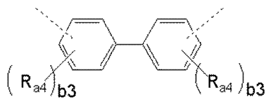
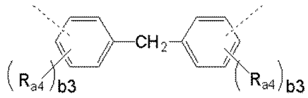
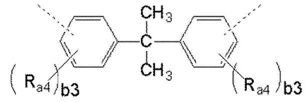
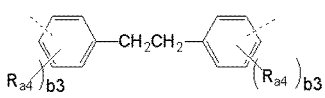
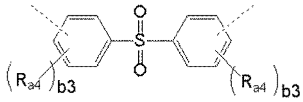
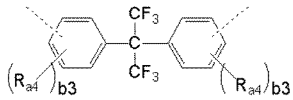
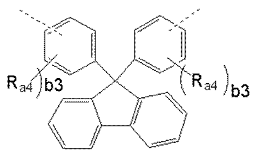
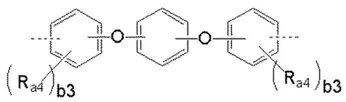
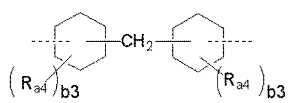
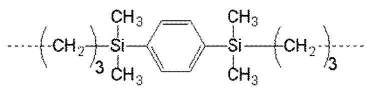
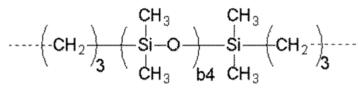
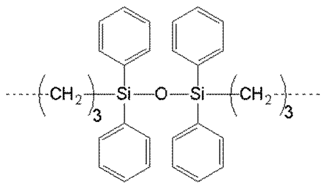

(6)

In the formulae, "b3" represents an integer of 1 to 4, $R_{a4}$ represents a fluorine atom, a methyl group, an ethyl group, a propyl group, an n-butyl group, a methoxy group, an ethoxy group, a propoxy group, a butoxy group, or a trifluoromethyl group, the $R_{a4}$s are identical to or different from each other when "b3" is 2 or more, "b4" represents an integer of 1 to 40, and a dotted line represents an attachment point.

The $R^1$ and the $R^2$ in the general formula (2) each independently represent a hydrogen atom or a monovalent organic group, and the monovalent organic group is a linear, branched, or cyclic alkyl group having 1 to 6 carbon atoms or an organic group represented by the general formula (3), provided that at least one of $R^1$ and $R^2$ is an organic group represented by the general formula (3).

The $M^1$ in the general formula (3) is not limited as long as it is a hydrogen atom or a monovalent organic group having 1 to 3 carbon atoms, but from the viewpoint of the photosensitivity of the negative photosensitive resin composition, a hydrogen atom or a methyl group is preferable.

The $M^2$ and $M^3$ in the general formula (3) are not limited as long as they each independently represent a hydrogen atom or a monovalent organic group having 1 to 3 carbon atoms, but from the viewpoint of the photosensitivity of the negative photosensitive resin composition, a hydrogen atom is preferable.

The "m" in the general formula (3) represents an integer of 2 to 10, and from the viewpoint of photosensitivity, preferably an integer of 2 to 4. Further preferably, "m" represents 2.

The polymer of the present invention can further contain, in addition to the structural unit represented by the general formula (2), any one or more of structural units represented by the following general formulae (7) to (9).

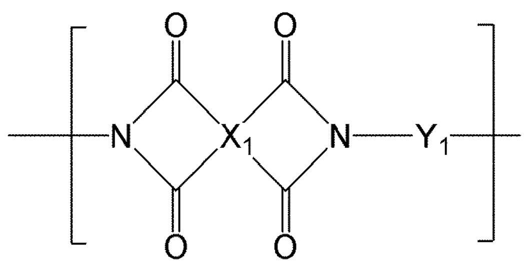

(7)

In the formula, $X_1$ represents a tetravalent organic group that is identical to or different from the above-described X, and $Y_1$ represents a divalent organic group that is identical to or different from the above-described Y.

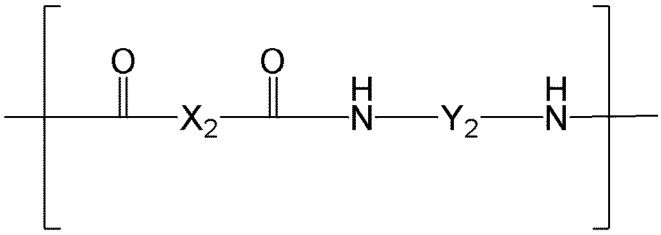

(8)

In the formula, $X_2$ represents a divalent organic group, and $Y_2$ represents a divalent organic group that is identical to or different from the above-described Y.

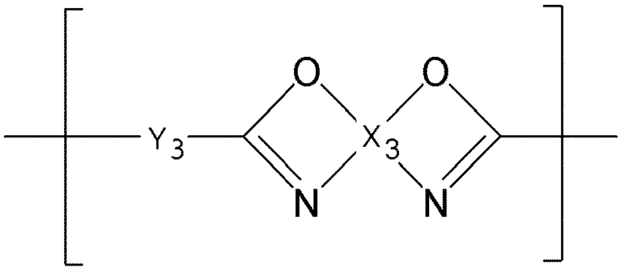

(9)

In the formula, $Y_3$ represents a divalent organic group that is identical to or different from the above-described Y, and $X_3$ represents a tetravalent organic group.

The $X_1$ in the general formula (7) represents a tetravalent organic group and is identical to or different from the above-described X, and is not limited as long as it is a tetravalent organic group. The $X_1$ is preferably a tetravalent alicyclic aliphatic group having 4 to 40 carbon atoms or a tetravalent aromatic group having 6 to 40 carbon atoms, and optionally contains a siloxane skeleton. The $X_1$ is further preferably a tetravalent organic group represented by one of the formulae (4). In addition, the structure of $X_1$ may be of one kind or a combination of two or more kinds.

The $Y_1$ in the general formula (7) represents a divalent organic group, is identical to or different from the above-described Y, and is not limited as long as it is a divalent organic group. The $Y_1$ is preferably a divalent organic group having 6 to 40 carbon atoms, more preferably a divalent cyclic organic group containing 1 to 4 aromatic rings or aliphatic rings each having a substituent, a divalent aliphatic group not having a cyclic structure, or a siloxane group. Further suitable examples of $Y_1$ include the structures represented by the formulae (5) or (6). In addition, the structure of $Y_1$ may be of one kind or a combination of two or more kinds.

The resin composition containing the polymer containing the structural unit represented by the general formula (7) is preferable because it is possible to enhance the mechanical strength, adhesive force to substrate, and heat resistance of the cured film obtained by patterning. Moreover, the structural unit (7) does not require ring-closing reaction in post-curing, so that the curing reaction temperature can be reduced relatively, which is preferable.

The $X_2$ in the general formula (8) represents a divalent organic group, and is not limited as long as it is a divalent organic group. The $X_2$ is preferably a divalent organic group having an aliphatic chain length structure having 4 to 40 carbon atoms, a divalent alicyclic aliphatic group having 4 to 40 carbon atoms, or a divalent aromatic group having 6 to 40 carbon atoms. The $X_2$ is further preferably a divalent organic group represented by one of the following formulae (8-1). In addition, the structure of $X_2$ may be of one kind or a combination of two or more kinds.

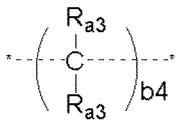 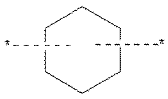 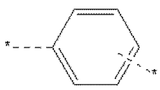

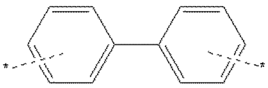 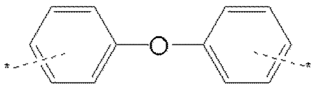 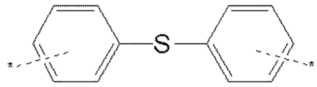

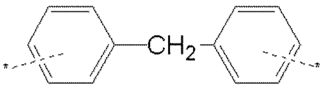 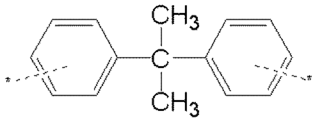 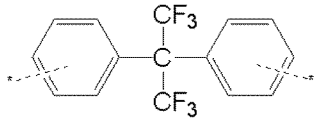

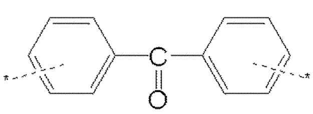 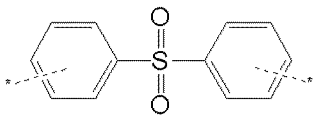

(8 − 1)

In the formulae, each $R_{a3}$ independently represents a hydrogen atom, a fluorine atom, or an alkyl group having 1 to 6 carbon atoms, "b4" represents an integer of 1 to 30, and a dotted line represents an attachment point.

The $Y_2$ in the general formula (8) represents a divalent organic group, is identical to or different from the above-described Y, and is not limited as long as it is a divalent organic group. The $Y_2$ is preferably a divalent organic group having 6 to 40 carbon atoms, a divalent cyclic organic group containing 1 to 4 aromatic rings or aliphatic rings each having a substituent, a divalent aliphatic group not having a cyclic structure, or a siloxane group. Further preferable examples include the structures represented by the formulae (5) or (6). In addition, the structure of $Y_2$ may be of one kind or a combination of two or more kinds.

The $Y_3$ in the general formula (9) is a divalent organic group and is identical to or different from the above-described Y, and is not limited as long as it is a divalent organic group. The $Y_3$ is preferably a divalent organic group having an aliphatic chain length structure having 4 to 40 carbon atoms, a divalent alicyclic aliphatic group having 4 to 40 carbon atoms, or a divalent aromatic group having 6 to 40 carbon atoms.

The $Y_3$ is further preferably a divalent organic group represented by one of the formulae (8-1). In addition, the structure of $Y_3$ may be of one kind or a combination of two or more kinds.

The $X_3$ in the general formula (9) is a tetravalent organic group and is not limited as long as it is a tetravalent organic group. The $X_3$ is preferably a tetravalent organic group having 6 to 40 carbon atoms, more preferably a tetravalent cyclic organic group containing 1 to 4 aromatic rings or aliphatic rings each having a substituent, a tetravalent aliphatic group not having a cyclic structure, or a siloxane group. Further suitable examples of the $X_3$ include structures represented by the following formulae (12). In addition, the structure of $X_3$ may be of one kind or a combination of two or more kinds.

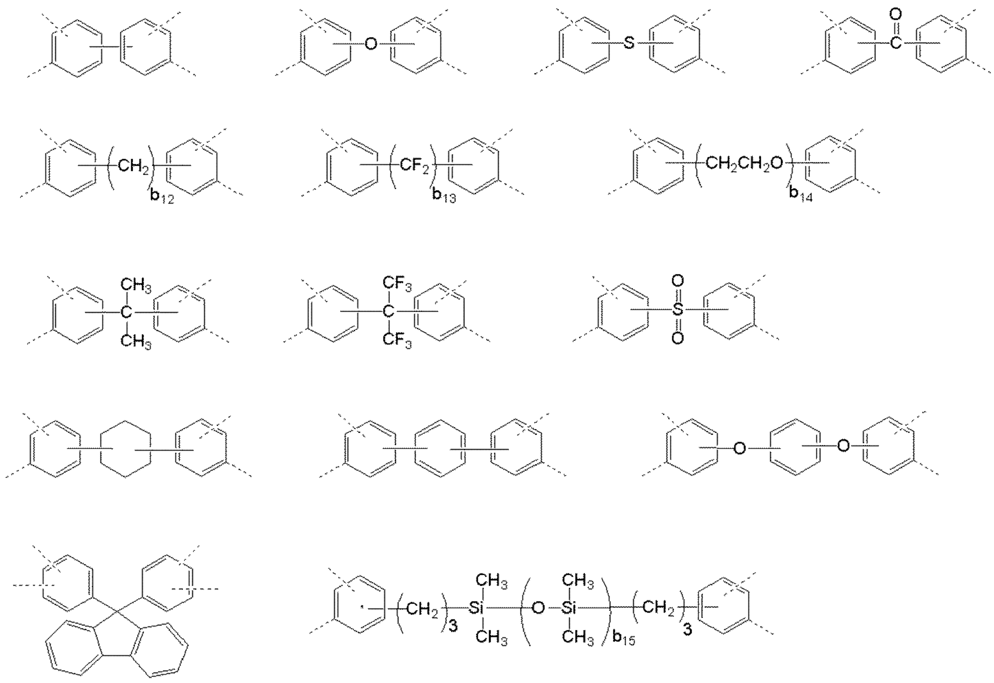

(12)

In the formulae, $b_{12}$, $b_{13}$, and $b_{14}$ each represent an integer of 1 to 10, "$b_{15}$" represents an integer of 1 to 20, and a dotted line represents an attachment point.

The resin composition containing the polymer containing the structural unit represented by the general formula (9) is preferable because it is possible to enhance the mechanical strength, adhesive force to substrate, and heat resistance of the cured film obtained by patterning. Moreover, when the structure represented by the general formula (9) is contained, a ring-closure reaction is not required in post-curing, so that the curing reaction temperature can be reduced relatively, which is preferable.

A suitable molecular weight for the polymer of the present invention is preferably 5,000 to 100,000, more preferably 7,000 to 50,000. When the molecular weight is 5,000 or more, it is easy to form a film of a photosensitive resin composition containing the polymer of the present invention on a substrate in such a manner as to achieve a desired film thickness. When the molecular weight is 100,000 or less, the photosensitive resin composition has a suitable viscosity, and there are no problems in film formation. Note that, in the present invention, the weight-average molecular weight is a value obtained by gel permeation chromatography (GPC) in terms of polystyrene.

[Method for Manufacturing Polymer]

The polymer contained in the inventive negative photosensitive resin composition preferably contains a structural unit represented by the following general formula (2).

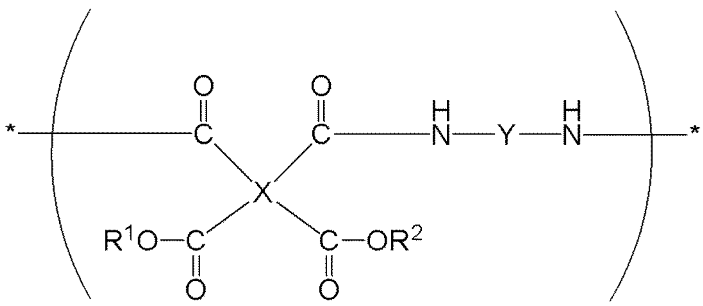

(2)

In the formula, X represents a tetravalent organic group; Y represents a divalent organic group; and $R^1$ and $R^2$ each independently represent a hydrogen atom or a monovalent organic group, provided that at least one of $R^1$ and $R^2$ is a group represented by the following general formula (3).

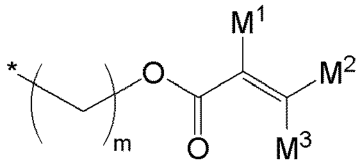

(3)

In the formula, $M^1$, $M^2$, and $M^3$ each independently represent a hydrogen atom or an organic group having 1 to 3 carbon atoms; "m" represents an integer of 2 to 10; and "*" represents an attachment point.

A polymer containing the structural unit represented by the general formula (2) can be obtained by allowing a tetracarboxylic acid diester compound represented by the following general formula (13) to react with a diamine represented by the following general formula (14).

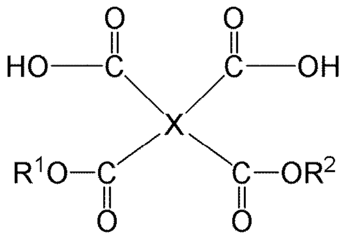

(13)

In the formula, X, $R^1$, and $R^2$ are as defined above.

$$H_2N\text{-}Y\text{-}NH_2 \qquad (14)$$

In the formula, Y is as defined above.

In the general formula (13), at least one of $R^1$ and $R^2$ is an organic group represented by the general formula (3), and the organic group represented by the general formula (3) can be introduced by allowing a tetracarboxylic dianhydride represented by the following general formula (15) to react with a compound represented by the following general formula (16), having a hydroxy group on an end, in the presence of a basic catalyst such as pyridine. Here, the tetracarboxylic dianhydride represented by the following general formula (15) is to be a source of the X (e.g. a tetravalent organic group represented by one of the formulae (4)) in the general formula (2), and the compound represented by the following general formula (16) having a hydroxy group on an end makes it possible to introduce the organic group represented by the general formula (3).

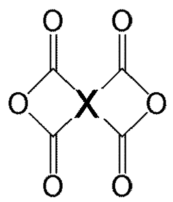

(15)

In the formula, X represents a tetravalent organic group, and has the same meaning as the X in the general formula (2).

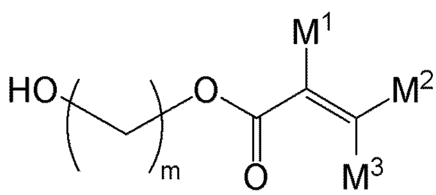

(16)

In the formula, $M^1$, $M^2$, $M^3$, and "m" have the same meanings as the $M^1$, $M^2$, $M^3$, and "m" in the general formula (3).

Suitable examples of the tetracarboxylic dianhydride represented by the general formula (15) include aromatic acid dianhydrides, alicyclic acid dianhydrides, aliphatic acid dianhydrides, siloxane skeleton-containing acid dianhydrides, etc.

Examples of the aromatic acid dianhydrides include, but are not limited to, for example, pyromellitic dianhydride, 3,3',4,4'-biphenyltetracarboxylic dianhydride, 2,3,3',4'-biphenyltetracarboxylic dianhydride, 2,3,2',3'-biphenyltetracarboxylic dianhydride, 3,3',4,4'-terphenyltetracarboxylic dianhydride, 3,3',4,4'-oxyphthalic dianhydride, 2,3,3',4'-oxyphthalic dianhydride, 2,3,2',3'-oxyphthalic dianhydride, diphenylsulfone-3,3',4,4'-tetracarboxylic dianhydride, benzophenone-3,3',4,4'-tetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,4-(3,4-dicarboxyphenoxy)benzene dianhydride, p-phenylenebis(trimellitic acid monoester acid anhydride), bis(1,3-dioxo-1,3-dihydroisobenzfuran-5-carboxylic acid)1,4-phenylene, 2,2-bis(4-(4-aminophenoxy)phenyl)propane, 1,2,5,6-naphthalenetetracarboxylic dianhydride, 2,3,6,7-naphthalenetetracarboxylic dianhydride, 9,9-bis(3,4-dicarboxyphenyl) fluorene dianhydride, 9,9-bis(4-(3,4-dicarboxyphenoxy) phenyl) fluorene dianhydride, 2,3,5,6-pyridinetetracarboxylic dianhydride, 3,4,9,10-perylenetetracarboxylic dianhydride, 2,2-bis(3,4-dicarboxyphenyl)hexafluoropropane dianhydride, 2,2-bis(4-(3,4-dicarboxybenzoyloxy)phenyl)hexafluoropropane dianhydride, 1,6-difluoropyromellitic dianhydride, 1-trifluoromethylpyromellitic dianhydride, 1,6-ditrifluoromethylpyromellitic dianhydride, 2,2'-bis(trifluoromethyl)-4,4'-bis(3,4-dicarboxyphenoxy)biphenyl dianhydride, 2,2'-bis[(dicarboxyphenoxy)phenyl]propane dianhydride, 2,2'-bis[(dicarboxyphenoxy)phenyl]hexafluoropropane dianhydride, and acid dianhydride compounds formed by substituting aromatic rings of the above compounds with an alkyl group, an alkoxy group, a halogen atom, or the like.

Examples of the alicyclic acid dianhydride include, but are not limited to, for example, 1,2,3,4-cyclobutanetetracarboxylic dianhydride, 1,2,3,4-cyclopentanetetracarboxylic dianhydride, 1,2,4,5-cyclohexanetetracarboxylic dianhydride, 1,2,4,5-cyclopentanetetracarboxylic dianhydride, 1,2,3,4-tetramethyl-1,2,3,4-cyclobutanetetracarboxylic dianhydride, 1,2-dimethyl-1,2,3,4-cyclobutanetetracarboxylic dianhydride, 1,3-dimethyl-1,2,3,4-cyclobutanetetracarboxylic dianhydride, 1,2,3,4-cycloheptanetetracarboxylic dianhydride, 2,3,4,5-tetrahydrofurantetracarboxylic dianhydride, 3,4-dicarboxy-1-cyclohexylsuccinic dianhydride, 2,3,5-tricarboxycyclopentylacetic dianhydride, 3,4-dicarboxy-1,2,3,4-tetrahydro-1-naphthalenesuccinic dianhydride, bicyclo[3.3.0]octane-2,4,6,8-tetracarboxylic dianhydride, bicyclo[4.3.0]nonane-2,4,7,9-tetracarboxylic dianhydride, bicyclo[4.4.0]decane-2,4,7,9-tetracarboxylic dianhydride, bicyclo[4.4.0]decane-2,4,8,10-tetracarboxylic dianhydride, tricyclo[6.3.0.0$^{2,6}$]undecane-3,5,9,11-tetracarboxylic dianhydride, bicyclo[2.2.2]octane-2,3,5,6-tetracarboxylic dianhydride, bicyclo[2.2.2]oct-7-ene-2,3,5,6-tetracarboxylic dianhydride, bicyclo[2.2.1]heptanetetracarboxylic dianhydride, bicyclo[2.2.1]heptane-5-carboxymethyl-2,3,6-tricarboxylic dianhydride, 7-oxabicyclo[2.2.1]heptane-2,4,6,8-tetracarboxylic dianhydride, octahydronaphthalene-1,2,6,7-tetracarboxylic dianhydride, tetradecahydroanthracene-1,2,8,9-tetracarboxylic dianhydride, 3,3',4,4'-dicyclohexanetetracarboxylic dianhydride, 3,3',4,4'-oxydicyclohexanetetracarboxylic dianhydride, 5-(2,5-dioxotetrahydro-3-furanyl)-3-methyl-3-cyclohexene-1,2-dicarboxylic anhydride, and "RIKACID" (Registered Trademark) BT-100 (trade name, manufactured by New Japan Chemical Co., Ltd.) and derivatives thereof, or acid dianhydride compounds formed by substituting aliphatic rings of the above compounds with an alkyl group, an alkoxy group, a halogen atom or the like.

Examples of the aliphatic acid dianhydride include, but are not limited to, for example, 1,2,3,4-butanetetracarboxylic dianhydride, 1,2,3,4-pentanetetracarboxylic dianhydride, and derivatives thereof.

Examples of the siloxane skeleton-containing acid dianhydride include, but are not limited to, for example, 1,3-bis(3,4-dicarboxyphenyl)-1,1,3,3-tetramethyldisiloxane dianhydride, 3,3'-((1,1,3,3-tetramethyl-1,3-disiloxanediyl)di-3,1-propanediyl)bis(dihydro-2,5-furandione), and derivatives thereof.

Any one of these aromatic acid dianhydrides, alicyclic acid dianhydrides, aliphatic acid dianhydrides, or siloxane skeleton-containing acid dianhydrides may be used, or two or more thereof may be used in combination.

The $M^1$ in the general formula (16) is not limited as long as it is a hydrogen atom or a monovalent organic group having 1 to 3 carbon atoms, but from the viewpoint of the photosensitivity of the negative photosensitive resin composition, a hydrogen atom or a methyl group is preferable.

The $M^2$ and the $M^3$ in the general formula (16) are not limited as long as they are each independently a hydrogen atom or a monovalent organic group having 1 to 3 carbon atoms, but from the viewpoint of the photosensitivity of the negative photosensitive resin composition, a hydrogen atom is preferable.

The "m" in the general formula (16) represents an integer of 2 to 10, and from the viewpoint of photosensitivity, preferably an integer of 2 to 4. More preferably, "m" is 2.

Among compounds represented by the general formula (16) having a hydroxy group on an end, examples of suitable compounds include 2-acryloyloxyethyl alcohol, 1-acryloyloxy-3-propyl alcohol, 2-methacryloyloxyethyl alcohol, and 1-methacryloyloxy-3-propyl alcohol.

The $R^1$ and the $R^2$ in the general formula (2) may each be a linear, branched, or cyclic alkyl group having 1 to 6 carbon atoms. Examples of methods for introducing a linear, branched, or cyclic alkyl group having 1 to 6 carbon atoms to the general formula (2) (that is, providing a linear, branched, or cyclic alkyl group having 1 to 6 carbon atoms as $R^1$ and $R^2$) include a method in which, in a reaction between the compound represented by the general formula (16) having a hydroxy group on an end and tetracarboxylic dianhydride performed in the presence of a basic catalyst, such as pyridine, a linear, branched, or cyclic alcohol having 1 to 6 carbon atoms is introduced at the same time.

Examples of suitable alcohols that can be used in this event include methanol, ethanol, 1-propanol, 2-propanol, 1-butanol, 2-butanol, 1-pentanol, 2-pentanol, 3-pentanol, neopentyl alcohol, 1-hexanol, 2-hexanol, 3-hexanol, cyclopentanol, and cyclohexanol.

Regarding the reaction between the tetracarboxylic dianhydride represented by the general formula (15) and the compound, having a hydroxy group on an end, represented by the general formula (16), the tetracarboxylic dianhydride represented by the general formula (15) and the compound, having a hydroxy group on an end, represented by the general formula (16) are stirred, dissolved, and mixed in the presence of a basic catalyst, such as pyridine, in a reaction solvent at a reaction temperature of 20 to 50°C for 4 to 10 hours. Thus, a half-esterification reaction of an acid dianhydride progresses, and the desired tetracarboxylic acid diester compound represented by the general formula (13) can be obtained as a solution in which the compound is dissolved in the reaction solvent.

The obtained tetracarboxylic acid diester compound may be subjected to isolation, or the obtained solution may be used as it is in the subsequent reaction with the diamine described later.

The reaction solvent preferably dissolves well a polymer having a structural unit of a polyimide precursor obtained from the above-described tetracarboxylic acid diester compound and by the polycondensation reaction between the tetracarboxylic acid diester compound and a diamine performed subsequently, and examples include N-methyl-2-pyrrolidone, N,N-dimethylacetamide, N,N-dimethylformamide, dimethylsulfoxide, tetramethylurea, γ-butyrolactone, etc. It is also possible to use ketones, esters, lactones, ethers, halogenated hydrocarbons, hydrocarbons, etc., and specific examples include acetone, methyl ethyl ketone, methyl isobutyl ketone, cyclohexanone, methyl acetate, ethyl acetate, butyl acetate, diethyl oxalate, ethylene glycol dimethyl ether, diethylene glycol dimethyl ether, tetrahydrofuran, dichloromethane, 1,2-dichloroethane, 1,4-dichlorobutane, chlorobenzene, o-dichlorobenzene, hexane, heptane, benzene, toluene, xylene, etc. One of these solvents may be used or two or more thereof may be used in mixture as necessary.

Suitable examples of the diamine represented by the general formula (14) include (2-methyl-4-amino)phenyl-4-aminobenzoate, (3-methyl-4-amino)phenyl-4-aminobenzoate, (2-ethyl-4-amino)phenyl-4-aminobenzoate, (3-ethyl-4-amino)phenyl-4-aminobenzoate, (2-propyl-4-amino)phenyl-4-aminobenzoate, (3-propyl-4-amino)phenyl-4-aminobenzoate, (2-isopropyl-4-amino)phenyl-4-aminobenzoate, (3-isopropyl-4-amino)phenyl-4-aminobenzoate, (2-butyl-4-amino)phenyl-4-aminobenzoate, (3-butyl-4-amino)phenyl-4-aminobenzoate, (2-isobutyl-4-amino)phenyl-4-aminobenzoate, (3-isobutyl-4-amino)phenyl-4-aminobenzoate, (2-pentyl-4-amino)phenyl-4-aminobenzoate, (3-pentyl-4-amino)phenyl-4-aminobenzoate, (2-hexyl-4-amino)phenyl-4-aminobenzoate, (3-hexyl-4-amino)phenyl-4-aminobenzoate, (2-methoxy-4-amino)phenyl-4-aminobenzoate, (3-methoxy-4-amino)phenyl-4-aminobenzoate, (2-ethoxy-4-amino)phenyl-4-aminobenzoate, (3-ethoxy-4-amino)phenyl-4-aminobenzoate, (2-propoxy-4-amino)phenyl-4-aminobenzoate, (3-propoxy-4-amino)phenyl-4-aminobenzoate, (2-butoxy-4-amino)phenyl-4-aminobenzoate, (3-butoxy-4-amino)phenyl-4-aminobenzoate, (2-pentoxy-4-amino)phenyl-4-aminobenzoate, (3-pentoxy-4-amino)phenyl-4-aminobenzoate, (2-phenyl-4-amino)phenyl-4-aminobenzoate, (3-phenyl-4-amino)phenyl-4-aminobenzoate, (2-methylphenyl-4-amino)phenyl-4-aminobenzoate, (3-methylphenyl-4-amino)phenyl-4-aminobenzoate, (2-ethylphenyl-4-amino)phenyl-4-aminobenzoate, (3-ethylphenyl-4-amino)phenyl-4-aminobenzoate, (2-propylphenyl-4-amino)phenyl-4-aminobenzoate, (3-propylphenyl-4-amino)phenyl-4-aminobenzoate, (2-butylphenyl-4-amino)phenyl-4-aminobenzoate, (3-butylphenyl-4-amino)phenyl-4-aminobenzoate, (2-fluorophenyl-4-amino)phenyl-4-aminobenzoate, (3-fluorophenyl-4-amino)phenyl-4-aminobenzoate, (2-chlorophenyl-4-amino)phenyl-4-aminobenzoate, (3-chlorophenyl-4-amino)phenyl-4-aminobenzoate, (2-bromophenyl-4-amino)phenyl-4-aminobenzoate, (3-bromophenyl-4-amino)phenyl-4-aminobenzoate, (2-methoxyphenyl-4-amino)phenyl-4-aminobenzoate, (3-methoxyphenyl-4-amino)phenyl-4-aminobenzoate, (2-ethoxyphenyl-4-amino)phenyl-4-aminobenzoate, (3-ethoxyphenyl-4-amino)phenyl-4-aminobenzoate, (2-ethoxyphenyl-4-amino)phenyl-4-aminobenzoate, (2-aminophenyl-4-amino)phenyl-4-aminobenzoate, (3-aminophenyl-4-amino)phenyl-4-aminobenzoate, (2-nitrophenyl-4-amino)phenyl-4-aminobenzoate, (3-nitrophenyl-4-amino)phenyl-4-aminobenzoate, (2-cyanophenyl-4-amino)phenyl-4-aminobenzoate, (3-cyanophenyl-4-amino)phenyl-4-aminobenzoate, (2-phenylethyl-4-amino)phenyl-4-aminobenzoate, (3-phenylethyl-4-amino)phenyl-4-aminobenzoate, (2-phenylamino-4-amino)phenyl-4-aminobenzoate, (3-phenylamino-4-amino)phenyl-4-aminobenzoate, (2-(4,4'-biphenyl)-4-amino)phenyl-4-aminobenzoate, (3-(4,4'-biphenyl)-4-amino)phenyl-4-aminobenzoate, (2-naphthyl-4-amino)phenyl-4-aminobenzoate, (3-naphthyl-4-amino)phenyl-4-aminobenzoate, (2-methylphenoxy-4-amino)phenyl-4-aminobenzoate, (3-methylphenoxy-4-amino)phenyl-4-aminobenzoate, (2-ethylphenoxy-4-amino)phenyl-4-aminobenzoate, (3-ethylphenoxy-4-amino)phenyl-4-aminobenzoate, (2-propylphenoxy-4-amino)phenyl-4-aminobenzoate, (3-propylphenoxy-4-amino)phenyl-4-aminobenzoate, (2-methoxyphenoxy-4-amino)phenyl-4-aminobenzoate, (3-methoxyphenoxy-4-amino)phenyl-4-aminobenzoate, (2-ethoxyphenoxy-4-amino)phenyl-4-aminobenzoate, (3-ethoxyphenoxy-4-amino)phenyl-4-aminobenzoate, (2-benzyl-4-amino)phenyl-4-aminobenzoate, (3-benzyl-4-amino)phenyl-4-aminobenzoate, (2-methylbenzyl-4-amino)phenyl-4-aminobenzoate, (3-methylbenzyl-4-amino)phenyl-4-aminobenzoate, (2-ethylbenzyl-4-amino)phenyl-4-aminobenzoate, (3-ethylbenzyl-4-amino)phenyl-4-aminobenzoate, (2-propylbenzyl-4-amino)phenyl-4-aminobenzoate, (3-propylbenzyl-4-amino)phenyl-4-aminobenzoate, (2-methoxybenzyl-4-amino)phenyl-4-aminobenzoate, (3-methoxybenzyl-4-amino)phenyl-4-aminobenzoate, (2-ethoxybenzyl-4-amino)phenyl-4-aminobenzoate, (3-ethoxybenzyl-4-amino)phenyl-4-aminobenzoate, (2-aminobenzyl-4-amino)phenyl-4-aminobenzoate, (3-aminobenzyl-4-amino)phenyl-4-aminobenzoate, (2-nitrobenzyl-4-amino)phenyl-4-aminobenzoate, (3-nitrobenzyl-4-amino)phenyl-4-aminobenzoate, (2-cyanobenzyl-4-amino)phenyl-4-aminobenzoate, (3-cyanobenzyl-4-amino)phenyl-4-aminobenzoate, (2-benzyloxy-4-amino)phenyl-4-aminobenzoate, (3-benzyloxy-4-amino)phenyl-4-aminobenzoate, (2-methylbenzyloxy-4-amino)phenyl-4-aminobenzoate, (3-methylbenzyloxy-4-amino)phenyl-4-aminobenzoate, (2-ethylbenzyloxy-4-amino) phenyl-4-aminobenzoate, (3-ethylbenzyloxy-4-amino)phenyl-4-aminobenzoate, (2-propylbenzyloxy-4-amino)phenyl-4-aminobenzoate, (3-propylbenzyloxy-4-amino)phenyl-4-aminobenzoate, (2-methoxybenzyloxy-4-amino)phenyl-4-aminobenzoate, (3-methoxybenzyloxy-4-amino)phenyl-4-aminobenzoate, (2-ethoxybenzyloxy-4-amino)phenyl-4-aminobenzoate, (3-ethoxybenzyloxy-4-amino)phenyl-4-aminobenzoate, 4-(4-aminophenoxy)-3-methylbenzenamine, 4-(4-aminophenoxy)-2-methylbenzenamine, 4-(4-aminophenoxy)-3-ethylbenzenamine, 4-(4-aminophenoxy)-2-ethylbenzenamine, 4-(4-aminophenoxy)-3-propylbenzenamine, 4-(4-aminophenoxy)-2-propylbenzenamine, 4-(4-aminophenoxy)-3-isopropylbenzenamine, 4-(4-aminophenoxy)-2-isopropylbenzenamine, 4-(4-aminophenoxy)-3-butylbenzenamine, 4-(4-aminophenoxy)-2-butylbenzenamine, 4-(4-aminophenoxy)-3-isobutylbenzenamine, 4-(4-aminophenoxy)-2-isobutylbenzenamine, and

4-(4-aminophenoxy)-3-pentylbenzenamine, 4-(4-aminophenoxy)-2-pentylbenzenamine, 4-(4-aminophenoxy)-3-hexylbenzenamine, 4-(4-aminophenoxy)-2-hexylbenzenamine, 4-(4-aminophenoxy)-3-(trifluoromethyl)benzenamine, 4-(4-aminophenoxy)-2-(trifluoromethyl)benzenamine, 4-(4-aminophenoxy)-3-methoxybenzenamine, 4-(4-aminophenoxy)-2-methoxybenzenamine, 4-(4-aminophenoxy)-3-ethoxybenzenamine, 4-(4-aminophenoxy)-2-ethoxybenzenamine, 4-(4-aminophenoxy)-3-propoxybenzenamine, 4-(4-aminophenoxy)-2-propoxybenzenamine, 4-(4-aminophenoxy)-3-butoxybenzenamine, 4-(4-aminophenoxy)-2-butoxybenzenamine, 4-(4-aminophenoxy)-3-phenylbenzenamine, 4-(4-aminophenoxy)-2-phenylbenzenamine, 4-(4-aminophenoxy)-3-methylphenylbenzenamine, 4-(4-aminophenoxy)-2-methylphenylbenzenamine, 4-(4-aminophenoxy)-3-ethylphenylbenzenamine, 4-(4-aminophenoxy)-2-ethylphenylbenzenamine, 4-(4-aminophenoxy)-3-propylphenylbenzenamine, 4-(4-aminophenoxy)-2-propylphenylbenzenamine, 4-(4-aminophenoxy)-3-butylphenylbenzenamine, 4-(4-aminophenoxy)-2-butylphenylbenzenamine, 4-(4-aminophenoxy)-3-fluorophenylbenzenamine, 4-(4-aminophenoxy)-2-fluorophenylbenzenamine, 4-(4-aminophenoxy)-3-chlorophenylbenzenamine, 4-(4-aminophenoxy)-2-chlorophenylbenzenamine, 4-(4-aminophenoxy)-3-bromophenylbenzenamine, 4-(4-aminophenoxy)-2-bromophenylbenzenamine, 4-(4-aminophenoxy)-3-methoxyphenylbenzenamine, 4-(4-aminophenoxy)-2-methoxyphenylbenzenamine, 4-(4-aminophenoxy)-3-ethoxyphenylbenzenamine, 4-(4-aminophenoxy)-2-ethoxyphenylbenzenamine, 4-(4-aminophenoxy)-3-(phenylethyl)phenylbenzenamine, 4-(4-aminophenoxy)-2-(phenylethyl)phenylbenzenamine, 4-(4-aminophenoxy)-3-naphthylphenylbenzenamine, 4-(4-aminophenoxy)-2-naphthylphenylbenzenamine, 4-(4-aminophenoxy)-3-benzylphenylbenzenamine, 4-(4-aminophenoxy)-2-benzylphenylbenzenamine, 4-((4-aminophenyl)thio)-3-methylbenzenamine, 4-((4-aminophenyl)thio)-2-methylbenzenamine, 4-((4-aminophenyl)thio)-3-ethylbenzenamine, 4-((4-aminophenyl)thio)-2-ethylbenzenamine, 4-((4-aminophenyl) thio)-3-propylbenzenamine, 4-((4-aminophenyl)thio)-2-propylbenzenamine, 4-((4-aminophenyl)thio)-3-isopropylbenzenamine, 4-((4-aminophenyl)thio)-2-isopropylbenzenamine, 4-((4-aminophenyl)thio)-3-butylbenzenamine, 4-((4-aminophenyl)thio)-2-butylbenzenamine, 4-((4-aminophenyl)thio)-3-isobutylbenzenamine, 4-((4-aminophenyl)thio)-2-isobutylbenzenamine, 4-((4-aminophenyl)thio)-3-(trifluoromethyl)benzenamine, 4-((4-aminophenyl)thio)-2-(trifluoromethyl) benzenamine, 4-((4-aminophenyl)thio)-3-methoxybenzenamine, 4-((4-aminophenyl)thio)-2-methoxybenzenamine, 4-((4-aminophenyl)thio)-3-ethoxybenzenamine, 4-((4-aminophenyl)thio)-2-ethoxybenzenamine, 4-((4-aminophenyl) thio)-3-propoxybenzenamine, 4-((4-aminophenyl)thio)-2-propoxybenzenamine, 4-((4-aminophenyl)thio)-3-isopropoxybenzenamine, 4-((4-aminophenyl)thio)-2-isopropoxybenzenamine, 4-((4-aminophenyl)thio)-3-butoxybenzenamine, 4-((4-aminophenyl)thio)-2-butoxybenzenamine, 4-((4-aminophenyl)thio)-3-phenylbenzenamine, 4-((4-aminophenyl) thio)-2-phenylbenzenamine, 4-((4-aminophenyl)thio)-3-naphthylbenzenamine, 4-((4-aminophenyl)thio)-2-naphthylbenzenamine, 4-((4-aminophenyl)thio)-3-methoxyphenylbenzenamine, 4-((4-aminophenyl)thio)-2-methoxyphenylbenzenamine, 4-((4-aminophenyl)methyl)-3-methylbenzenamine, 4-((4-aminophenyl)methyl)-2-methylbenzenamine, 4-((4-aminophenyl)methyl)-3-ethylbenzenamine, 4-((4-aminophenyl)methyl)-2-ethylbenzenamine, 4-((4-aminophenyl) methyl)-3-propylbenzenamine, 4-((4-aminophenyl)methyl)-2-propylbenzenamine, 4-((4-aminophenyl)methyl)-3-isopropylbenzenamine, 4-((4-aminophenyl)methyl)-2-isopropylbenzenamine, 4-((4-aminophenyl)methyl)-3-butylbenzenamine, 4-((4-aminophenyl)methyl)-2-butylbenzenamine, 4-((4-aminophenyl)methyl)-3-isobutylbenzenamine, 4-((4-aminophenyl)methyl)-2-isobutylbenzenamine, 4-((4-aminophenyl)methyl)-3-(trifluoromethyl)benzenamine, 4-((4-aminophenyl)methyl)-2-(trifluoromethyl)benzenamine, 4-((4-aminophenyl)methyl)-3-methoxybenzenamine, 4-((4-aminophenyl)methyl)-2-methoxybenzenamine, 4-((4-aminophenyl)methyl)-3-ethoxybenzenamine, 4-((4-aminophenyl)methyl)-2-ethoxybenzenamine, 4-((4-aminophenyl)methyl)-3-propoxybenzenamine, 4-((4-aminophenyl)methyl)-2-propoxybenzenamine, 4-((4-aminophenyl)methyl)-3-isopropoxybenzenamine, 4-((4-aminophenyl)methyl)-2-isopropoxybenzenamine, 4-((4-aminophenyl)methyl)-3-butoxybenzenamine, 4-((4-aminophenyl)methyl)-2-butoxybenzenamine, 4-((4-aminophenyl)methyl)-3-phenylbenzenamine, 4-((4-aminophenyl)methyl)-2-phenylbenzenamine, 4-((4-aminophenyl) methyl)-3-naphthylbenzenamine, 4-((4-aminophenyl)methyl)-2-naphthylbenzenamine, 4-((4-aminophenyl)methyl)-3-methoxyphenylbenzenamine, 4-((4-aminophenyl)methyl)-2-methoxyphenylbenzenamine, (4-amino-2-methylphenyl) (4-aminophenyl)methanone, (4-amino-2-ethylphenyl)(4-aminophenyl)methanone, (4-amino-2-propylphenyl) (4-aminophenyl)methanone, (4-amino-2-isopropylphenyl) (4-aminophenyl)methanone, (4-amino-2-butylphenyl) (4-aminophenyl) methanone, (4-amino-2-(trifluoromethyl)phenyl)(4-aminophenyl)methanone, 4-amino-2-methoxyphenyl) (4-aminophenyl)methanone, 4-amino-2-ethoxyphenyl) (4-aminophenyl)methanone, (4-amino-2-(phenyl)phenyl) (4-aminophenyl) methanone, and (4-amino-2-(methoxyphenyl)phenyl)(4-aminophenyl)methanone. However, examples are not limited thereto.

Here, the polymer having the polyimide precursor containing the structural unit represented by the general formula (2) can be obtained by, for example, reacting a tetracarboxylic acid diester compound represented by the general formula (13) with a diamine represented by the general formula (14) in the presence of a dehydration condensation agent. That is, the polymer having the polyimide precursor containing the structural unit represented by the general formula (2) can be obtained by using the tetracarboxylic acid diester compound represented by the general formula (13) for the reaction in the state of being dissolved in the reaction solvent; adding into this reaction solution a known dehydration condensation agent (for example, dicyclohexylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate or the like) and mixing the resultant mixture under ice cooling to make the tetracarboxylic acid diester compound represented by the general formula (13) into a polyacid anhydride; and then adding dropwise to this the diamine represented by the general formula (14) that has been dissolved or dispersed in a solvent separately to carry out the polycondensation.

In addition, examples of other methods of obtaining the polymer having the polyimide precursor containing the structural unit represented by the general formula (2) by reacting the tetracarboxylic acid diester compound represented by the general formula (13) with the diamine compound represented by the general formula (14) include a process in which the polymer is synthesized by converting the tetracarboxylic acid diester compound represented by the general formula (13) into an acid chloride with using a chlorinating agent such as thionyl chloride or oxalyl chloride, and reacting the acid chloride with the diamine represented by the general formula (14).

In the reaction in which the tetracarboxylic acid diester compound is converted into an acid chloride with using a chlorinating agent, a basic compound may be further used. For this basic compound, for example, pyridine, 4-dimethylaminopyridine, triethylamine, or the like can be used.

Then, by reacting the obtained acid chloride of the tetracarboxylic acid diester compound with the diamine represented by the general formula (14) in the presence of a basic catalyst, the target polymer having the polyimide precursor containing the structural unit represented by the general formula (2) can be obtained. Upon this, examples of the basic catalyst include pyridine, dimethylaminopyridine, 1,8-diazabicyclo[5.4.0]undeca-7-ene, 1,5-diazabicyclo[4.3.0]nona-5-ene, etc.

In the method of producing the polymer having the polyimide precursor to be contained in the inventive negative photosensitive resin composition, the preferable solvent to be used in the process through the acid chloride well dissolves the above-described tetracarboxylic acid diester compound and an acid chloride thereof, as well as the polymer of the polyimide precursor obtained through the polycondensation reaction of them with the diamine, and a similar solvent to those given above can be used. Specific examples thereof include N-methyl-2-pyrrolidone, N,N-dimethylacetamide, N,N-dimethylformamide, dimethylsulfoxide, tetramethylurea, hexamethylphosphoric triamide, and γ-butyrolactone. In addition, other than polar solvents, ketones, esters, lactones, ethers, halogenated hydrocarbons, hydrocarbons and the like can also be used. Examples thereof include acetone, diethyl ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, xylene, etc. Any one of these organic solvents may be used, or two or more thereof may be used in combination.

Furthermore, as stated above, the polymer having the polyimide precursor to be contained in the inventive negative photosensitive resin composition can further contain, in addition to the structural unit represented by the general formula (2), a structural unit represented by the following general formula (7).

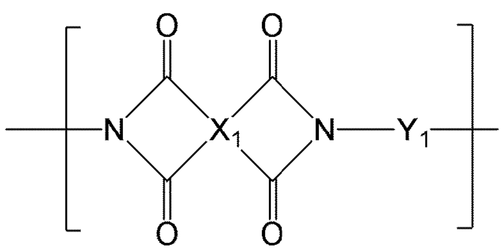

(7)

In the formula, $X_1$ and $Y_1$ are as defined above.

A polymer containing the structural unit represented by the general formula (7) can be obtained by allowing a tetracarboxylic dianhydride represented by the following general formula (17) to react with a diamine represented by the following general formula (18). Firstly, a tetracarboxylic dianhydride represented by the following general formula (17) can be allowed to react with a diamine represented by the following general formula (18) to synthesize an amic acid, and then

subsequently, imidization can be performed by chemical imidization or thermal dehydration to give a polymer containing the structural unit (7).

The structural unit (7) can be prepared by: dissolving a diamine in a solvent that has a high boiling point and high polarity, such as γ-butyrolactone and N-methyl-2-pyrrolidone; then adding an acid anhydride thereto and carrying out a reaction of the resultant mixture at 0 to 80°C, preferably 10 to 50°C, to form an amic acid; and then, in the case of chemical imidization, performing an imidization reaction by adding, for example, acetic anhydride and pyridine, and in the case of imidization by thermal dehydration, adding a non-polar solvent, such as xylene, thereto and heating the reaction solution at 100 to 200°C, preferably 130 to 180°C, thereby carrying out an imidization reaction while removing water from the reaction system.

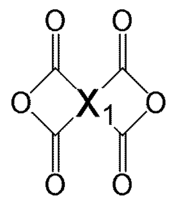

(17)

In the formula, $X_1$ is as defined above.

$H_2N-Y_1-NH,$ (18)

In the formula, $Y_1$ is as defined above.

Suitable examples of the tetracarboxylic dianhydride represented by the general formula (17) include the examples given for the tetracarboxylic dianhydride represented by the general formula (15).

Suitable examples of the diamine represented by the general formula (18) include the examples given for the diamine represented by the general formula (14).

Furthermore, as stated above, the polymer having the polyimide precursor to be contained in the inventive negative photosensitive resin composition can further contain, in addition to the structural unit represented by the general formula (2), a structural unit represented by the following general formula (8).

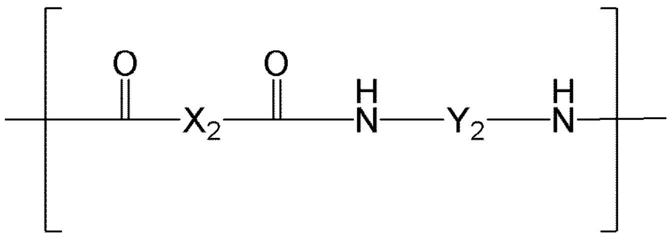

(8)

In the formula, $X_2$ and $Y_2$ are as defined above.

A polymer containing the structural unit represented by the general formula (8) can be obtained by performing the same reaction procedure as in the case of the structural unit (2). That is, the polymer can be obtained by reacting a dicarboxylic acid compound represented by the following general formula (19) in the presence of a dehydration condensation agent or using a chlorinating agent to convert the compound into an acid chloride, and then reacting the acid chloride with a diamine represented by the following general formula (20).

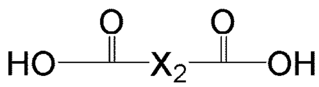

(19)

In the formula, $X_2$ is as defined above.

$H_2N-Y_2-NH_2$ (20)

In the formula, $Y_2$ is as defined above.

Examples of the dicarboxylic acid compound represented by the general formula (19) include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric

acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, etc.

Further, examples of the dicarboxylic acid compound having an aromatic ring include, but are not limited to, phthalic acid, isophthalic acid, terephthalic acid, 4,4'-diphenyl ether dicarboxylic acid, 3,4'-diphenyl ether dicarboxylic acid, 3,3'-diphenyl ether dicarboxylic acid, 4,4'-biphenyldicarboxylic acid, 3,4'-biphenyldicarboxylic acid, 3,3'-biphenyldicarboxylic acid, 4,4'-benzophenonedicarboxylic acid, 3,4'-benzophenonedicarboxylic acid, 3,3'-benzophenonedicarboxylic acid, 4,4'-hexafluoroisopropylidenedibenzoic acid, 4,4'-dicarboxydiphenylamide, 1,4-phenylenediethanoic acid, bis(4-carboxyphenyl)sulfide, 2,2-bis(4-carboxyphenyl)-1,1,1,3,3,3-hexafluoropropane, bis(4-carboxyphenyl)tetraphenyldisiloxane, bis(4-carboxyphenyl)tetramethyldisiloxane, bis(4-carboxyphenyl)sulfone, bis(4-carboxyphenyl)methane, 5-tert-butylisophthalic acid, 5-bromoisophthalic acid, 5-fluoroisophthalic acid, 5-chloroisophthalic acid, 2,2-bis-(p-carboxyphenyl)propane, and 2,6-naphthalenedicarboxylic acid, etc. In addition, one of the compounds may be used or the compounds may be used in mixture.

Suitable examples of the diamine represented by the general formula (20) include the examples given for the diamine represented by the general formula (14).

Furthermore, as stated above, the polymer having the polyimide precursor to be contained in the inventive negative photosensitive resin composition can further contain, in addition to the structural unit represented by the general formula (2), a structural unit represented by the following general formula (9).

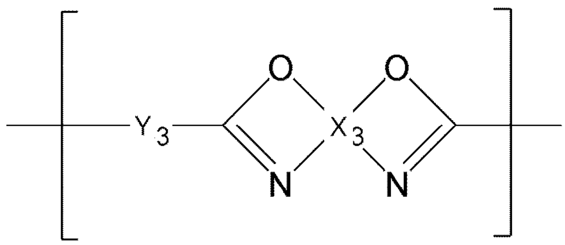

(9)

In the formula, $X_3$ and $Y_3$ are as defined above.

A polymer containing the structural unit represented by the general formula (9) can be obtained by reacting a dicarboxylic acid compound represented by the following general formula (21) in the presence of a dehydration condensation agent or using a chlorinating agent to convert the compound into an acid chloride, then reacting the acid chloride with a dihydroxydiamine compound represented by the following general formula (22) to synthesize a hydroxyamide (polyoxazole precursor), and then forming an oxazole ring through a thermal dehydration process.

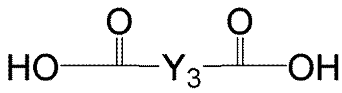

(21)

In the formula, $Y_3$ is as defined above.

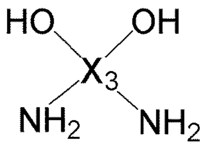

(22)

In the formula, $X_3$ is as defined above.

Suitable examples of the dicarboxylic acid compound represented by the general formula (21) include the examples given for the dicarboxylic acid compound represented by the general formula (19).

Examples of the dihydroxydiamine compound represented by the general formula (22) include, but are not limited to, 3,3'-diamino-4,4'-dihydroxybiphenyl, 3,3'-diamino-4,4'-dihydroxybiphenyl ether, 2,2'-bis(3-amino-4-hydroxyphenyl) sulfide, 2,2'-bis(3-amino-4-hydroxyphenyl) ketone, 3,3'-diamino-4,4'-dihydroxyphenylmethane, 1,2-bis(3-amino-4-hydroxyphenyl)ethane, 2,2'-bis(3-amino-4-hydroxyphenyl)difluoromethane, 4,4'-(1,1,2,2,3,3-hexafluoro-1,3-propanediyl) bis(2-aminophenol), 2,2'-bis(3-amino-4-hydroxyphenyl)propane, 2,2'-bis(3-amino-4-hydroxyphenyl)hexafluoropropane, 2,2'-bis(3-amino-4-hydroxyphenyl)sulfone, 1,1-bis(3-amino-4-hydroxyphenyl)cyclohexane, 4,4'-(1,4-phenylenebis(oxy))bis(2-aminophenol), 9,9-bis(3-amino-4-hydroxyphenyl)fluorene, etc. Furthermore, one of these compounds may be used, or a mixture thereof may be used.

(Molecular Weight of Polymer and Introduction of EndCapping Agent)

A suitable molecular weight of the above-described polymer is preferably 5,000 to 100,000, more preferably 7,000 to 50,000. When the molecular weight is 5,000 or more, it is easier to form a film of the inventive negative photosensitive resin composition containing the above-described polymer with a desired film thickness on a substrate. When the molecular weight is 100,000 or less, the viscosity of the negative photosensitive resin composition is suitable, and there are no problems in film formation.

The above-described polymer may be capped at both ends with an end-capping agent for the purposes of controlling the molecular weight in the polycondensation reaction and preventing temporal change in the molecular weight of the obtained polymer, that is, gelation. Examples of an end-capping agent that reacts with an acid dianhydride include monoamines, monohydric alcohols, etc. In addition, examples of an end-capping agent that reacts with a diamine compound include acid anhydrides, monocarboxylic acids, monoacid chloride compounds, monoactive ester compounds, dicarbonate esters, vinyl ethers, etc. In addition, by reacting the polymer with an end-capping agent, a variety of organic groups can be introduced as end groups.

Examples of the monoamine to be used as the capping agent for the acid anhydride group terminal include, but are not limited to, aniline, 5-amino-8-hydroxyquinoline, 4-amino-8-hydroxyquinoline, 1-hydroxy-8-aminonaphthalene, 1-hydroxy-7-aminonaphthalene, 1-hydroxy-6-aminonaphthalene, 1-hydroxy-5-aminonaphthalene, 1-hydroxy-4-aminonaphthalene, 1-hydroxy-3-aminonaphthalene, 1-hydroxy-2-aminonaphthalene, 1-amino-7-hydroxynaphthalene, 2-hydroxy-7-aminonaphthalene, 2-hydroxy-6-aminonaphthalene, 2-hydroxy-5-aminonaphthalene, 2-hydroxy-4-aminonaphthalene, 2-hydroxy-3-aminonaphthalene, 1-amino-2-hydroxynaphthalene, 1-carboxy-8-aminonaphthalene, 1-carboxy-7-aminonaphthalene, 1-carboxy-6-aminonaphthalene, 1-carboxy-5-aminonaphthalene, 1-carboxy-4-aminonaphthalene, 1-carboxy-3-aminonaphthalene, 1-carboxy-2-aminonaphthalene, 1-amino-7-carboxynaphthalene, 2-carboxy-7-aminonaphthalene, 2-carboxy-6-aminonaphthalene, 2-carboxy-5-aminonaphthalene, 2-carboxy-4-aminonaphthalene, 2-carboxy-3-aminonaphthalene, 1-amino-2-carboxynaphthalene, 2-aminonicotinic acid, 4-aminonicotinic acid, 5-aminonicotinic acid, 6-aminonicotinic acid, 4-aminosalicylic acid, 5-aminosalicylic acid, 6-aminosalicylic acid, ammelide, 2-aminobenzoic acid, 3-aminobenzoic acid, 4-aminobenzoic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 5-amino-8-mercaptoquinoline, 4-amino-8-mercaptoquinoline, 1-mercapto-8-aminonaphthalene, 1-mercapto-7-aminonaphthalene, 1-mercapto-6-aminonaphthalene, 1-mercapto-5-aminonaphthalene, 1-mercapto-4-aminonaphthalene, 1-mercapto-3-aminonaphthalene, 1-mercapto-2-aminonaphthalene, 1-amino-7-mercaptonaphthalene, 2-mercapto-7-aminonaphthalene, 2-mercapto-6-aminonaphthalene, 2-mercapto-5-aminonaphthalene, 2-mercapto-4-aminonaphthalene, 2-mercapto-3-aminonaphthalene, 1-amino-2-mercaptonaphthalene, 3-amino-4,6-dimercaptopyrimidine, 2-aminothiophenol, 3-aminothiophenol, 4-aminothiophenol, 2-ethynylaniline, 3-ethynylaniline, 4-ethynylaniline, 2,4-diethynylaniline, 2,5-diethynylaniline, 2,6-diethynylaniline, 3,4-diethynylaniline, 3,5-diethynylaniline, 1-ethynyl-2-aminonaphthalene, 1-ethynyl-3-aminonaphthalene, 1-ethynyl-4-aminonaphthalene, 1-ethynyl-5-aminonaphthalene, 1-ethynyl-6-aminonaphthalene, 1-ethynyl-7-aminonaphthalene, 1-ethynyl-8-aminonaphthalene, 2-ethynyl-1-aminonaphthalene, 2-ethynyl-3-aminonaphthalene, 2-ethynyl-4-aminonaphthalene, 2-ethynyl-5-aminonaphthalene, 2-ethynyl-6-aminonaphthalene, 2-ethynyl-7-aminonaphthalene, 2-ethynyl-8-aminonaphthalene, 3,5-diethynyl-1-aminonaphthalene, 3,5-diethynyl-2-aminonaphthalene, 3,6-diethynyl-1-aminonaphthalene, 3,6-diethynyl-2-aminonaphthalene, 3,7-diethynyl-1-aminonaphthalene, 3,7-diethynyl-2-aminonaphthalene, 4,8-diethynyl-1-aminonaphthalene, 4,8-diethynyl-2-aminonaphthalene, 4-fluoroaniline, 3-fluoroaniline, 2-fluoroaniline, 2,4-difluoroaniline, 3,4-difluoroaniline, 2,4,6-trifluoroaniline, 2,3,4-trifluoroaniline, pentafluoroaniline, etc. One of these monoamines may be used, or two or more thereof may be used in combination.

Meanwhile, examples of the monohydric alcohol to be used as the capping agent for the acid anhydride group terminal include, but are not limited to, methanol, ethanol, 1-propanol, 2-propanol, 1-butanol, 2-butanol, 1-pentanol, 2-pentanol, 3-pentanol, 1-hexanol, 2-hexanol, 3-hexanol, 1-heptanol, 2-heptanol, 3-heptanol, 1-octanol, 2-octanol, 3-octanol, 1-nonanol, 2-nonanol, 1-decanol, 2-decanol, 1-undecanol, 2-undecanol, 1-dodecanol, 2-dodecanol, 1-tridecanol, 2-tridecanol, 1-tetradecanol, 2-tetradecanol, 1-pentadecanol, 2-pentadecanol, 1-hexadecanol, 2-hexadecanol, 1-heptadecanol, 2-heptadecanol, 1-octadecanol, 2-octadecanol, 1-nonadecanol, 2-nonadecanol, 1-icosanol, 2-methyl-1-propanol, 2-methyl-2-propanol, 2-methyl-1-butanol, 3-methyl-1-butanol, 2-methyl-2-butanol, 3-methyl-2-butanol, 2-propyl-1-pentanol, 2-ethyl-1-hexanol, 4-methyl-3-heptanol, 6-methyl-2-heptanol, 2,4,4-trimethyl-1-hexanol, 2,6-dimethyl-4-heptanol, isononyl alcohol, 3,7-dimethyl-3-octanol, 2,4-dimethyl-1-heptanol, 2-heptylundecanol, ethylene glycol monoethyl ether, ethylene glycol monomethyl ether, ethylene glycol monobutyl ether, propylene glycol 1-methyl ether, diethylene glycol monoethyl ether, diethylene glycol monomethyl ether, diethylene glycol monobutyl ether, cyclopentanol, cyclohexanol, cyclopentanemonomethylol, dicyclopentanemonomethylol, tricyclodecanemonomethylol, norborneol, terpineol, etc. One of these may be used, or two or more thereof may be used in combination.

Examples of the acid anhydride, monocarboxylic acid, monoacid chloride compound and monoactive ester compound to be used as the capping agent for the amino group terminal include acid anhydrides, such as phthalic anhydride, maleic anhydride, nadic anhydride, cyclohexanedicarboxylic anhydride and 3-hydroxyphthalic anhydride; monocarboxylic acids, such as 2-carboxyphenol, 3-carboxyphenol, 4-carboxyphenol, 2-carboxythiophenol, 3-carboxythiophenol, 4-carboxythiophenol, 1-hydroxy-8-carboxynaphthalene, 1-hydroxy-7-carboxynaphthalene, 1-hydroxy-6-carboxynaphthalene, 1-hydroxy-5-carboxynaphthalene, 1-hydroxy-4-carboxynaphthalene, 1-hydroxy-3-carboxynaphthalene, 1-hydroxy-2-carboxynaphthalene, 1-mercapto-8-carboxynaphthalene, 1-mercapto-7-carboxynaphthalene, 1-mercapto-6-carboxynaphthalene, 1-mercapto-5-carboxynaphthalene, 1-mercapto-4-carboxynaphthalene, 1-mercapto-3-carboxynaphthalene, 1-mercapto-2-carboxynaphthalene, 2-carboxybenzenesulfonic acid, 3-carboxybenzenesulfonic acid, 4-carboxybenzenesulfonic acid, 2-ethynylbenzoic acid, 3-ethynylbenzoic acid, 4-ethynylbenzoic acid, 2,4-diethynylbenzoic acid, 2,5-diethynylbenzoic acid, 2,6-diethynylbenzoic acid, 3,4-diethynylbenzoic acid, 3,5-diethynylbenzoic acid, 2-ethynyl-1-naphthoic acid, 3-ethynyl-1-naphthoic acid, 4-ethynyl-1-naphthoic acid, 5-ethynyl-1-naphthoic acid, 6-ethynyl-1-naphthoic acid, 7-ethynyl-1-naphthoic acid, 8-ethynyl-1-naphthoic acid, 2-ethynyl-2-naphthoic acid, 3-ethynyl-2-naphthoic acid, 4-ethynyl-2-naphthoic acid, 5-ethynyl-2-naphthoic acid, 6-ethynyl-2-naphthoic acid, 7-ethynyl-2-naphthoic acid and 8-ethynyl-2-naphthoic acid, and monoacid chloride compounds in which the carboxy group of the above monocarboxylic acids is acid-chlorinated; monoacid chloride compounds of dicarboxylic acids, such as terephthalic acid, phthalic acid, maleic acid, cyclohexanedicarboxylic acid, 3-hydroxyphthalic acid, 5-norbornene-2,3-dicarboxylic acid, 1,2-dicarboxynaphthalene, 1,3-dicarboxynaphthalene, 1,4-dicarboxynaphthalene, 1,5-dicarboxynaphthalene, 1,6-dicarboxynaphthalene, 1,7-dicarboxynaphthalene, 1,8-dicarboxynaphthalene, 2,3-dicarboxynaphthalene, 2,6-dicarboxynaphthalene and 2,7-dicarboxynaphthalene, in which only a monocarboxy group is acid-chlorinated; and monoactive ester compounds obtained through reaction between monoacid chloride compounds and N-hydroxybenzotriazole or N-hydroxy-5-norbornene-2,3-dicarboxyimide.

Examples of the dicarbonate ester compound to be used as the capping agent for the amino group terminal include di-tert-butyl dicarbonate, dibenzyl dicarbonate, dimethyl dicarbonate, diethyl dicarbonate, etc.

Examples of the vinyl ether compound to be used as the capping agent for the amino group terminal include butyl vinyl ether, cyclohexyl vinyl ether, ethyl vinyl ether, 2-ethylhexyl vinyl ether, isobutyl vinyl ether, isopropyl vinyl ether, n-propyl vinyl ether, tert-butyl vinyl ether, benzyl vinyl ether, etc.

Examples of another compound to be used as the capping agent for the amino group terminal include benzoyl chloride; chloroformate esters, such as fluorenylmethyl chloroformate, 2,2,2-trichloroethyl chloroformate, tert-butyl chloroformate, n-butyl chloroformate, isobutyl chloroformate, benzyl chloroformate, allyl chloroformate, ethyl chloroformate, and isopropyl chloroformate; isocyanate compounds, such as butyl isocyanate, 1-naphthyl isocyanate, octadecyl isocyanate, and phenyl isocyanate; methanesulfonic acid chloride and p-toluenesulfonic acid chloride; etc.

The proportion of the capping agent to be introduced for the acid anhydride group terminal is preferably in the range of 0.1 to 60 mol%, particularly preferably 5 to 50 mol%, and further preferably 5 to 20 mol% relative to the total amount of the tetracarboxylic dianhydride component and the dicarboxylic acid component. Moreover, the proportion of the capping agent to be introduced for the amino group terminal is preferably in the range of 0.1 to 100 mol% and particularly preferably 5 to 90 mol% relative to the diamine component. Moreover, by allowing a reaction with a plurality of end-capping agents, a plurality of different end groups may be introduced.

[Component (D)]

Next, the component (D) nitrogen-containing organic compound of the present invention represented by the following general formula (1) will be described.

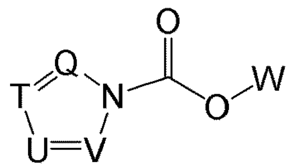

(1)

In the formula, Q represents a nitrogen atom or a carbon atom having an $R^q$ group, T represents a nitrogen atom or a carbon atom having an $R^t$ group, U represents a nitrogen atom or a carbon atom having an $R^u$ group, V represents a nitrogen atom or a carbon atom having an $R^v$ group, the $R^q$ group, the $R^t$ group, the $R^u$ group, and the $R^v$ group each

represent a hydrogen atom, a linear, branched, or cyclic alkyl group having 1 to 15 carbon atoms, an aryl group having 6 to 15 carbon atoms, a halogen atom, or a nitro group, the $R^q$ group and the $R^t$ group, the $R^t$ group and the $R^u$ group, and the $R^u$ group and the $R^v$ group optionally being bonded to each other to form a ring together with the carbon atoms bonded to the $R^q$ group and the $R^t$ group, the $R^t$ group and the $R^u$ group, and the $R^u$ group and the $R^v$ group, and W represents an alkyl group having 1 to 15 carbon atoms or an aryl group having 6 to 15 carbon atoms and is optionally substituted with an alkoxy group.

That is, the nitrogen-containing organic compound represented by the general formula (1) can be shown by the following general formulae (1-1) to (1-9).

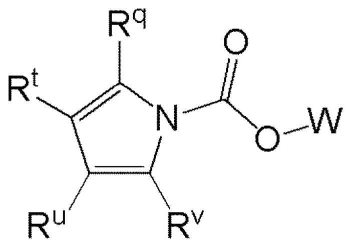
(1−1)

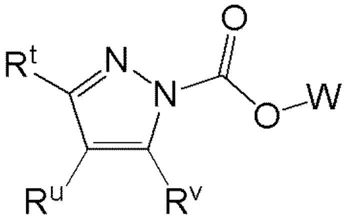
(1−2)

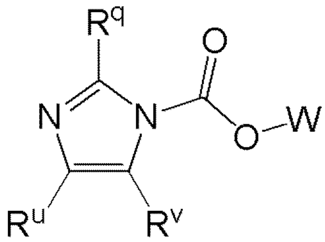
(1−3)

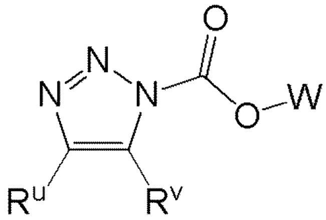
(1−4)

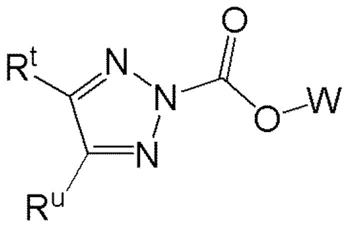
(1−5)

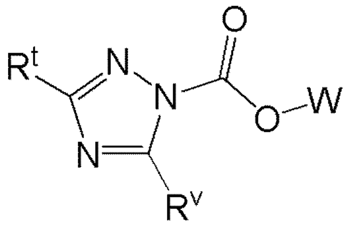
(1−6)

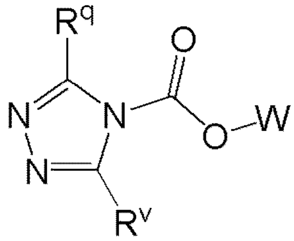
(1−7)

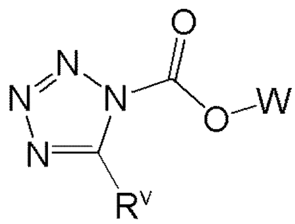
(1−8)

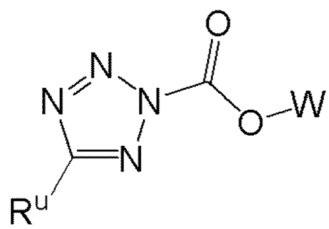
(1−9)

In the formulae, the $R^q$ group, $R^t$ group, $R^u$ group, $R^v$ group, and W have the same meanings as in the general formula (1).

The $R^q$ group, the $R^t$ group, the $R^u$ group, and the $R^v$ group each represent a hydrogen atom, a linear, branched, or cyclic alkyl group having 1 to 15 carbon atoms, an aryl group having 6 to 15 carbon atoms, a halogen atom, or a nitro

group; preferably a hydrogen atom, a linear, branched, or cyclic alkyl group having 1 to 6 carbon atoms, an aryl group having 6 to 15 carbon atoms, a halogen atom, or a nitro group; and further preferably a hydrogen atom, a methyl group, an ethyl group, an n-propyl group, an n-butyl group, a tert-butyl group, a phenyl group, or a nitro group.

The $R^q$ group and the $R^t$ group, which are substituents on adjacent carbon atoms, are optionally bonded to each other to form a ring together with the carbon atoms bonded to the $R^q$ group and the $R^t$ group. Similarly, the $R^t$ group and the $R^u$ group, and the $R^u$ group and the $R^v$ group, which are substituents on adjacent carbon atoms, are optionally bonded to each other to form a ring together with the carbon atoms bonded to the $R^t$ group and the $R^u$ group, and the $R^u$ group and the $R^v$ group. The cyclic structure formed by these groups together with the carbon atoms bonded thereto may constitute an alicyclic structure or aromatic ring structure having 6 to 20 carbon atoms; preferably an alicyclic structure or aromatic ring structure having 6 to 12 carbon atoms. Further preferably, the cyclic structure formed by these groups together with the carbon atoms bonded thereto forms a benzene ring structure, that is, the following general formulae (1-10) to (1-17) are preferable.

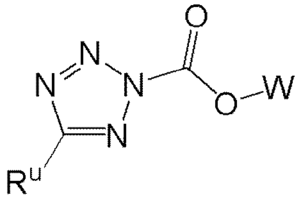

(1−10)

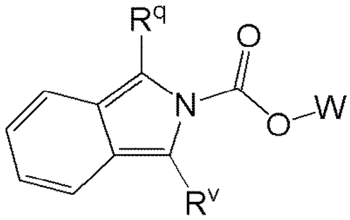

(1−11)

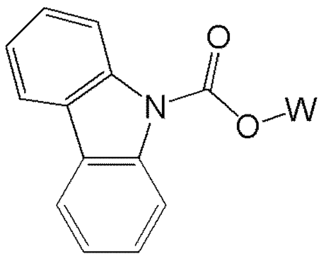

(1−12)

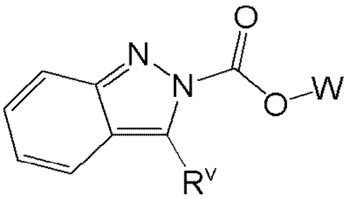

(1−13)

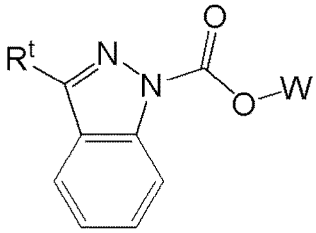

(1−14)

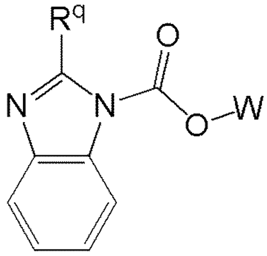

(1−15)

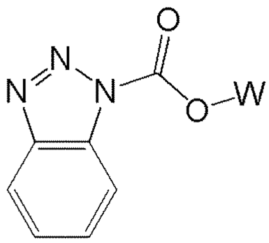

(1−16)

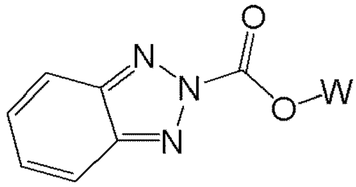

(1−17)

In the formulae, the $R^q$ group, $R^t$ group, $R^u$ group, $R^v$ group, and W have the same meanings as in the general formula (1).

As the cyclic structure formed by these groups together with the carbon atoms bonded thereto, a benzene ring structure is the most preferable as described above. In a case where a condensed aromatic ring structure, such as a naphthalene structure, is formed, absorption of high-energy beams having a wavelength of 190 to 500 nm occurs in a step of performing patterning using the inventive photosensitive resin composition, that is, a step of exposing the photosensitive material film with a high-energy beam having a wavelength of 190 to 500 nm via a photomask, and fine patterning is difficult, and therefore, such a case is unfavorable.

Furthermore, in this event, a nitrogen-containing organic compound in which the W in the general formula (1) of the component (D) represents a tert-butyl group is preferable. When the W is a tert-butyl group, a compound in which the nitrogen atom of the nitrogen-containing organic compound represented by the general formula (1) is protected by a tert-butoxycarbonyl group (N-Boc group) is indicated. A tert-butoxycarbonyl group (N-Boc group) is removed in a heating process of a curing reaction in a range of 100°C to 150°C, and an azole compound, which can promote an imide ring-closing reaction, can be generated. Thus, imidization at 200°C or lower is possible.

Alternatively, in this event, a nitrogen-containing organic compound in which the W in the general formula (1) of the component (D) represents a benzyl group is preferable. When the W is a benzyl group, a compound in which the nitrogen atom of the nitrogen-containing organic compound represented by the general formula (1) is protected by a benzyloxycarbonyl protecting group (Z group) is indicated. A benzyloxycarbonyl protecting group (Z group) is removed in a heating process of a curing reaction in a range of 120°C to 190°C, and an azole compound, which can promote an imide ring-closing reaction, can be generated. Thus, imidization at 200°C or lower is possible.

Further suitable examples of the nitrogen-containing compound represented by the formula (1) include the following compounds.

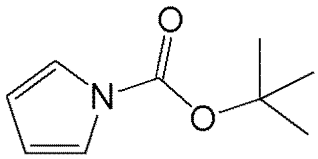

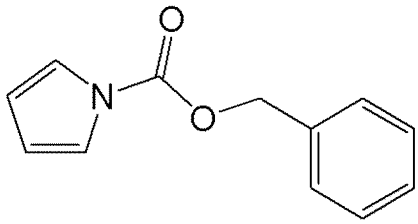

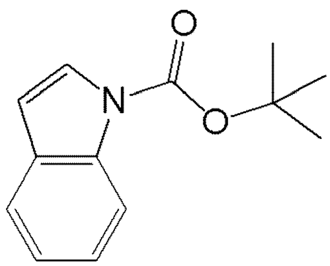

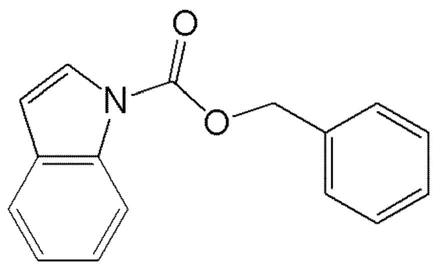

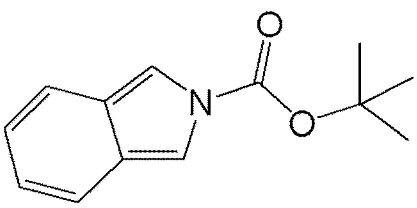

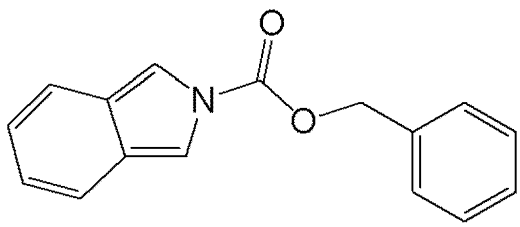

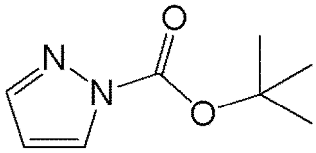

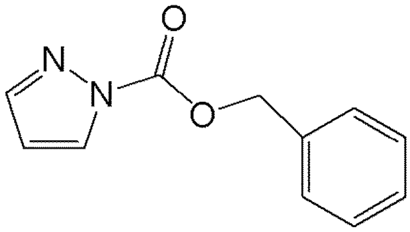

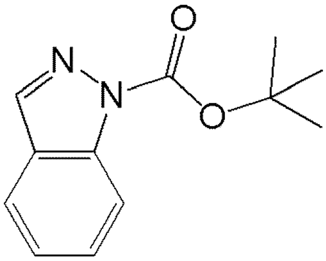

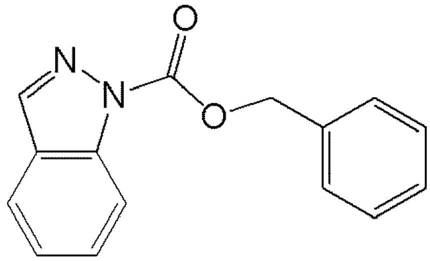

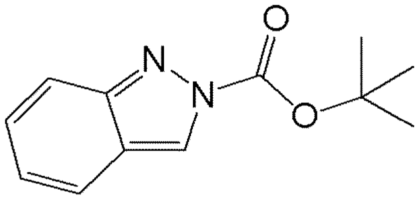

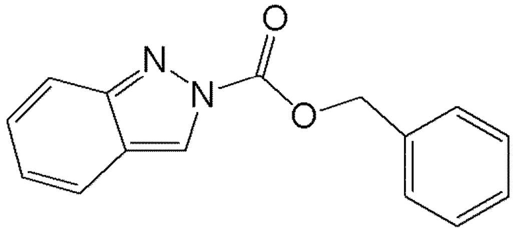

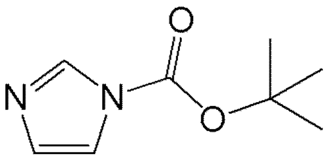

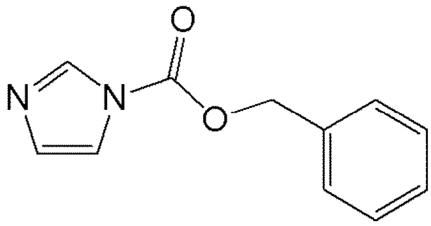

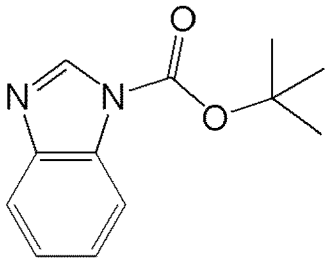

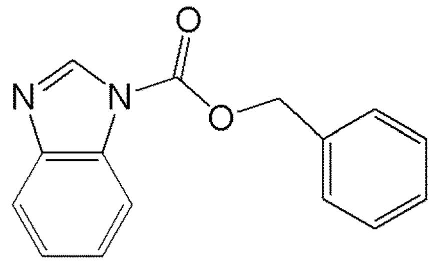

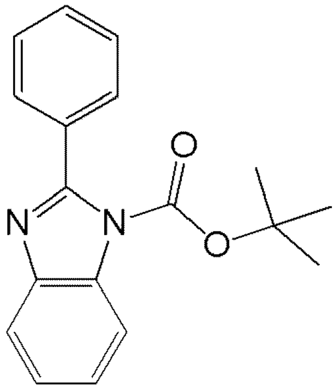

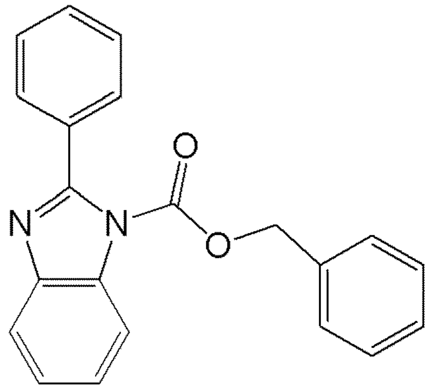

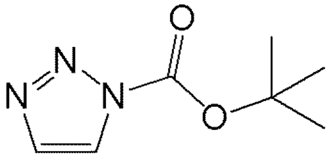
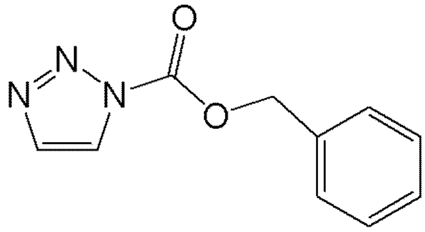
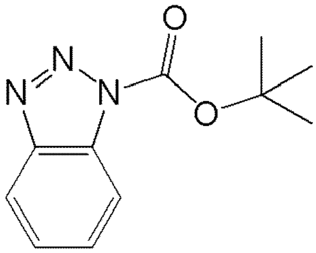
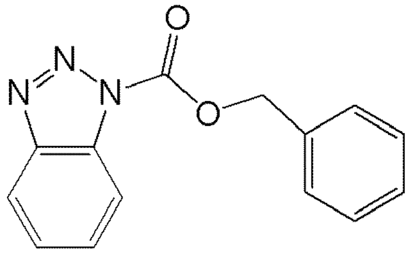
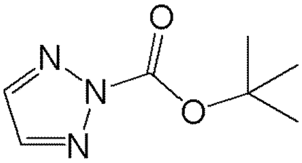
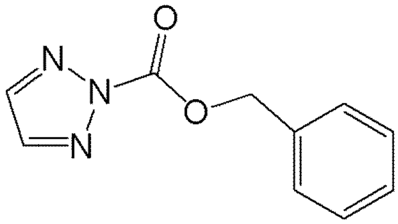
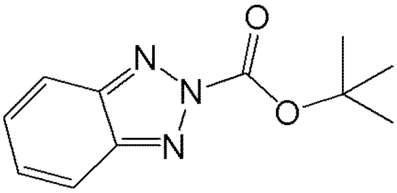
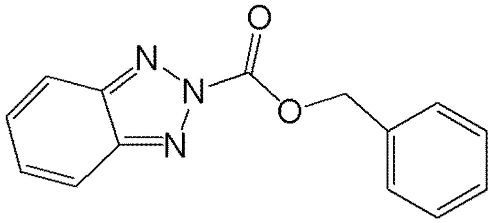
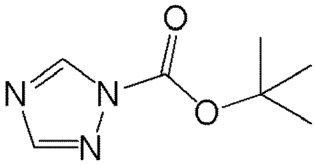
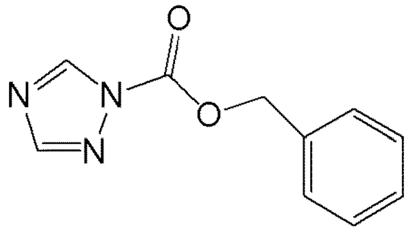
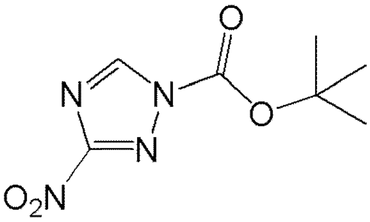
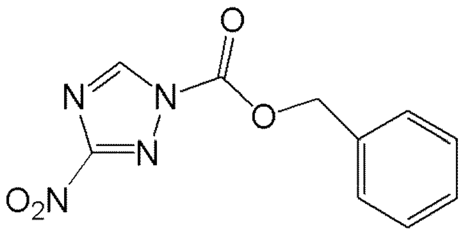

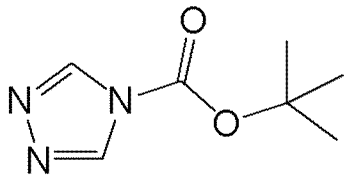

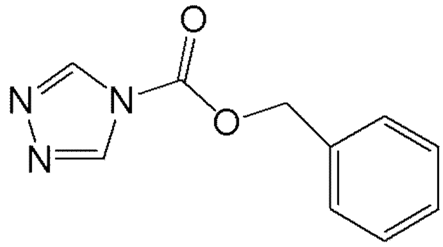

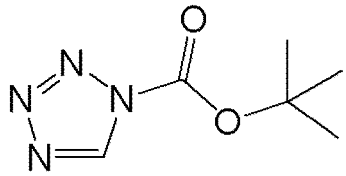

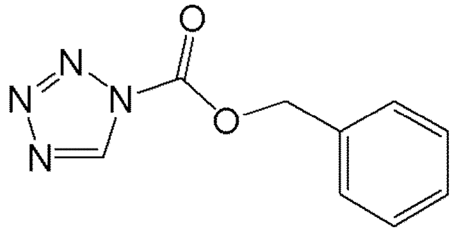

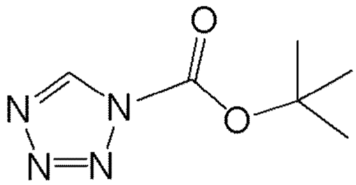

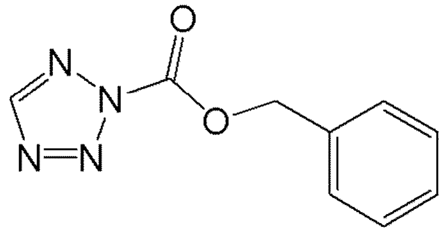

The nitrogen-containing organic compound represented by the general formula (1) can be obtained, for example, by the method shown in the following reaction formula, but is not limited thereto.

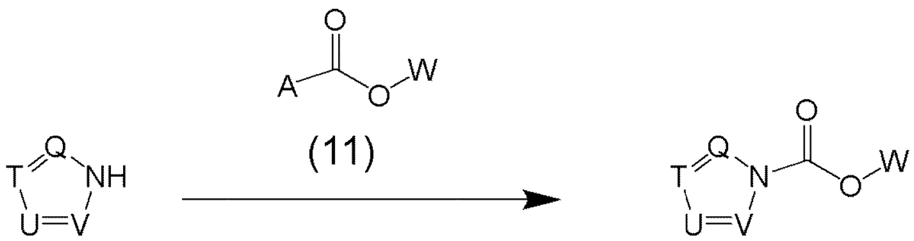


(10) (1)

In the formula, Q, T, U, V, and W are as defined above. A represents a halogen atom or a group represented by the following formula (12).

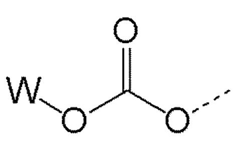

(12)

Here, a broken line represents an attachment point. W is as defined above.

The nitrogen-containing organic compound of the general formula (1) can be obtained by: a reaction between the azole derivative (10) and the halocarbonic acid ester (a compound in which the A of the formula (11) represents a halogen atom in the reaction formula) in the reaction formula; or a reaction between the azole derivative (10) and the dicarbonate diester (a compound in which the A represents the formula (12) in the reaction formula) in the reaction formula.

In the case of a nitrogen-containing organic compound of the general formula (1) in which the W represents a tert-butyl group, the compound can be obtained by a reaction between the azole derivative (10) and the di-tert-butyl dicarbonate (a compound in which the A of the formula (11) represents the formula (12) and the W represents a tert-butyl group in the reaction formula) in the reaction formula.

In the case of a nitrogen-containing organic compound in which the W in the general formula (1) represents a benzyl group, the compound can be obtained by: a reaction between the azole derivative (10) and the benzyloxycarbonyl halide (a compound in which the A of the formula (11) represents a halogen atom and the W represents a benzyl group in the reaction formula) in the reaction formula; or a reaction between the azole derivative (10) and the dibenzyl carbonate (a compound in which the A of the formula (11) represents the formula (12) and the W represents a benzyl group in the reaction formula) in the reaction formula.

When the azole derivative (10) and the halocarbonic acid ester in the above reaction formula are used for the nitrogen-containing compound of the general formula (1), the reaction can be performed without a solvent or in a solvent, such as methylene chloride, acetonitrile, diethyl ether, tetrahydrofuran, N,N-dimethylformamide, toluene, and hexane, and it is possible to add the azole derivative (10), the corresponding halocarbonic acid ester, such as benzyl chlorocarbonate and 4-methoxybenzyl chlorocarbonate, and a base, such as triethylamine, pyridine, 2,6-lutidine, and N,N-dimethylaniline successively or simultaneously under cooling, heating, etc. as necessary.

When the azole derivative (10) and the dicarbonate diester in the above reaction formula are used for the nitrogen-containing compound of the general formula (1), the reaction can be performed in a solvent, such as methylene chloride, acetonitrile, diethyl ether, tetrahydrofuran, N,N-dimethylformamide, toluene, and hexane, and it is possible to add the azole derivative (10), carbonate diester, and a base, such as triethylamine, pyridine, 2,6-lutidine, and N,N-dimethylaniline successively or simultaneously under cooling, heating, etc. as necessary.

The amount of the halocarbonic acid ester or the carbonate diester represented by (11) in the reaction formula to be used varies depending on conditions, but for example, is preferably 1.0 to 5.0 mol, particularly preferably 1.0 to 2.0 mol based on 1 mol of the azole derivative (10), being the starting material. The amount of the base to be used varies depending on conditions, but for example, is preferably 0 to 5.0 mol, particularly preferably 0 to 2.0 mol based on 1 mol of the azole derivative (10), being the starting material. The reaction is desirably monitored by gas chromatography (GC) or silica-gel thin-layer chromatography (TLC) to complete the reaction in terms of yield, and the reaction time is typically approximately 0.5 to 24 hours. A common aqueous work-up of the reaction mixture can yield the target nitrogen-containing organic compound (1), and the compound can be purified, as necessary, by a common method such as distillation, chromatography, and recrystallization. Alternatively, in some cases, it is possible to purify the compound after filtering the salt generated in the reaction or purify the reaction solution directly without performing an aqueous work-up.

Meanwhile, 1 to 10 parts by mass of the component (D) nitrogen-containing organic compound is preferably contained based on 100 parts by mass of the component (A).

When the amount of the component (D) nitrogen-containing organic compound is 10 parts by mass or less, the contained nitrogen-containing compound does not function as a plasticizer, and therefore, deformation of a formed pattern due to heat, that is, thermal flow, does not occur and there is no risk of the pattern formation being degraded. Furthermore, after curing, there is no risk of the glass transition point (Tg.) of the obtained cured film decreasing.

[Component (C)]

Next, the photopolymerization initiator (C) will be described.

As the photopolymerization initiator (C), any compound that is conventionally used as a photopolymerization initiator for UV curing can be selected. Preferable examples include, but are not limited to: benzophenone derivatives, such as benzophenone, methyl o-benzoylbenzoate, 4-benzoyl-4'-methyldiphenyl ketone, dibenzyl ketone, and fluorenone; acetophenone derivatives, such as 2,2'-diethoxyacetophenone, 2-hydroxy-2-methylpropiophenone, and 1-hydroxycyclohexyl phenyl ketone; thioxanthone derivatives, such as thioxanthone, 2-methylthioxanthone, 2-isopropylthioxanthone, and diethylthioxanthone; benzyl derivatives, such as benzyl, benzyl dimethyl ketal, and benzyl-β-methoxyethyl acetal; benzoin derivatives, such as benzoin and benzoin methyl ether; oximes, such as 1-phenyl-1,2-butanedione-2-(O-methoxycarbonyl)oxime, 1-phenyl-1,2-propanedione-2-(O-methoxycarbonyl)oxime, 1-phenyl-1,2-propanedione-2-(O-ethoxycarbonyl)oxime, 1-phenyl-1,2-propanedione-2-(O-benzoyl)oxime, 1,3-diphenylpropanetrione-2-(O-ethoxycarbonyl)oxime, and 1-phenyl-3-ethoxypropanetrione-2-(O-benzoyl)oxime; N-arylglycines, such as N-phenylglycine; peroxides, such as benzoyl perchloride; and aromatic imidazoles. Furthermore, one of these compounds may be used, or two or more kinds thereof may be used in mixture. Among the above photopolymerization initiators (C), oximes are more preferable particularly from the viewpoint of photosensitivity.

The photopolymerization initiator (C) is preferably contained in an amount of 0.1 parts by mass to 20 parts by mass, and from the viewpoint of photosensitivity property, preferably 2 parts by mass to 15 parts by mass relative to 100 parts by mass of the polymer of the present invention having a structural unit of the polyimide precursor, the polymer being the base resin (A). When the photopolymerization initiator (C) is contained in an amount of 0.1 parts by mass or more relative to 100 parts by mass of the base resin (A), the photosensitive resin composition is excellent in photosensitivity, and meanwhile, when contained in an amount of 20 parts by mass or less, the photosensitive resin composition is excellent in thick-film curability.

[Component (E)]

Next, the solvent (E) of the inventive negative photosensitive resin composition will be described.

Organic solvents that can be selected are not limited as long as they are capable of dissolving the base resin of (A), the photopolymerization initiator (C), and the nitrogen-containing organic compound (D) represented by the general formula (1). Examples of the solvent (E) include: ketones, such as cyclohexanone, cyclopentanone, and methyl-2-n-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone; etc. One or more kinds thereof may be used. In particular, ethyl lactate, cyclohexanone, cyclopentanone, propylene glycol monomethyl ether acetate, γ-butyrolactone, or a mixed solvent thereof is preferable.

The amount of the solvent to be contained is preferably 50 to 2,000 parts by mass, particularly preferably 100 to 1,000 parts by mass based on a total of 100 parts by mass of the contained amount of the base polymer of (A) and the photopolymerization initiator (C).

[Component (B)]

Furthermore, the inventive negative photosensitive resin composition preferably contains (B) a polymerizable compound having a group containing two or more ethylenically unsaturated groups.

When a crosslinking agent having two or more photopolymerizable unsaturated bonds in one molecule is contained as described, it is possible to promote the crosslinking by the photopolymerization of the component (A) in exposed portions and enhance the contrast between exposed and unexposed portions.

As the polymerizable compound (B) having a group containing two or more ethylenically unsaturated groups, (meth)acrylic compounds are preferable, and preferable examples include, but are not limited to, ethylene glycol diacrylate, ethylene glycol dimethacrylate, polyethylene glycol diacrylate (each having 2 to 20 ethylene glycol units), polyethylene glycol dimethacrylate (each having 2 to 20 ethylene glycol units), poly(1,2-propylene glycol) diacrylate, poly(1,2-propylene glycol) dimethacrylate, 1,6-hexanediol diacrylate, neopentyl glycol diacrylate, pentaerythritol diacrylate, trimethylolpropane triacrylate, pentaerythritol triacrylate, dipentaerythritol hexaacrylate, tetramethylolpropane tetraacrylate, tetraethylene glycol diacrylate, 1,6-hexanediol dimethacrylate, neopentyl glycol dimethacrylate, pentaerythritol dimethacrylate, trimethylolpropane trimethacrylate, pentaerythritol trimethacrylate, dipentaerythritol hexamethacrylate, tetramethylolpropane tetramethacrylate, glycerol diacrylate, glycerol dimethacrylate, methylenebisacrylamide, N-methylolacrylamide, an adduct of ethylene glycol diglycidyl ether and methacrylic acid, an adduct of glycerol diglycidyl ether and acrylic acid, an adduct of bisphenol A diglycidyl ether and acrylic acid, an adduct of bisphenol A diglycidyl ether and methacrylic acid, and N,N'-bis(2-methacryloyloxyethyl) urea.

The polymerizable compound (B) having a group containing two or more ethylenically unsaturated groups is preferably contained in an amount of 1 to 100 parts by weight, further preferably 3 to 50 parts by weight based on 100 parts by mass of the polymer having the structural unit of the polyimide precursor of the present invention. When the amount is in the range of 1 to 100 parts by weight, the target advantageous effects can be sufficiently achieved. Note that, as a copolymerization monomer, one kind of compound may be used, or a mixture of multiple kinds may be used.

[Component (F)]

The inventive negative photosensitive resin composition can further contain, as (F) a heat crosslinking agent component, one or more kinds of crosslinking agents selected from an amino condensate modified by formaldehyde or formaldehyde-alcohol; a phenol compound having two or more methylol groups or alkoxymethylol groups by average in one molecule; a compound in which a hydrogen atom of a hydroxy group of polyhydric phenol is substituted with a glycidyl group; a compound in which a hydrogen atom of a hydroxy group of polyhydric phenol or a hydroxy group of polyhydric alcohol is substituted with a substituent represented by the following formula (F-1); and a compound having two or more nitrogen atoms having a glycidyl group represented by the following formula (F-2).

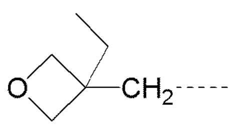

(F-1)

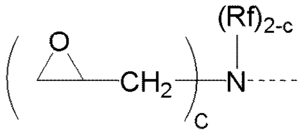 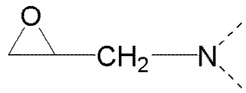 (F-2)

In the formulae, a dotted line represents an attachment point, Rf represents a linear, branched, or cyclic alkyl group having 1 to 6 carbon atoms, and "c" represents 1 or 2.

Examples of the amino condensates modified by the formaldehyde or formaldehyde-alcohol include a melamine condensate modified by the formaldehyde or formaldehyde-alcohol, and a urea condensate modified by the formaldehyde or formaldehyde-alcohol.

The melamine condensate modified by the formaldehyde or formaldehyde-alcohol is prepared, for example, in such a manner that, firstly, according to a well-known method, a melamine monomer is modified by methylol reaction with formalin, or this is further modified by alkoxylation with alcohol, and thus, a modified melamine represented by the following general formula (23) is obtained. As the alcohol, a lower alcohol, for example, an alcohol having 1 to 4 carbon atoms, is preferable.

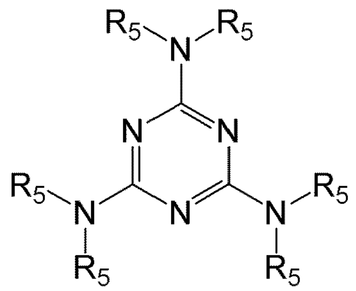

(23)

In the formula, $R_5$s may be the identical to or different from each other, and are methylol groups, alkoxymethyl groups containing an alkoxy group having 1 to 4 carbon atoms, or hydrogen atoms, provided that at least one $R_5$ is a methylol group or the alkoxymethyl group.

Examples of the $R_5$ include a hydrogen atom, a methylol group, and alkoxymethyl groups such as a methoxymethyl group and an ethoxymethyl group.

Specific examples of the modified melamine represented by the general formula (23) include trimethoxymethylmonomethylol melamine, dimethoxymethylmonomethylol melamine, trimethylol melamine, hexamethylol melamine, and hexamethoxymethylol melamine. Next, the modified melamine represented by the general formula (23) or its multimer (for example, an oligomer such as a dimer or a trimer) is subjected to addition condensation polymerization with formaldehyde until a desired molecular weight is obtained according to the conventional method to obtain a melamine condensate modified by formaldehyde or formaldehyde-alcohol.

The urea condensate modified by the formaldehyde or formaldehyde-alcohol is prepared, according to, for example, a well-known method, by modifying a urea condensate having a desired molecular weight by methylol reaction with formaldehyde, or by further modifying by alkoxylation with alcohol.

Specific examples of the urea condensate modified by the formaldehyde or formaldehyde-alcohol include a methoxymethylated urea condensate, an ethoxymethylated urea condensate, a propoxymethylated urea condensate, and the like.

One of these modified melamine condensates and modified urea condensates may be used or two or more kinds thereof may be used in mixture.

Next, examples of the phenol compound having two or more methylol groups or alkoxymethylol groups in average in one molecule include (2-hydroxy-5-methyl)-1,3-benzenedimethanol, 2,2',6,6'-tetramethoxymethylbisphenol A, compounds represented by the following formulae (F-3) to (F-8), and the like.

(F-3)

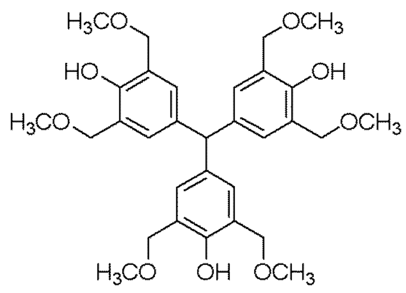

(F-4)

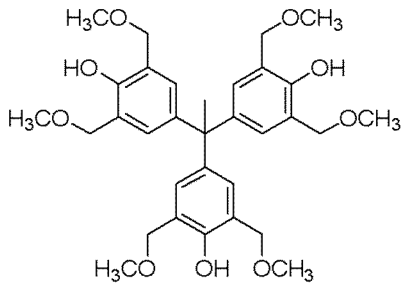

(F-5)

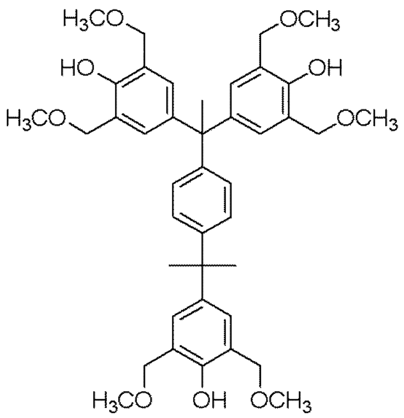

(F-6)

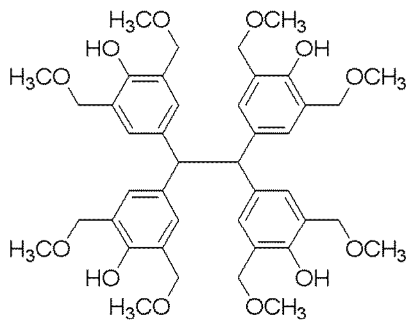

(F-7)

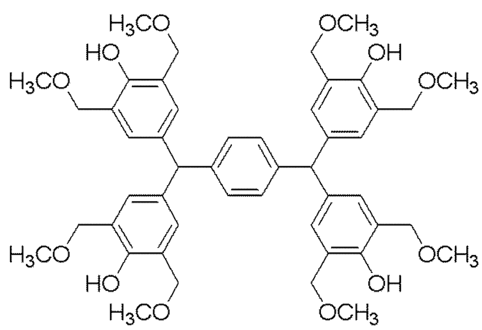

(F-8)

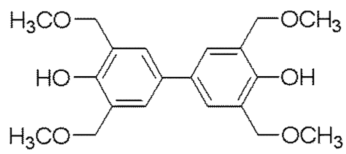

One of the crosslinking agents may be used or two or more kinds may be used in combination.

Meanwhile, examples of the compounds in which a hydrogen atom of a hydroxy group of polyhydric phenol is substituted with a glycidyl group include a compound obtained by reaction of the hydroxy group of bisphenol A, tris(4-hydroxyphenyl)methane, and 1,1,1-tris(4-hydroxyphenyl)ethane with epichlorohydrin in the presence of a base. Suitable examples of the compound in which a hydrogen atom of a hydroxy group of a polyhydric phenol is substituted with a glycidyl group include the compounds represented by the following formulae (F-9) to (F-15).

(F-9)

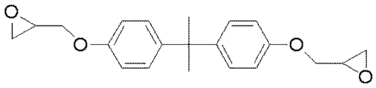

(F-10)

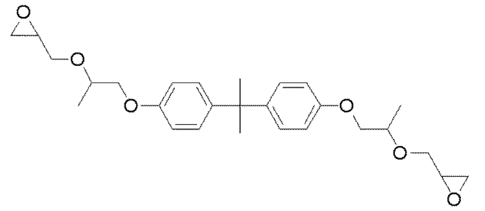

(F-11)

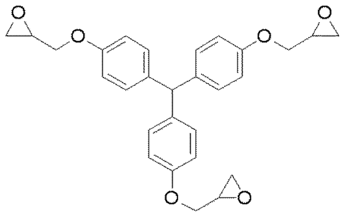

(F-12)

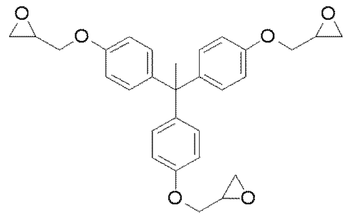

(F-13)

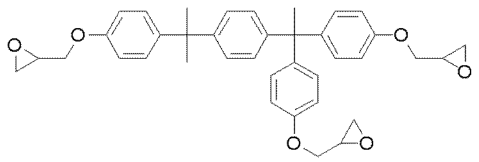

(F-14)

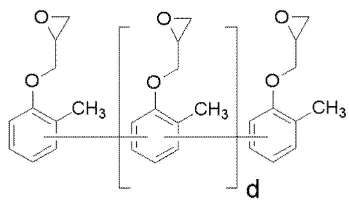

(F-15)

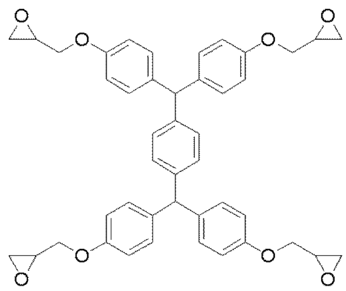

In the formulae, "d" satisfies $2 \leq d \leq 3$.

Furthermore, preferable examples of compounds other than those of the formulae (F-9) to (F-15) include EPICLON 850-S, EPICLON HP-4032, EPICLON HP-7200, EPICLON HP-820, EPICLON HP-4700, EPICLON EXA-4710, EPICLON HP-4770, EPICLON EXA-859CRP, EPICLON EXA-4880, EPICLON EXA-4850, EPICLON EXA-4816, EPICLON EXA-4822 (all trade names, manufactured by DIC Corporation), RIKARESIN BPO-20E, RIKARESIN BEO-60E (both trade names, manufactured by New Japan Chemical Co., Ltd.), EP-4003S, EP-4000S, EP-4000S, EP-4000L (all trade names, manufactured by ADEKA CORPORATION), jER828EL, YX7105 (both trade names, manufactured by Mitsubishi Chemical Group Corporation), etc.

One kind or two kinds of the compounds obtained by substituting a hydroxy group of the polyhydric phenol with a glycidoxy group (a compound in which a hydrogen atom of a hydroxy group of polyhydric phenol is substituted with a glycidyl group) may be used as a crosslinking agent.

Examples of the compound in which a hydrogen atom of a hydroxy group of polyhydric phenol is substituted with a substituent represented by the following formula (F-1) include ones containing two or more of the substituents and represented by the following formula (F-16).

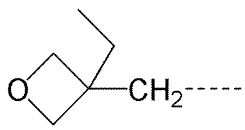 (F-1)

In the formula, a dotted line represents an attachment point.

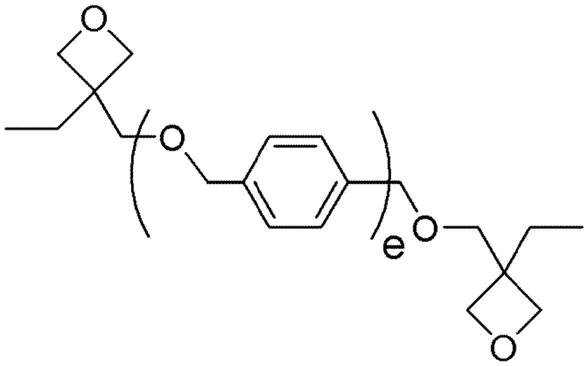

(F-16)

In the formula, "e" satisfies $1 \leq e \leq 3$.

Furthermore, preferable examples of compounds other than those of the formulae (F-9) to (F-15) include 3-ethyl-3-hydroxymethyloxetane, 1,4-bis{[(3-ethyl-3-oxethanyl)methoxy]methyl}benzene, 3-ethyl-3-(2-ethylhexylmethyl) oxetane, 1,4-benzendicarboxylic acid bis[(3-ethyl-3-oxetanyl)methyl] ester, ARON OXETANE series manufactured by TOAGOSEI CO., LTD., etc.

Meanwhile, examples of the compound containing two or more nitrogen atoms having a glycidyl group represented by the following formulae (F-2) include ones represented by the following formula (F-17).

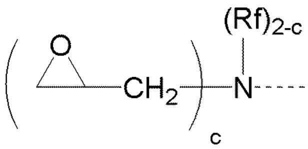

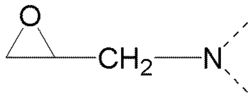

(F-2)

In the formulae, a dotted line represents an attachment point, Rf represents a linear, branched, or cyclic alkyl group having 1 to 6 carbon atoms, and "c" represents 1 or 2.

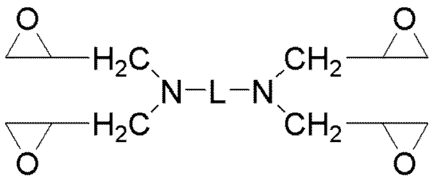

(F-17)

In the formula, L represents a linear, branched, or cyclic alkylene group having 2 to 12 carbon atoms or a divalent aromatic group.

Examples of the compounds represented by the formula (F-17) include compounds represented by the following formulae (F-18) to (F-21).

(F-18)

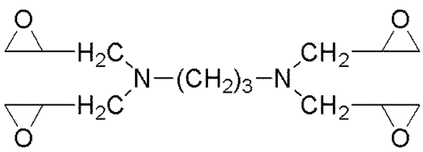

(F-19)

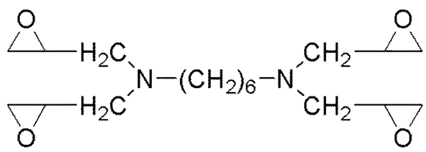

(F-20)

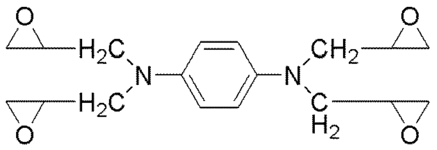

(F-21)

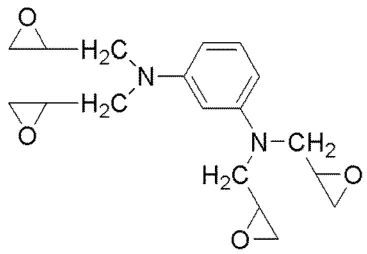

Meanwhile, as the compound containing two or more nitrogen atoms each of which has a glycidyl group(s) represented by the formula (F-2), compounds represented by the following formulae (F-22) and (F-23) may be suitably used.

(F-22)

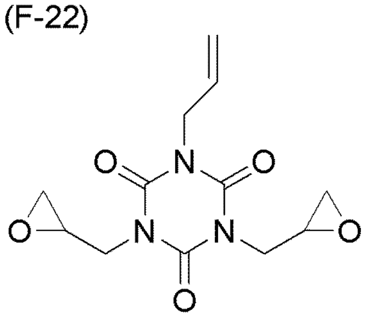

(F-23)

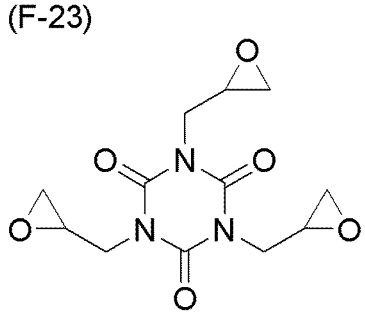

One kind or two kinds of these compounds containing two or more nitrogen atoms each of which has a glycidyl group(s) represented by the formula (F-2) may be used as a crosslinking agent.

An epoxy group is greatly distorted in the ring and has high reactivity, and oxetane has high basicity and easily bonds with an acid. It is reported that by combining oxetanyl groups with epoxy groups, the reactivity in cation polymerization improves remarkably.

The component (F) is a component that causes a crosslinking reaction in the post-curing after forming a pattern of the inventive negative photosensitive resin composition to further increase the strength of a cured product. A weight-average molecular weight of such a component (F) is preferably 150 to 10,000, and particularly preferably 200 to 3,000, from the viewpoint of the photocurability and heat resistance.

In the inventive negative photosensitive resin composition, the amount of the component (F) to be contained is preferably 0.5 to 100 parts by mass, particularly preferably 1 to 80 parts by mass relative to 100 parts by mass of the component (A).

The inventive negative photosensitive resin composition preferably further contains (G) an antioxidant. By the component (G) antioxidant being contained, it is possible to suppress unnecessary crosslinking among the component (A) or between the components (A) and (B) at the time of patterning, and contrast can be enhanced. In addition, by an anticorrosive effect to metal materials, it is possible to suppress oxidation of metal by water from outside, a photo-acid generator, a thermal acid generator, etc. and accompanying adhesion degradation and delamination.

[Component (G)]

Specific examples of antioxidants (G) that can be used here include hindered phenol-based antioxidants, phosphorus-based antioxidants, and sulfur-based antioxidants as preferable examples. However, the antioxidant is not limited thereto. Moreover, one of these antioxidants (G) can be used or two or more thereof can be used in combination.

Furthermore, out of the above-described specific examples of antioxidants (G), examples of the hindered phenol-based antioxidants include pentaerythritol tetrakis[3-(3,5-di-tert-butyl-4-hydroxyphenyl)propionate] (Irganox 1010 (trade name), manufactured by BASF Japan Ltd.), thiodiethylenebis[3-(3,5-di-tert-butyl-4-hydroxyphenyl)propionate] (Irganox 1035 (trade name), manufactured by BASF Japan Ltd.), octadecyl[3-(3,5-di-tert-butyl-4-hydroxyphenyl) propionate] (Irganox 1076 (trade name), manufactured by BASF Japan Ltd.), octyl-1-3,5-di-tert-butyl-4-hydroxy-hydrocinnamic acid (Irganox 1135 (trade name), manufactured by BASF Japan Ltd.), 4,6-bis(octylthiomethyl-o-cresol) (Irganox 1520L, manufactured by BASF Japan Ltd.), Sumilizer GA80 (trade name, manufactured by Sumitomo Chemical Co., Ltd.), Adekastab AO-20 (trade name, manufactured by ADEKA CORPORATION), Adekastab AO-30 (trade name, manufactured by ADEKA CORPORATION), Adekastab AO-40 (trade name, manufactured by ADEKA CORPORATION), Adekastab AO-50 (trade name, manufactured by ADEKA CORPORATION), Adekastab AO-60 (trade name, manufactured by ADEKA CORPORATION), Adekastab AO-80 (trade name, manufactured by ADEKA CORPORATION), Adekastab AO-330 (trade name, manufactured by ADEKA CORPORATION), hindered phenol-based antioxidants disclosed in WO 2017/188153 A1, and the like.

Furthermore, out of the above-described specific examples of antioxidants (G), examples of the phosphorus-based antioxidants include triphenyl phosphite, tris(methylphenyl) phosphite, triisooctyl phosphite, tridecyl phosphite, tris(2-ethylhexyl) phosphite, tris(nonylphenyl) phosphite, tris(octylphenyl) phosphite, tris[decylpoly(oxyethylene) phosphite, tris(cyclohexylphenyl) phosphite, tricyclohexyl phosphite, tri(decyl)thio phosphite, triisodecylthio phosphite, phenyl-bis(2-ethylhexyl) phosphite, phenyl-diisodecyl phosphite, tetradecylpoly(oxyethylene)-bis(ethylphenyl) phosphite, phenyl-dicyclohexyl phosphite, phenyl-diisooctyl phosphite, phenyl-di(tridecyl) phosphite, diphenyl-cyclohexyl phosphite, diphenyl-isooctyl phosphite, diphenyl-2-ethylhexyl phosphite, diphenyl-isodecyl phosphite, diphenyl-cyclohexylphenyl phosphite, diphenyl-(tridecyl)thio phosphite, and the like.

Furthermore, out of the above-described specific examples of antioxidants (G), examples of the sulfur-based antioxidants include Adekastab AO-412S (trade name, manufactured by ADEKA CORPORATION), AO-503S (trade name, manufactured by ADEKA CORPORATION), Sumilizer TP-D (trade name, manufactured by Sumitomo Chemical Co., Ltd.), and the like.

Sulfur-based antioxidants and phosphorus-based antioxidants can be expected to have an effect of decomposing peroxides.

The contained amount of the antioxidant (G) is preferably 0.1 to 10 parts by mass, more preferably 0.2 to 5 parts by mass relative to 100 parts by mass of the component (A) polymer. When the contained amount is 0.1 parts by mass or more, adhesiveness to metal materials is enhanced, while at the same time, delamination is suppressed. Meanwhile, when the contained amount is 10 parts by mass or less, the developing properties of the composition and the toughness of the cured film are not degraded.

[Component (H)]

The inventive negative photosensitive resin composition preferably further contains a silane compound (H). The inventive negative photosensitive resin composition preferably contains a metal adhesion improver for enhancing adhesion to metal materials used for electrodes, wiring, etc., and examples of the metal adhesion improver include a silane compound.

Examples of the silane compound include the compounds disclosed in paragraph 0167 of WO 2015-199219 A1, the compounds disclosed in paragraphs 0062 to 0073 of JP 2014-191002 A, the compounds disclosed in paragraphs 0063 to 0071 of WO 2011-080992 A1, the compounds disclosed in paragraphs 0060 and 0061 of JP 2014-191252 A, the compounds disclosed in paragraphs 0045 to 0052 of JP 2014-041264 A, and the compounds disclosed in paragraph 0055 of WO 2014-097594 A1. Furthermore, as disclosed in paragraphs 0050 to 0058 of JP 2011-128358 A, it is also desirable to use two or more different kinds of silane coupling agents.

A silane compound (H) usable here is not particularly limited, but preferably has an alkoxysilyl group. Suitable, specific examples include the following: γ-glycidoxypropyltriethoxysilane, γ-glycidoxypropyltrimethoxysilane, 2-(3,4-epoxycyclohexyl)ethyltrimethoxysilane, bis(2-hydroxyethyl)-3-aminopropyl-triethoxysilane, γ-aminopropyltrimethoxysilane, γ-aminopropyltriethoxysilane, vinyltriethoxysilane, vinyltrimethoxysilane, γ-methacryloxypropyltrimethoxysilane, γ-acryloxypropyltrimethoxysilane, 3-mercaptopropyltrimethoxysilane, 3-isocyanatepropyltriethoxysilane, bis(2-hydroxyethyl)-3-aminopropyltriethoxysilane, triethoxysilylpropylethyl carbamate, 3-(triethoxysilyl)propyl succinic anhydride, phenyltriethoxysilane, phenyltrimethoxysilane, N-phenyl-3-aminopropyltrimethoxysilane, 3-triethoxysilyl-N-(1,3-dimethylbutylidene)propylamine, amide group-containing silane compounds disclosed in JP 6414060 B, thiourea group-containing silane compounds disclosed in WO 2016/140024 A1 and JP 5987984 B, thiol group-containing silane compounds disclosed in JP 2017-044964 A, and the like. However, the silane compound is not limited thereto. Furthermore, one of these silane compounds (H) can be used or a combination of two or more thereof can be used.

As the silane coupling agent, it is also desirable to use the compounds represented by the following formulae (H-1) to (H-7).

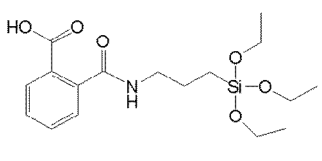

( H-1 )

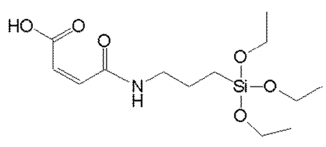

( H-2 )

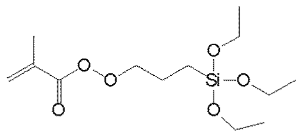

( H-3 )

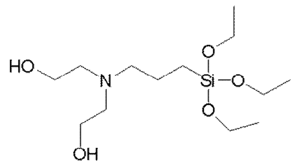

( H-4 )

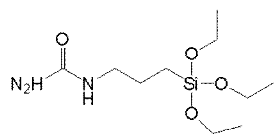

( H-5 )

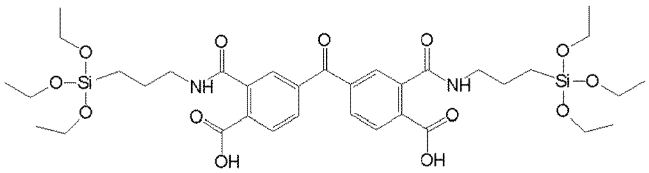

( H-6 )

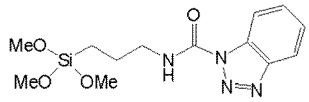

( H-7 )

The silane compound (H),contained in an amount of 0.1 to 30 parts by mass, more preferably 0.5 to 15 parts by mass, and further preferably 0.5 to 5 parts by mass based on 100 parts by mass of the polymer having the structural unit of the polyimide precursor contained in the inventive negative photosensitive resin composition. When the amount is the lower limit or more, the adhesion between the cured film and the metal layer after a curing process is excellent, and when the amount is the upper limit or less, the heat resistance and mechanical characteristics of the cured film after a curing process is excellent. The silane compound (H), being the metal adhesion improver, may be of only one kind, or two or more kinds. When two or more kinds are used it is preferable that the total amount is in the above range.

[Component (I)]

In the present invention, a polymerization inhibitor (I) is preferably further contained. As the polymerization inhibitor (I), a thermal polymerization inhibitor can be contained to enhance the stability of the viscosity and the photosensitivity of the composition solution during storage. As the thermal polymerization inhibitor, a known thermal polymerization inhibitor can be used in accordance with the purpose of the present invention. Examples include hydroquinone, N-nitrosodiphenylamine, p-tert-butylcatechol, phenothiazine, N-phenylnaphthylamine, ethylenediaminetetraacetic acid, 1,2-cyclohexanediaminetetraacetic acid, glycol ether diamine tetraacetic acid, 2,6-di-tert-butyl-p-methylphenol, 5-nitroso-8-hydroxyquinoline, 1-nitroso-2-naphthol, 2-nitroso-1-naphthol, 2-nitroso-5-(N-ethyl-N-sulfopropylamino)phenol, N-nitroso-N-phenylhydroxylamine ammonium salt, and N-nitroso-N(1-naphthyl)hydroxylamine ammonium salt. The amount of the polymerization inhibitor (I) to be contained in the inventive negative photosensitive resin composition is preferably 0.005 to 5 parts by weight based on 100 parts by mass of the polymer having the structural unit of the polyimide precursor contained in the inventive negative photosensitive resin composition.

[Others]

The inventive negative photosensitive resin composition may further contain components other than the polymer having a polyimide precursor structure (A), the photopolymerization initiator (C), and the nitrogen-containing organic compound (D) represented by the general formula (1). Examples of other components include (J) a sensitizer, (K) a migration inhibitor, and (L) a surfactant.
Examples of the sensitizer (J) include Michler's ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylideneindanone, p-dimethylaminobenzylideneindanone, 2-(p-dimethylaminophenylbiphenylene)-benzothiazole, 2-(p-dimethylaminophenylvinylene)benzothiazole, 2-(p-dimethylaminophenylvinylene)isonaphthothiazole, 1,3-bis(4'-dimethylaminobenzal) acetone, 1,3-bis(4'-diethylaminobenzal)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin, N-phenyl-N'-ethylethanolamine, N-phenyldiethanolamine, N-p-tolyldiethanolamine, N-phenylethanolamine, 4-morpholinobenzophenone, isoamyl dimethylaminobenzoate, isoamyl diethylaminobenzoate, 2-mercaptobenzimidazole, 1-phenyl-5-mercaptotetrazole, 2-mercaptobenzothiazole, 2-(p-dimethylaminostyryl)benzoxazole, 2-(p-dimethylaminostyryl)benzthiazole, 2-(p-dimethylaminostyryl)naphtho(1,2-d)thiazole, 2-(p-dimethylaminobenzoyl)styrene, etc. One of these may be used, or for example, a combination of 2 to 5 kinds thereof may be used.

The amount of the sensitizer (J) to be contained is preferably 0.05 to 20 parts by mass, more preferably 0.1 to 10 parts by mass based on 100 parts by mass of the component (A) polymer.

The inventive negative photosensitive resin composition preferably further contains (K) a migration inhibitor. When a migration inhibitor is contained, it is possible effectively to suppress the migration of metal ions derived from a metal layer (metal wiring) to a curable resin composition layer.

The migration inhibitor (K) is not particularly limited, and examples thereof include compounds having a heterocycle (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring, a 6H-pyran ring, or a triazine ring), compounds having a thiourea and a sulfanyl group, hindered phenol-based compounds, salicylic acid derivative-based compounds, and hydrazide derivative-based compounds. In particular, triazole-based compounds, such as 1,2,4-triazole and benzotriazole and tetrazole-based compounds, such as 1H-tetrazole and 5-phenyltetrazole, can be favorably used.

As the migration inhibitor (K), it is also possible to use an ion-trapping agent for trapping anions, such as halogen ions.

As other migration inhibitors, it is possible to use the corrosion inhibitor disclosed in paragraph 0094 of JP 2013-015701 A, the compounds disclosed in paragraphs 0073 to 0076 of JP 2009-283711 A, the compounds disclosed in paragraph 0052 of JP 2011-059656 A, the compounds disclosed in paragraphs 0114, 0116, and 0118 of JP 2012-194520 A, the compounds disclosed in paragraph 0166 of WO 2015/199219 A1, etc.

Specific examples of the migration inhibitor include the following compounds.

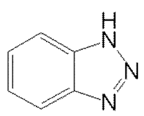
( K-1 )

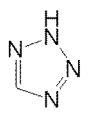
( K-2 )

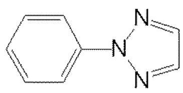
( K-3 )

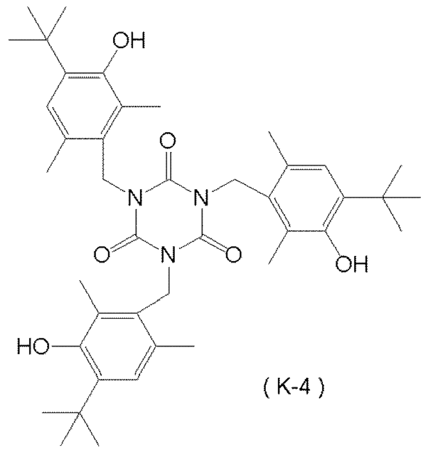
( K-4 )

When the inventive negative photosensitive resin composition contains a migration inhibitor, the migration inhibitor is preferably contained in an amount of 0.01 to 5.0 mass%, more preferably 0.05 to 2.0 mass%, and further preferably 0.1 to 1.0 mass% based on 100 parts by mass of the polymer having the structural unit of the polyimide precursor contained in the inventive negative photosensitive resin composition.

The migration inhibitor may be of only one kind, or two or more kinds. When the migration inhibitor is of two or more kinds, it is preferable that the total amount is in the above range.

As the surfactant (L), a nonionic surfactant is preferable. Examples include fluorine-based surfactants, and specific examples include perfluoroalkyl polyoxyethylene ethanol, fluorinated alkyl ester, perfluoroalkyl amine oxide, and fluorine-containing organosiloxane-based compounds.

As these surfactants, commercially available products can be used. Examples thereof include Fluorad "FC-4430" (manufactured by Sumitomo 3M Limited), Surflon "S-141" and "S-145" (both manufactured by ASAHI GLASS CO., LTD.), UNIDYNE "DS-401", "DS-4031", and "DS-451" (all manufactured by DAIKIN INDUSTRIES, LTD.), Megafac "F-8151" (manufactured by DIC Corporation), and "X-70-093" (manufactured by Shin-Etsu Chemical Co., Ltd.). Among these, preferred are Fluorad "FC-4430" (manufactured by Sumitomo 3M Limited) and "X-70-093" (manufactured by Shin-Etsu Chemical Co., Ltd.).

The amount of the surfactant (L) to be contained is preferably 0.01 to 0.05 parts by mass based on 100 parts by mass of the component (A) polymer. When the amount is in such a range, there is an advantage that coatability on a substrate can be improved without degradation of patterning properties or properties of the cured film.

[Patterning Process]

Next, patterning processes using the inventive negative photosensitive resin composition will be described.

The present invention provides a patterning process including the steps of:

(1) applying any of the above-described negative photosensitive resin compositions onto a substrate to form a photosensitive material film;
(2) subsequently performing heat treatment and then exposure of the photosensitive material film with a high-energy beam having a wavelength of 190 to 500 nm or an electron beam through a photomask; and
(3) after the exposure, performing development using a developing solution of an organic solvent.

The patterning may be performed using the inventive negative photosensitive resin composition and by employing a known lithography technology. For example, a silicon wafer, an $SiO_2$ substrate, an SiN substrate, or a substrate on which a pattern of copper wiring or the like has been formed is coated with the negative photosensitive resin composition by a spin coating technique and pre-baked under conditions of about 80 to 130°C for about 50 to 600 seconds to form a resist film with a thickness of 1 to 50 μm, preferably 1 to 30 μm, further preferably 5 to 20 μm. Then, a mask for forming the target pattern is put on the resist film, and exposure is performed with a high-energy beam, such as i-line and g-line, having a wavelength of 190 to 500 nm with an exposure value of approximately 1 to 5,000 mJ/$cm^2$, preferably approximately 100 to 2,000 mJ/$cm^2$.

After that, development is performed. For the above-described inventive negative photosensitive resin composition, development with an organic solvent is suitable. As a suitable organic solvent usable for the development with the organic solvent, it is possible to use a solvent given above used for the preparation of the inventive photosensitive resin composition. Preferable examples include ketones, such as cyclohexanone and cyclopentanone, and furthermore, glycols, such as propylene glycol monomethyl ether. The development can be carried out by normal methods such as spray method and paddle method, or by dipping the film in a developing solution, for example. Thereafter, by carrying out washing, rinsing, drying, and the like, as necessary, a resist film having a desired pattern can be obtained.

The obtained patterned film is post-cured at a temperature of 100 to 300°C, preferably 150 to 300°C, and further preferably 180 to 250°C by using an oven or a hot plate. When the post-curing temperature is 100 to 300°C, the crosslinking density of the film of the photosensitive resin composition can be increased and the remaining volatile components can be removed. The post-curing temperature is preferable from the viewpoints of adhesiveness to the substrate, heat resistance and strength, as well as electrical properties. The post-curing time can be 10 minutes to 10 hours.

The cured film thus obtained is excellent in adhesiveness to a substrate, heat resistance, electrical properties, mechanical strength and chemical resistance. A semiconductor device using the cured film as a protective film is also excellent in reliability. In particular, the cured film can prevent cracking upon a temperature cycle test. Therefore, the cured film is suitably used as a protective film for electrical and electronic components, semiconductor devices, etc.

Thus, the present invention provides an interlayer insulating film or a surface protective film including a cured film obtained by curing the above-described negative photosensitive resin composition.

The protective films are effective for applications as an insulating film for semiconductor devices including a rewiring application, an insulating film for multilayer printed circuit board, a solder mask, a coverlay film, and so forth, because the protective films have the heat resistance, chemical resistance, and insulating property.

Furthermore, the present invention provides an electronic component having the interlayer insulating film or surface protective film described above.

Such an electronic component has a protective film (interlayer insulating film or surface protective film) with heat resistance, chemical resistance, and insulating property, and is thus excellent in reliability.

## EXAMPLES

Hereinafter, the present invention will be described specifically with reference to Synthesis Examples, Comparative Synthesis Examples, Examples, and Comparative Examples, but the present invention is not limited by the following Examples.

### I. Synthesis of Polymers

Chemical structural formulae and names of the compounds used in the following Synthesis Examples of polymers used for the inventive negative photosensitive resin composition are shown below.

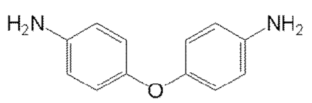

ODA

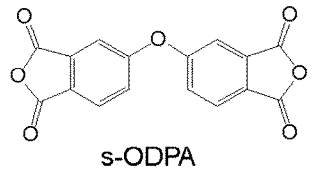

s-ODPA

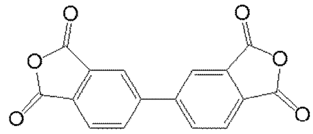

s-BPDA

ODA 4,4'-diaminodiphenyl ether
s-ODPA 3,3',4,4'-oxydiphthalic dianhydride
s-BPDA 3,3',4,4'-biphenyltetracarboxylic dianhydride

[Synthesis Example 1] Synthesis of Tetracarboxylic Acid Diester Compound (X-1)

Into a 3-L flask provided with a stirrer and a thermometer, 100 g (322 mmol) of 3,3',4,4'-oxydiphthalic dianhydride (s-ODPA), 65.2 g (644 mmol) of triethylamine, 39.3 g (322 mmol) of N,N-dimethyl-4-aminopyridine, and 400 g of γ-butyrolactone were added, under stirring at room temperature, 83.8 g (644 mmol) of hydroxyethylmethacrylate (HEMA) was dropped thereto, followed by stirring for 24 hours under room temperature. After that, 370 g of a 10% aqueous solution of hydrochloric acid was dropped in under ice cooling to terminate the reaction. To the reaction liquid, 800 g of 4-methyl-2-pentanone was added to sample an organic layer, followed by washing 6 times with 600 g of water. A solvent of the obtained organic layer was distilled off and 180 g of a tetracarboxylic acid diester compound (X-1) of the following structure was obtained.

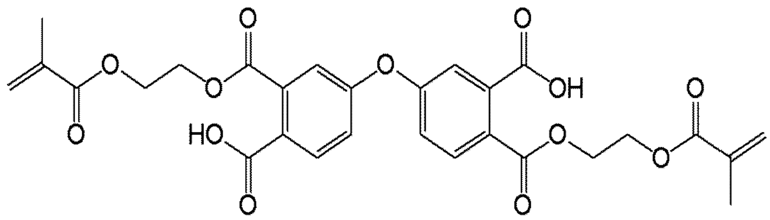

(X-1)

[Synthesis Example 2] Synthesis of Tetracarboxylic Acid Diester Compound (X-2)

According to Synthesis Example 1, 172 g of a tetracarboxylic acid diester compound (X-2) of the following structure was obtained in the same manner except that the 3,3',4,4'-oxydiphthalic dianhydride (s-ODPA) was changed to 94.8 g (322 mmol) of 3,3',4,4'-biphthalic dianhydride (s-BPDA).

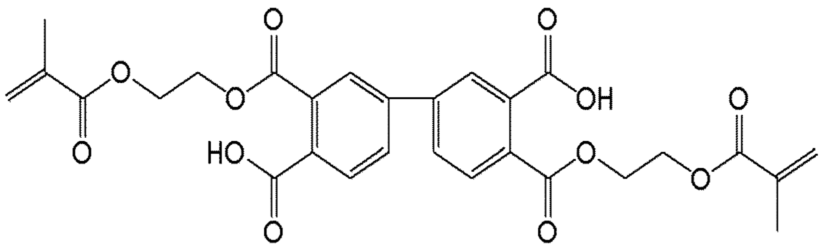

(X-2)

[Synthesis Example 3] Synthesis of Polyimide Precursor (A-1)

Into a 1-L flask provided with a stirrer and a thermometer, 44.0 g (77.1 mmol) of X-1 and 176 g of N-methyl-2-pyrrolidone were added, followed by dissolving by stirring at room temperature. Next, under ice cooling, 18.8 g (158.1 mmol) of thionyl chloride was dropped thereto so as to keep the reaction solution temperature to 10°C or lower. After completion of the dropping, the solution was stirred under ice cooling for 2 hours. Subsequently, a solution obtained by dissolving 14.4 g (71.7 mmol) of 4,4'-diaminodiphenyl ether (ODA) and 25.0 g (316.2 mmol) of pyridine with 70 g of N-methyl-2-pyrrolidone was dropped thereto under ice cooling so as to keep the reaction solution temperature to 10°C or lower. After completion of the dropping, the temperature was restored to room temperature, and the reaction liquid was dropped into 3 L of water under stirring. A precipitate was collected by filtration to be washed appropriately with water, followed by drying under reduced pressure at 40°C for 48 hours. Thus, a polyimide precursor (A-1) was obtained. The

molecular weight of the polymer was measured by GPC using DMF as an eluent under the condition of the temperature of 40°C. The weight-average molecular weight was 24,000 in terms of polystyrene.

[Synthesis Example 4] Synthesis of Polyimide Precursor (A-2)

Except that the (X-1) indicated in Synthesis Example 3 was changed to 42.8 g (77.1 mmol) of (X-2), a polyimide precursor (A-2) was obtained in the same manner. The molecular weight of the polymer was measured by GPC using DMF as an eluent under the condition of the temperature of 40°C. The weight-average molecular weight was 23,000 in terms of polystyrene.

II. Nitrogen-Containing Compounds

The compounds used in the Synthesis Examples of the nitrogen-containing organic compounds used for the inventive negative photosensitive resin compositions are shown below.

(D-1) imidazole
(D-2) benzimidazole
(D-3) 2-phenylbenzimidazole
(D-4) pyrazole
(D-5) indazole
(D-6) 1H-1,2,3-triazole
(D-7) 1,2,3-benzotriazole
(D-8) 1,2,4-triazole
(D-9) 3-nitro-1,2,4-triazole
(D-10) 1H-tetrazole
(D-11) 2,6-dimethylpiperidine

[Synthesis Example 5] Synthesis of 1-(Tert-Butoxycarbonyl)Benzimidazole (D-2-1)

In a 300-ml flask provided with a reflux condenser, a stirrer, and a thermometer, 62 mg (0.51 mol) of 4-(N,N-dimethylamino)pyridine and 6.55 g (30.0 mmol) of di-tert-butyldicarbonate were added to a solution of 2.95 g (25.0 mmol) of benzimidazole (D-2) in 100 mL of acetonitrile, the solution having been stirred in nitrogen at 25°C. After that, the mixture was stirred at 25°C for 12 hours. After completion of the reaction, the reaction solution was introduced into 200 mL of cool water, and the organic layer was extracted using 30 mL of ethyl acetate three times. The organic layer was further washed three times with 50 mL of cool water, the organic layer was dried with magnesium sulfate and then concentrated under reduced pressure, and crystallization was performed using petroleum ether to obtain 1-(tert-butoxycarbonyl)benzimidazole (D-2-1), having the following structure. (4.37 g, yield: 80.0%)

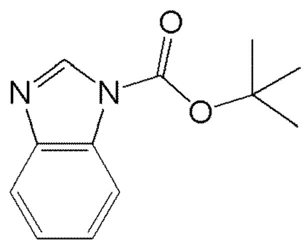

(D-2-1) 1-(tert-butoxycarbonyl)benzimidazole

[Synthesis Example 6] Synthesis of 1-(Tert-Butoxycarbonyl)-2-Phenylbenzimidazole (D-3-1)

The benzimidazole (D-2) in Synthesis Example 5 was changed to 4.86 g of 2-phenylbenzimidazole (D-3), and a reaction was performed in the same manner to obtain N-(tert-butoxycarbonyl)-2-phenylbenzimidazole (D-3-1), having the following structure. (4.71 g, yield: 64.0%)

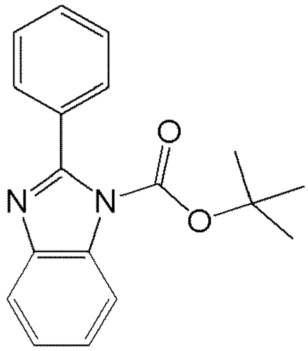

(D-3-1)1-(tert-butoxycarbonyl)-2-phenylbenzimidazole

[Synthesis Example 7] Synthesis of 1-(Tert-Butoxycarbonyl)-Pyrazole (D-4-1)

The benzimidazole (D-2) of Synthesis Example 5 was changed to 1.70 g of pyrazole (D-4), and a reaction was performed in the same manner to obtain 1-(tert-butoxycarbonyl)-pyrazole (D-4-1), having the following structure. (3.58 g, yield: 85.1%)

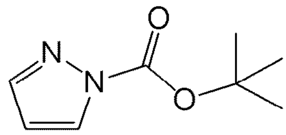

(D-4-1)1-(tert-butoxycarbonyl)-pyrazole

[Synthesis Example 8] Synthesis of 1-(Tert-Butoxycarbonyl)-Indazole (D-5-1)

The benzimidazole (D-2) in Synthesis Example 5 was changed to 2.95 g of indazole (D-5), and a reaction was performed in the same manner to obtain 1-(tert-butoxycarbonyl)-indazole (D-5-1), having the following structure. (3.94 g, yield: 72.2%)

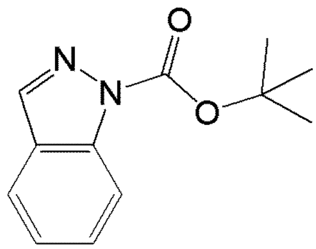

(D-5-1)1-(tert-butoxycarbonyl)-indazole

[Synthesis Example 9] Synthesis of 1-(Tert-Butoxycarbonyl)-1H-1,2,3-Triazole (D-6-1)

The benzimidazole (D-2) in Synthesis Example 5 was changed to 1.73 g of 1H-1,2,3-triazole (D-6), and a reaction was performed in the same manner to obtain 1-(tert-butoxycarbonyl)-1H-1,2,3-triazole (D-6-1), having the following structure. (3.33 g, yield: 78.8%)

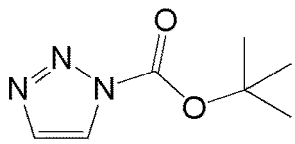

(D-6-1)1-(tert-butoxycarbonyl)-1H-1,2,3-triazole

[Synthesis Example 10] Synthesis of 1-(Tert-Butoxycarbonyl)-1H-1,2,3-Benzotriazole (D-7-1)

The benzimidazole (D-2) in Synthesis Example 5 was changed to 2.98 g of 1,2,3-benzotriazole (D-7), and a reaction was performed in the same manner to obtain 1-(tert-butoxycarbonyl)-1H-1,2,3-benzotriazole (D-7-1), having the following structure. (3.23 g, yield: 58.9%)

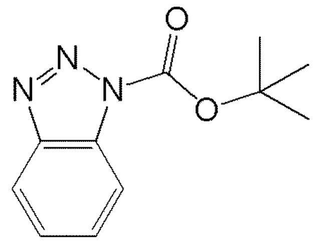

(D-7-1)1-(tert-butoxycarbonyl)-1H-1,2,3-benzotriazole

[Synthesis Example 11] Synthesis of 1-(Tert-Butoxycarbonyl)-3-Nitro-1,2,4-Triazole (D-9-1)

The benzimidazole (D-2) in Synthesis Example 5 was changed to 2.85 g of 3-nitro-1,2,4-triazole (D-9), and a reaction was performed in the same manner to obtain 1-(tert-butoxycarbonyl)-3-nitro-1,2,4-triazole (D-9-1), having the following structure. (3.88 g, yield: 72.8%)

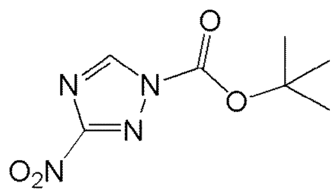

(D-9-1)1-(tert-butoxycarbonyl)-3-nitro-1,2,4-triazole

[Synthesis Example 12] Synthesis of 1-(Tert-Butoxycarbonyl)-1H-Tetrazole (D-10-1)

The benzimidazole (D-2) in Synthesis Example 5 was changed to 1.75 g of 1H-tetrazole (D-10), and a reaction was performed in the same manner to obtain 1-(tert-butoxycarbonyl)-1H-tetrazole (D-10-1), having the following structure. (2.80 g, yield: 65.8%)

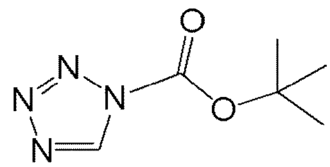

(D-10-1) 1-(tert-butoxycarbonyl)-1H-tetrazole

[Synthesis Example 13] Synthesis of N-(Tert-Butoxycarbonyl)-2,6-Dimethylpiperidine (D-11-1)

The benzimidazole (D-2) in Synthesis Example 5 was changed to 2.83 g of 2,6-dimethylpiperidine (D-11), a reaction was performed in the same manner, and the process was halted at the concentration under reduced pressure in Synthesis Example 5 to obtain an oily product of N-(tert-butoxycarbonyl)-2,6-dimethylpiperidine (D-11-1), having the following structure. (4.95 g, yield: 80.1%)

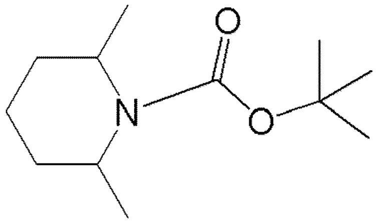

(D-11-1) N-(tert-butoxycarbonyl)-2,6-dimethylpiperidine

[Synthesis Example 14] Synthesis of 1-(Benzyloxycarbonyl)-Imidazole (D-1-2)

In a 300-ml flask provided with a reflux condenser, a stirrer, and a thermometer, 4.26 g (25.0 mmol) of benzyl chlorocarbonate was added dropwise to a mixed solution of 3.40 g (50.0 mmol) of imidazole (D-1) and 70 g of tetrahydrofuran at 0°C, and then, the mixture was stirred at 50°C for 20 hours. After completion of the reaction, the reaction solution was introduced into 200 mL of cool water, and the organic layer was extracted using 30 mL of ethyl acetate three times. The organic layer was further washed three times with 50 mL of cool water, the organic layer was dried with magnesium sulfate and then concentrated under reduced pressure, and crystallization was performed using petroleum ether to obtain 1-(benzyloxycarbonyl)-imidazole (D-1-2), having the following structure. (3.85 g, yield: 76.2%)

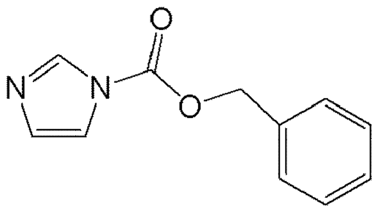

(D-1-2) 1-(benzyloxycarbonyl)-imidazole

[Synthesis Example 15] Synthesis of 1-(Benzyloxycarbonyl)-Benzimidazole (D-2-2)

The imidazole (D-1) in Synthesis Example 14 was changed to 5.91 g of benzimidazole (D-2), and a reaction was performed in the same manner to obtain 1-(benzyloxycarbonyl)-benzimidazole (D-2-2), having the following structure. (4.16 g, yield: 65.9%)

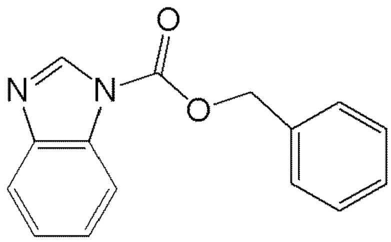

(D-2-2) 1-(benzyloxycarbonyl)-benzimidazole

[Synthesis Example 16] Synthesis of 1-(Benzyloxycarbonyl)-2-Phenylbenzimidazole (D-3-2)

The imidazole (D-1) in Synthesis Example 14 was changed to 9.71 g of 2-phenylbenzimidazole (D-3), and a reaction was performed in the same manner to obtain 1-(benzyloxycarbonyl)-2-phenylbenzimidazole (D-3-2), having the following structure. (4.98 g, yield: 60.7%)

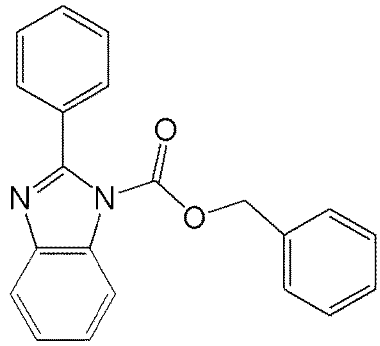

(D-3-2) 1-(benzyloxycarbonyl)-2-phenylbenzimidazole

[Synthesis Example 17] Synthesis of 1-(Benzyloxycarbonyl)-Pyrazole (D-4-2)

The imidazole (D-1) in Synthesis Example 14 was changed to 3.40 g of pyrazole (D-4), and a reaction was performed in the same manner to obtain 1-(benzyloxycarbonyl)-pyrazole (D-4-2), having the following structure. (3.14 g, yield: 62.2%)

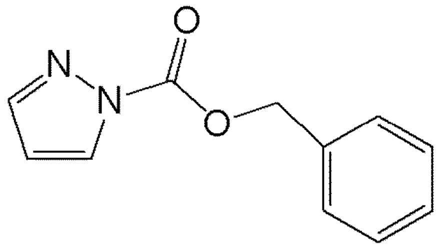

(D-4-2)1-(benzyloxycarbonyl)-pyrazole (D-4-2)

[Synthesis Example 18] Synthesis of 1-(Benzyloxycarbonyl)-Indazole (D-5-2)

The imidazole (D-1) in Synthesis Example 14 was changed to 5.91 g of indazole (D-5), and a reaction was performed in the same manner to obtain 1-(benzyloxycarbonyl)-indazole (D-5-2), having the following structure. (3.99 g, yield: 63.2%)

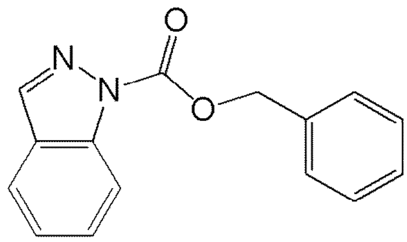

(D-5-2)1-(benzyloxycarbonyl)-indazole

[Synthesis Example 19] Synthesis of 1-(Benzyloxycarbonyl)-1H-1,2,3-Triazole (D-6-2)

The imidazole (D-1) in Synthesis Example 14 was changed to 3.45 g of 1H-1,2,3-triazole (D-6), and a reaction was performed in the same manner to obtain 1-(benzyloxycarbonyl)-1H-1,2,3-triazole (D-6-2), having the following structure. (3.04 g, yield: 63.2%)

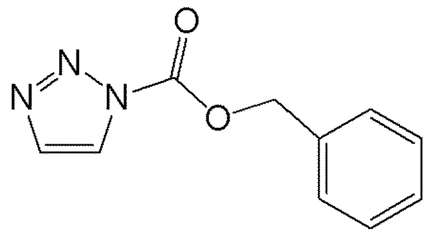

(D-6-2)1-(benzyloxycarbonyl)-1H-1,2,3-triazole

[Synthesis Example 20] Synthesis of 1-(Benzyloxycarbonyl)-1H-1,2,3-Benzotriazole (D-7-2)

The imidazole (D-1) in Synthesis Example 14 was changed to 5.96 g of 1,2,3-benzotriazole (D-7), and a reaction was performed in the same manner to obtain 1-(benzyloxycarbonyl)-1H-1,2,3-benzotriazole (D-7-2), having the following structure. (3.79 g, yield: 59.8%)

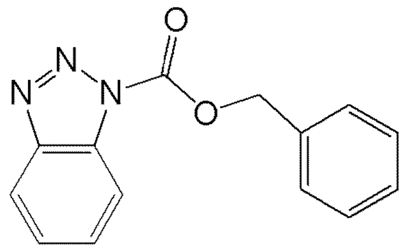

(D-7-2)1-(benzyloxycarbonyl)-1H-1,2,3-benzotriazole

[Synthesis Example 21] Synthesis of 1-(Benzyloxycarbonyl)-1H-1,2,4-Triazole (D-8-2)

The imidazole (D-1) in Synthesis Example 14 was changed to 3.45 g of 1,2,4-triazole (D-8), and a reaction was performed in the same manner to obtain 1-(benzyloxycarbonyl)-1H-1,2,4-triazole (D-8-2), having the following structure. (3.17 g, yield: 62.4%)

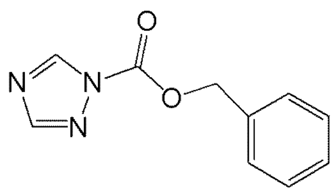

(D-8-2)1-(benzyloxycarbonyl)-1H-1,2,4-triazole

[Synthesis Example 22] Synthesis of 1-(Benzyloxycarbonyl)-3-Nitro-1,2,4-Triazole (D-9-2)

The imidazole (D-1) in Synthesis Example 14 was changed to 5.70 g of 3-nitro-1,2,4-triazole (D-9), and a reaction was performed in the same manner to obtain 1-(benzyloxycarbonyl)-3-nitro-1,2,4-triazole (D-9-2), having the following structure. (3.38 g, yield: 54.4%)

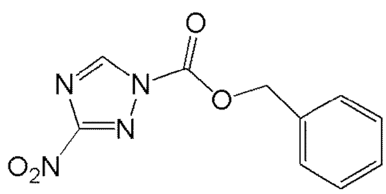

(D-9-2)1-(benzyloxycarbonyl)-3-nitro-1,2,4-triazole

[Synthesis Example 23] Synthesis of 1-(Benzyloxycarbonyl)-1H-Tetrazole (D-10-2)

The imidazole (D-1) in Synthesis Example 14 was changed to 3.50 g of 1H-tetrazole (D-10), and a reaction was performed in the same manner to obtain 1-(benzyloxycarbonyl)-1H-tetrazole (D-10-2), having the following structure. (3.13 g, yield: 61.4%)

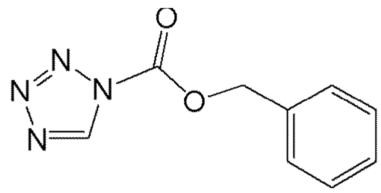

(D-10-2) 1-(benzyloxycarbonyl)-1H-tetrazole

[Synthesis Example 24] Synthesis of N-(Benzyloxycarbonyl)-2,6-Dimethylpiperidine (D-11-2)

The imidazole (D-1) in Synthesis Example 14 was changed to 5.67 g of 2,6-dimethylpiperidine (D-11), a reaction was performed in the same manner, and the process was halted at the concentration under reduced pressure in Synthesis Example 14 to obtain an oily product of N-(benzyloxycarbonyl)-2,6-dimethylpiperidine (D-11-2), having the following structure. (1.87 g, yield: 30.2%)

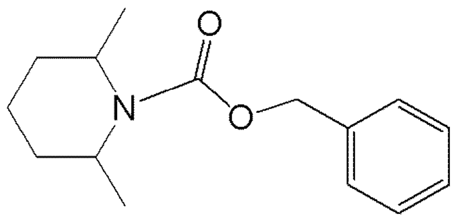

(D-11-2) N-(benzyloxycarbonyl)-2,6-dimethylpiperidine

Note that, as 1-(tert-butoxycarbonyl)-imidazole (D-1-1) and 1-(tert-butoxycarbonyl)-1H-1,2,4-triazole (D-8-1), shown by the following structural formulae, commercially available reagents (Tokyo Chemical Industry Co., Ltd.) were used.

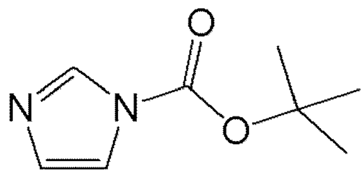

(D-1-1)1-(tert-butoxycarbonyl)-imidazole

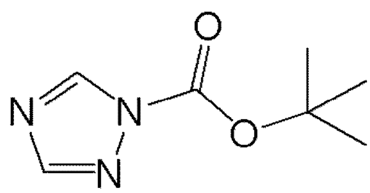

(D-8-1)1-(tert-butoxycarbonyl)-1H-1,2,4-triazole

III. Imide Ring-Closing Temperature

100 parts by weight of the polymer (A-1) synthesized in the above, 5 parts by weight of the nitrogen-containing compounds (D-1-1) to (D-10-2) obtained in the above manner as shown in Table 1 below (Example 1) to (Example 20), and furthermore, 4.0 parts by weight of a photopolymerization initiator (C-1) (N-1919 manufactured by ADEKA CORPORATION) were dissolved in a solvent, γ-butyrolactone (hereinafter, GBL). After that, micro-filtering was applied with a Teflon (registered trademark) 1.0-μm filter to prepare a negative photosensitive resin composition. In addition, a composition to which a nitrogen-containing compound was not added was prepared as Comparative Example **1.**

Subsequently, the composition was applied by rotating a substrate after each of the obtained composition solutions was dispensed by 5 mL on a silicon substrate, that is, by a spin-coating method. After that, the compositions were pre-baked on a hot plate 100°C for 3 minutes. The rotational rate during coating was adjusted such that a finishing film thickness after the pre-baking was 0.9 μm to 1.2 μm.

The applied composition film on the silicon substrate was subjected to exposure on the entire surface with an i-line by using an i-line stepper NSR-2205i11 manufactured by Nikon Corporation with an exposure dose of 600 mJ.

The obtained cured film was heated at temperatures of 100°C to 250°C at 10°C intervals for 1 hour, and then the following FT-IR was used to measure absorption intensity at each temperature by infrared spectroscopy. In addition, the obtained cured film was heated at 300°C for 1 hours, and then the absorption intensity was measured in the same manner.

FT-IR Nicolet iN10 MX (Thermo Fisher Scientific K.K.)

When the polyimide ring-closing reaction of the polymer of the polyimide precursor in the composition film progresses, C-N bonds are newly formed, and therefore, in an IR spectrum, the absorption intensity of 1379 $cm^{-1}$ derived from C-N stretching increases. Meanwhile, the C-C double bonds of a benzene ring do no change even after imidization, and therefore, in an IR spectrum, the absorption intensity of 1552 $cm^{-1}$ derived from C-C stretching of benzene rings does not change. Using this absorption intensity of 1552 $cm^{-1}$ derived from the C-C stretching of the benzene rings as an internal standard, the absorption intensity of 1379 $cm^{-1}$ derived from C-N stretching can be shown by the following formula (30) as the degree of progress of the imide ring-closing reaction at each temperature, that is, the imidization ratio. Thus, the degree of progress of the imidization at each temperature can be compared relatively.

$$\text{Imidization ratio} = \frac{\text{Absorption intensity of 1379 cm}^{-1}\text{ derived from C–N stretching}}{\text{Absorption intensity of 1552 cm}^{-1}\text{ derived from C–C stretching of benzene rings}} \quad (30)$$

The imidization ratio of the cured film after heating at 300°C for 1 hour, calculated by the formula (30), can be regarded as the result when the ring-closing reaction of the polymer of the polyimide precursor to a polyimide has progressed completely. When the imidization ratio of the cured film obtained at the varied temperatures is equal to the imidization ratio of the cured film at 300°C, the temperature in that case can be indicated as a temperature at which the imide ring-closing reaction of the polyimide precursor of the composition film can be performed completely.

For each of Example 1 to Example 20 shown in the following Table 1, regarding the cured film of each of the photosensitive resin compositions respectively containing the nitrogen-containing compounds (D-1-1) to (D-10-2), the lowest temperature at which the imidization ratio was equal to that of the cured film after heating at 300°C for 1 hour has been shown as the imide ring-closing temperature of that composition film.

[Table 1]

| | Nitrogen-containing compound | Imide ring-closing temperature |
|---|---|---|
| Example 1 | D-1-1 | 170°C |
| Example 2 | D-2-1 | 170°C |
| Example 3 | D-3-1 | 190°C |
| Example 4 | D-4-1 | 170°C |
| Example 5 | D-5-1 | 180°C |
| Example 6 | D-6-1 | 170°C |
| Example 7 | D-7-1 | 180°C |
| Example 8 | D-8-1 | 170°C |

(continued)

| | Nitrogen-containing compound | Imide ring-closing temperature |
|---|---|---|
| Example 9 | D-9-1 | 170°C |
| Example 10 | D-10-1 | 170°C |
| Example 11 | D-1-2 | 180°C |
| Example 12 | D-2-2 | 180°C |
| Example 13 | D-3-2 | 190°C |
| Example 14 | D-4-2 | 180°C |
| Example 15 | D-5-2 | 180°C |
| Example 16 | D-6-2 | 180°C |
| Example 17 | D-7-2 | 180°C |
| Example 18 | D-8-2 | 180°C |
| Example 19 | D-9-2 | 180°C |
| Example 20 | D-10-2 | 180°C |
| Comparative Example 1 | Nitrogen-containing compound not added | 230°C |

As shown in Table 1 above, in the Examples, containing a nitrogen-containing organic compound of the present invention, the imidization reaction of the polymer containing the polyimide precursor structure was successfully promoted, and it was possible to perform an imide ring-closing reaction at a low temperature, that is, at 200°C or lower.

IV. Preparation of Photosensitive Resin Composition

Using the polymers containing the polyimide precursors obtained in the above-described Synthesis Example 3 and Synthesis Example 4 as base resins, 35 mass% resin compositions in terms of resin were prepared with the constitutions and blending amounts of the nitrogen-containing compounds of the present invention acquired above described in Tables 2 to **4.** Thereafter, after stirring, mixing, and dissolving, micro-filtering was applied with a Teflon (registered trademark) 1.0-μm filter to obtain a photosensitive resin composition. In the Tables, the solvent GBL represents γ-butyrolactone.

[Table 2]

| | Example 21 | Example 22 | Example 23 | Example 24 | Example 25 | Example 26 | Example 27 | Example 28 | Example 29 | Example 30 |
|---|---|---|---|---|---|---|---|---|---|---|
| | Photosensitive resin composition 1 | Photosensitive resin composition 2 | Photosensitive resin composition 3 | Photosensitive resin composition 4 | Photosensitive resin composition 5 | Photosensitive resin composition 6 | Photosensitive resin composition 7 | Photosensitive resin composition 8 | Photosensitive resin composition 9 | Photosensitive resin composition 10 |
| Polymer | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight |
| Nitrogen-containing organic compound | D-1-1 5 parts by weight | D-2-1 5 parts by weight | D-3-1 5 parts by weight | D-4-1 5 parts by weight | D-5-1 5 parts by weight | D-6-1 5 parts by weight | D-7-1 5 parts by weight | D-8-1 5 parts by weight | D-9-1 5 parts by weight | D-10-1 5 parts by weight |
| Photopolymerization initiator (C-1) | 4 parts by weight | 4 parts by weight | 4 parts by weight | 4 parts by weight | 4 parts by weight | 4 parts by weight | 4 parts by weight | 4 parts by weight | 4 parts by weight | 4 parts by weight |
| Polymerizable compound (B-1) | 10 parts by weight | 10 parts by weight | 10 parts by weight | 10 parts by weight | 10 parts by weight | 10 parts by weight | 10 parts by weight | 10 parts by weight | 10 parts by weight | 10 parts by weight |
| Heat crosslinking agent | Not added | Not added | Not added | Not added | Not added | Not added | Not added | Not added | Not added | Not added |
| Antioxidant (G-1) | 1 parts by weight | 1 parts by weight | 1 parts by weight | 1 parts by weight | 1 parts by weight | 1 parts by weight | 1 parts by weight | 1 parts by weight | 1 parts by weight | 1 parts by weight |
| Silane compound (H-1) | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight |
| Polymerization inhibitor (I-1) | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight |
| Solvent GBL | 180 parts by weight | 180 parts by weight | 180 parts by weight | 180 parts by weight | 180 parts by weight | 180 parts by weight | 180 parts by weight | 180 parts by weight | 180 parts by weight | 180 parts by weight |
| Hole pattern profile | Good | Good | Good | Good | Good | Good | Good | Good | Good | Good |
| Minimum hole diameter | 5 µm | 5 µm | 5 µm | 5 µm | 5 µm | 5 µm | 5 µm | 5 µm | 5 µm | 5 µm |
| Sensitivity | 400 mJ | 400 mJ | 400 mJ | 400 mJ | 400 mJ | 400 mJ | 400 mJ | 400 mJ | 400 mJ | 400 mJ |
| Storage stability | Excellent | Excellent | Excellent | Excellent | Excellent | Excellent | Excellent | Excellent | Excellent | Excellent |
| Chemical resistance | Excellent | Excellent | Excellent | Excellent | Excellent | Excellent | Excellent | Excellent | Excellent | Excellent |

[Table 3]

| | Example 31 | Example 32 | Example 33 | Example 34 | Example 35 | Example 36 | Example 37 | Example 38 | Example 39 | Example 40 |
|---|---|---|---|---|---|---|---|---|---|---|
| | Photo-sensitive resin composition 11 | Photo-sensitive resin composition 12 | Photo-sensitive resin composition 13 | Photo-sensitive resin composition 14 | Photo-sensitive resin composition 15 | Photo-sensitive resin composition 16 | Photo-sensitive resin composition 17 | Photo-sensitive resin composition 18 | Photo-sensitive resin composition 19 | Photo-sensitive resin composition 20 |
| Polymer | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight |
| Nitrogen-containing organic compound | D-1-2 5 parts by weight | D-2-2 5 parts by weight | D-3-2 5 parts by weight | D-4-2 5 parts by weight | D-5-2 5 parts by weight | D-6-2 5 parts by weight | D-7-2 5 parts by weight | D-8-2 5 parts by weight | D-9-2 5 parts by weight | D-10-2 5 parts by weight |
| Photo-polymerization initiator (C-1) | 4 parts by weight | 4 parts by weight | 4 parts by weight | 4 parts by weight | 4 parts by weight | 4 parts by weight | 4 parts by weight | 4 parts by weight | 4 parts by weight | 4 parts by weight |
| Polymerizable compound (B-1) | 10 parts by weight | 10 parts by weight | 10 parts by weight | 10 parts by weight | 10 parts by weight | 10 parts by weight | 10 parts by weight | 10 parts by weight | 10 parts by weight | 10 parts by weight |
| Heat crosslinking agent | Not added | Not added | Not added | Not added | Not added | Not added | Not added | Not added | Not added | Not added |
| Antioxidant (G-1) | 1 parts by weight | 1 parts by weight | 1 parts by weight | 1 parts by weight | 1 parts by weight | 1 parts by weight | 1 parts by weight | 1 parts by weight | 1 parts by weight | 1 parts by weight |
| Silane compound (H-1) | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight |
| Polymerization inhibitor (I-1) | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight |
| Solvent GBL | 180 parts by weight | 180 parts by weight | 180 parts by weight | 180 parts by weight | 180 parts by weight | 180 parts by weight | 180 parts by weight | 180 parts by weight | 180 parts by weight | 180 parts by weight |
| Hole pattern profile | Good | Good | Good | Good | Good | Good | Good | Good | Good | Good |
| Minimum hole diameter | 5 μm | 5 μm | 5 μm | 5 μm | 5 μm | 5 μm | 5 μm | 5 μm | 5 μm | 5 μm |
| Sensitivity | 420 mJ | 400 mJ | 420 mJ | 420 mJ | 420 mJ | 420 mJ | 420 mJ | 420 mJ | 420 mJ | 440 mJ |

(continued)

| | Example 31 | Example 32 | Example 33 | Example 34 | Example 35 | Example 36 | Example 37 | Example 38 | Example 39 | Example 40 |
|---|---|---|---|---|---|---|---|---|---|---|
| | Photo-sensitive resin composition 11 | Photo-sensitive resin composition 12 | Photo-sensitive resin composition 13 | Photo-sensitive resin composition 14 | Photo-sensitive resin composition 15 | Photo-sensitive resin composition 16 | Photo-sensitive resin composition 17 | Photo-sensitive resin composition 18 | Photo-sensitive resin composition 19 | Photo-sensitive resin composition 20 |
| Storage stability | Excellent | Excellent | Excellent | Excellent | Excellent | Excellent | Excellent | Excellent | Excellent | Excellent |
| Chemical resistance | Excellent | Excellent | Excellent | Excellent | Excellent | Excellent | Excellent | Excellent | Excellent | Excellent |

[Table 4]

| | Example 41 | Example 42 | Example 43 | Comparative Example 2 | Comparative Example 3 | Comparative Example 4 | Comparative Example 5 |
|---|---|---|---|---|---|---|---|
| | Photosensitive resin compo-sition 21 | Photosensitive resin compo-sition 22 | Photosensitive resin compo-sition 23 | Photosensitive resin compo-sition 24 | Photosensitive resin compo-sition 25 | Photosensitive resin compo-sition 26 | Photosensitive resin compo-sition 27 |
| Polymer | A-1 100 parts by weight | A-1 100 parts by weight | A-2 100 parts by weight | A-1 100 parts by weight | A-1 100 parts by weight | A-1 100 parts by weight | A-1 100 parts by weight |
| Nitrogen-contain-ing organic com-pound | 0-1-1 5 parts by weight | · D-2-1 5 parts by weight | D-1-1 5 parts by weight | D-11-1 5 parts by weight | D-11-2 5 parts by weight | D-1 5 parts by weight | Not added |
| Photo-polymerization initiator (C-1) | 4 parts by weight | 4 parts by weight | 4 parts by weight | 4 parts by weight | 4 parts by weight | 4 parts by weight | 4 parts by weight |
| Polymerizable compound (B-1) | 10 parts by weight | 10 parts by weight | 10 parts by weight | 10 parts by weight | 10 parts by weight | 10 parts by weight | 10 parts by weight |
| Heat crosslinking agent | F-1 5 parts by weight | F-2 10 parts by weight | Not added | Not added | Not added | Not added | Not added |
| Antioxidant (G-1) | 1 parts by weight | 1 parts by weight | 1 parts by weight | 1 parts by weight | 1 parts by weight | 1 parts by weight | 1 parts by weight |
| Silane compound (H-1) | 0.5 parts by weight | 0.5 parts by weight | 0.5 parts by weight | 0.5 parts by weight | 0.5 parts by weight | 0.5 parts by weight | 0.5 parts by weight |
| Polymerization inhibitor (I-1) | 0.5 parts by weight | 0.5 parts by weight | 0.5 parts by weight | 0.5 parts by weight | 0.5 parts by weight | 0.5 parts by weight | 0.5 parts by weight |
| Solvent GBL | 180 parts by weight | 180 parts by weight | 180 parts by weight | 180 parts by weight | 180 parts by weight | 180 parts by weight | 180 parts by weight |
| Hole pattern profile | Good | Good | Good | Good | Good | Good | Good |
| Minimum hole dia-meter | 5 μm | 5 μm | 5 μm | 5 μm | 5 μm | 5 μm | 6 μm |
| Sensitivity | 400 mJ | 400 mJ | 400 mJ | 400 mJ | 400 mJ | 400 mJ | 400 mJ |
| Storage stability | Excellent | Excellent | Excellent | Good | Good | Good | Good |
| Chemical resistance | Excellent | Excellent | Excellent | Excellent | Excellent | Excellent | Poor |

The photosensitive resin compositions 1 to 23 (Example 21 to Example 43) shown in Tables 2 to 4 relate to the inventive negative photosensitive resin composition described above.
In Tables 2 to 4, the comparative photosensitive resin compositions 24 to 26 (Comparative Example 2 to Comparative Example 4) relate to negative photosensitive resin compositions containing a nitrogen-containing organic compound other than the nitrogen-containing organic compounds used in the inventive negative photosensitive resin compositions described above, for example the nitrogen-containing organic compounds obtained in the above-described Synthesis Examples 13 and 24. There is also an example where a nitrogen-containing compound, imidazole (D-1), other than the nitrogen-containing organic compounds of the present invention were used.
The comparative photosensitive resin composition 27 (Comparative Example 5) has a constitution in which the nitrogen-containing organic compounds used in the inventive negative photosensitive resin compositions were not added.
Note that, in Tables 2 to 4, details of the polymerizable compound (B-1) having a group containing two or more ethylenically unsaturated groups, photo-radical generator (C-1), heat crosslinking agents (F-1) and (F-2), antioxidant (G-1), silane compound (H-1), and polymerization inhibitor (I-1) are as follows. "Parts by weight" has the same meaning as "parts by mass".

Photopolymerization initiator (C-1): N-1919 manufactured by ADEKA CORPORATION

Polymerizable compound (B-1) having a group containing two or more ethylenically unsaturated groups: tetraethylene glycol dimethacrylate

Heat crosslinking agent (F-1):

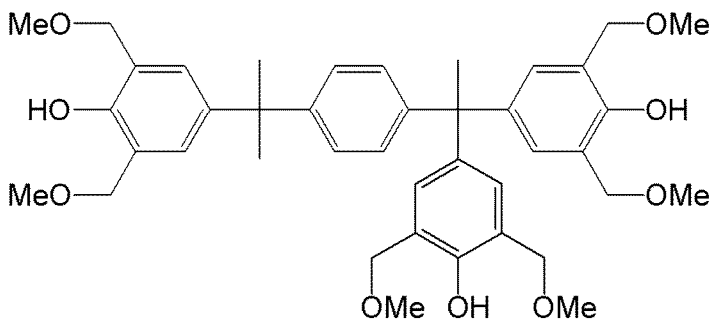

Heat crosslinking agent (F-2):
Epoxy resin: EP4000L manufactured by ADEKA CORPORATION
Antioxidant (G-1):
Hindered phenol-based antioxidant: Sumilizer GA-80 manufactured by Sumitomo Chemical Co., Ltd.
Silane compound (H-1):
Amino silane coupling agent: KBM-573 manufactured by Shin-Etsu Chemical Co., Ltd.
Polymerization inhibitor (I-1):
2-nitroso-1-naphthol (reagent: Tokyo Chemical Industry Co., Ltd.)

V. Pattern Formation

By rotating a substrate after each of the photosensitive resin compositions 1 to 23 and comparative photosensitive resin compositions 24 to 27 was dispensed by 5 mL on a silicon substrate, that is, by a spin-coating method, the photosensitive resin composition was applied such that a film thickness was 5 μm after patterning and heating for the post-curing. That is, by studying in advance that after the post-curing step, the film thickness decreases, the rotational rate during coating was adjusted.
Next, the compositions applied on the substrates were pre-baked on a hot plate at 100°C for 3 minutes. Then, an i-line stepper NSR-2205i11 manufactured by Nikon Corporation was used for i-line exposure and patterning. In the patterning, a mask for positive pattern or negative pattern was used appropriately in accordance with the photosensitive resin compositions used. The mask has a pattern capable of forming 20-μm holes arranged by a fineness ratio of 1:1, and can form a hole pattern of 50 μm to 20 μm holes with a 10-μm pitch, 20 μm to 10 μm holes with a 5-μm pitch, and 10 μm to 1 μm holes with a 1-μm pitch.
In the development step, cyclopentanone was used as the developing solution. For development with an organic

solvent, 1-minute spray development with each organic solvent was performed once, and rinsing was performed with isopropyl alcohol.

Then, the obtained pattern on the substrate was post-cured using an oven at 200°C for 2 hours while the oven was purged with nitrogen.

Next, each substrate was cut out so that the shape of the obtained hole pattern could be observed, and the shape of the hole pattern was observed by using a scanning electron microscope (SEM). The aperture of the smallest opening hole at a film thickness of 5 μm after the post-curing was determined, and the pattern shape was evaluated. Together with these results, the sensitivities at which the minimum pattern was successfully formed are shown together in Tables 2 to 4.

Note that the shape of the hole pattern was evaluated by the criteria as described below, and the evaluation results are shown together in Tables 2 to 4.

Good: holes were observed in a rectangular shape or forward taper shape (the shape in which the dimension of the upper part of a hole is larger than the dimension of the bottom part)

Poor: holes were observed in a reverse taper shape (the shape in which the dimension of the upper part of a hole is smaller than the dimension of the bottom part) or overhang shape (the shape in which the upper part of a hole protrudes), remarkable film thinning was observed, or residue was observed at the bottom part of a hole

VI. Storage Stability

By rotating a substrate after each of the photosensitive resin compositions shown above was dispensed by 5 mL on a silicon substrate in the above-described pattern formation, the composition was applied in the same manner, and then pre-baked on a hot plate at 100°C for 3 minutes. The film thickness after the pre-baking was recorded, and solutions of the photosensitive resin compositions were stored at room temperature for 3 weeks.

After the 3 weeks, films were formed under the same conditions and at the same rotational rate, and the film thickness was measured. The film thickness before storage and the film thickness after storage were compared, and storage stability was evaluated in the following manner.

The film thickness change rate was calculated according to the following formula.

Film thickness change rate (%) = {(film thickness before time passed - film thickness after time passed) / film thickness before time passed} × 100

The calculated film thickness change rate was evaluated according to the following evaluation criteria.

Excellent: a composition in which the fluctuation in the film thickness before and after storage was 10% or less. Good: a composition in which the fluctuation in the film thickness before and after storage was 10% to 15%.
Poor: a composition in which the fluctuation in the film thickness before and after storage was 15% or more.

The evaluation results are shown together in Tables 2 to 4. It can be said that the smaller the film thickness change rate, the better the storage stability of the curable resin composition.

VII. Chemical Resistance

By rotating a substrate after each of the photosensitive resin compositions shown above was dispensed by 5 mL on a silicon substrate in the above-described pattern formation, the composition was applied in the same manner, and then pre-baked on a hot plate at 100°C for 3 minutes. Then, an i-line stepper NSR-2205i11 manufactured by Nikon Corporation was used for i-line exposure to perform exposure of the entire surface without pattern formation at an exposure dose of 600 mJ.

Then, the obtained film on the substrate was post-cured using an oven at 200°C for 2 hours while the oven was purged with nitrogen.

The obtained cured film was immersed in the following chemical solution under the following conditions, and the dissolution rate was calculated. Chemical solution: mixture of dimethyl sulfoxide (DMSO) and a 25 mass% aqueous solution of tetramethylammonium hydroxide (TMAH) at 90 : 10 (mass ratio)
Evaluation conditions: the resin layer was immersed in the chemical solution at 75°C for 15 minutes, the film thicknesses of before and after the immersion were compared, and the change rate of the cured film was measured. The evaluation was carried out according to the following evaluation criteria, and the evaluation results are shown together in Tables 2 to 4. It can be said that the smaller the change rate in the film thickness, the better the chemical resistance of the cured film (resin layer) obtained from the composition.

Excellent: the change rate of the film thickness was less than 3.0 μm.
Good: the change rate of the film thickness was 3.0 μm or more and less than 5.0 μm.
Poor: the change rate of the film thickness was 5.0 μm or more.

As shown from the results of Tables 2 to 4, it can be seen that the negative photosensitive resin compositions containing the nitrogen-containing organic compounds of the present invention are excellent in resolution. Furthermore, it can be seen that storage stability and chemical resistance are also excellent.

On the other hand, it was found that, if a negative photosensitive resin composition containing a compound other than the nitrogen-containing organic compound of the present invention is used, storage stability is poor to some extent (comparative photosensitive resin compositions 24 to 27 (Comparative Example 2 to Comparative Example 5)).

The comparative photosensitive resin composition 27 (Comparative Example 5) is a composition not containing the above-described nitrogen-containing organic compound used in the inventive negative photosensitive resin composition. The chemical resistance of the cured film of this composition was poor compared to the composition containing the nitrogen-containing organic compound of the present invention. This is considered to be because the composition not containing the nitrogen-containing organic compound of the present invention as described above has a high imide ring-closing temperature of 230°C, and under the conditions of 200°C for 2 hours using an oven as in the present evaluation, it was not possible to achieve complete imidization, and chemical resistance, which is an advantage of polyimide, was not exhibited.

The present description includes the following embodiments.

[1]: A negative photosensitive resin composition comprising:

(A) a polymer having a polyimide precursor structure;
(C) a photopolymerization initiator;
(D) a nitrogen-containing organic compound represented by the following general formula (1); and
(E) a solvent,

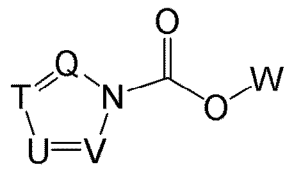

(1)

wherein Q represents a nitrogen atom or a carbon atom having an $R^q$ group, T represents a nitrogen atom or a carbon atom having an $R^t$ group, U represents a nitrogen atom or a carbon atom having an $R^u$ group, V represents a nitrogen atom or a carbon atom having an $R^v$ group, the $R^q$ group, the $R^t$ group, the $R^u$ group, and the $R^v$ group each represent a hydrogen atom, a linear, branched, or cyclic alkyl group having 1 to 15 carbon atoms, an aryl group having 6 to 15 carbon atoms, a halogen atom, or a nitro group, the $R^q$ group and the $R^t$ group, the $R^t$ group and the $R^u$ group, and the $R^u$ group and the $R^v$ group optionally being bonded to each other to form a ring together with the carbon atoms bonded to the $R^q$ group and the $R^t$ group, the $R^t$ group and the $R^u$ group, and the $R^u$ group and the $R^v$ group, and W represents an alkyl group having 1 to 15 carbon atoms or an aryl group having 6 to 15 carbon atoms and is optionally substituted with an alkoxy **group.**

[2]: The negative photosensitive resin composition according to [1], wherein the component (A) is a polymer having a polyimide precursor structure represented by the following general formula (2),

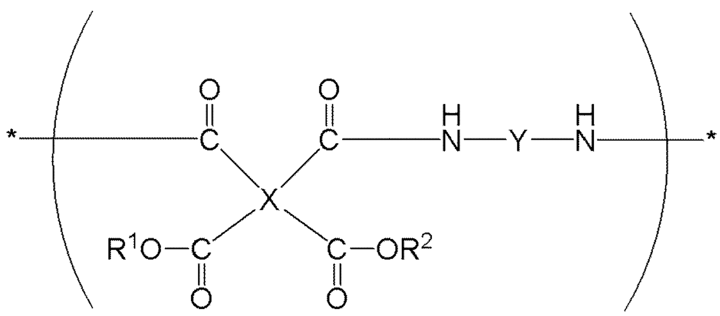

(2)

wherein X represents a tetravalent organic group; Y represents a divalent organic group; and $R^1$ and $R^2$ each independently represent a hydrogen atom or a monovalent organic group, provided that at least one of $R^1$ and $R^2$ is a group represented by the following general formula (3 ,

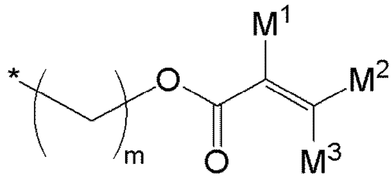
(3)

wherein $M^1$, $M^2$, and $M^3$ each independently represent a hydrogen atom or an organic group having 1 to 3 carbon atoms; "m" represents an integer of 2 to 10; and "*" represents an attachment point.

[3]: The negative photosensitive resin composition according to [1] or [2], further comprising (B) a polymerizable compound having two or more ethylenically unsaturated groups.
[4]: The negative photosensitive resin composition according to any one of [1] to [3], wherein the W in the general formula (1) of the component (D) is a tert-butyl group.
[5]: The negative photosensitive resin composition according to any one of [1] to [3], wherein the W in the general formula (1) of the component (D) is a benzyl group.
[6]: The negative photosensitive resin composition according to any one of [1] to [5], containing 1 to 10 parts by mass of the component (D) based on 100 parts by mass of the component (A).
[7]: The negative photosensitive resin composition according to any one of [1] to [6], comprising, as (F) a heat crosslinking agent, one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (F-1), and a compound containing two or more nitrogen atoms each having a glycidyl group represented by the following formula (F-2),

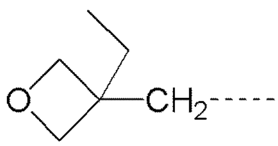
(F-1)

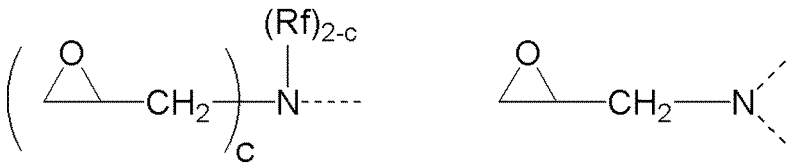
(F-2)

wherein a dotted line represents an attachment point; Rf represents a linear, branched, or cyclic alkyl group having 1 to 6 carbon atoms; and "c" represents 1 or 2.
[8]: The negative photosensitive resin composition according to any one of [1] to [7], further comprising (G) an antioxidant.
[9]: The negative photosensitive resin composition according to any one of [1] to [8], further comprising (H) a silane compound.
[10]: The negative photosensitive resin composition according to any one of [1] to [9], further comprising (I) a polymerization inhibitor.
[11]: A patterning process comprising the steps of:

(1) applying the negative photosensitive resin composition according to any one of [1] to [10] onto a substrate to form a photosensitive material film;
(2) subsequently performing heat treatment and then exposure of the photosensitive material film with a high-energy beam having a wavelength of 190 to 500 nm or an electron beam through a photomask; and
(3) after the exposure, performing development using a developing solution of an organic solvent.

[12]: A method for forming a cured film, comprising heating and post-curing a patterned film obtained by the patterning process according to [11] at a temperature of 100 to 300°C.
[13]: An interlayer insulating film, being a cured film of the negative photosensitive resin composition according to any one of [1] to [10].
[14]: A surface protective film, being a cured film of the negative photosensitive resin composition according to any one of [1] to [10].
[15]: An electronic component comprising the interlayer insulating film according to [13].
[16]: An electronic component comprising the surface protective film according to [14].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A negative photosensitive resin composition comprising:

(A) a polymer having a polyimide precursor structure;
(C) a photopolymerization initiator;
(D) a nitrogen-containing organic compound represented by the following general formula (1); and
(E) a solvent,

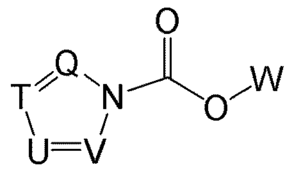

(1)

wherein Q represents a nitrogen atom or a carbon atom having an $R^q$ group, T represents a nitrogen atom or a carbon atom having an $R^t$ group, U represents a nitrogen atom or a carbon atom having an $R^u$ group, V represents a nitrogen atom or a carbon atom having an $R^v$ group, the $R^q$ group, the $R^t$ group, the $R^u$ group, and the $R^v$ group each represent a hydrogen atom, a linear, branched, or cyclic alkyl group having 1 to 15 carbon atoms, an aryl group having 6 to 15 carbon atoms, a halogen atom, or a nitro group, the $R^q$ group and the $R^t$ group, the $R^t$ group and the $R^u$ group, and the $R^u$ group and the $R^v$ group optionally being bonded to each other to form a ring together with the carbon atoms bonded to the $R^q$ group and the $R^t$ group, the $R^t$ group and the $R^u$ group, and the $R^u$ group and the $R^v$ group, and W represents an alkyl group having 1 to 15 carbon atoms or an aryl group having 6 to 15 carbon atoms and is optionally substituted with an alkoxy group.

2. The negative photosensitive resin composition according to claim 1, wherein the component (A) is a polymer having a polyimide precursor structure represented by the following general formula (2),

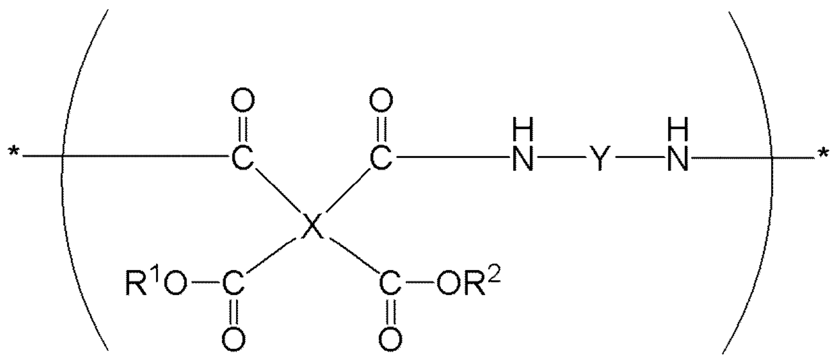

(2)

wherein X represents a tetravalent organic group; Y represents a divalent organic group; and $R^1$ and $R^2$ each independently represent a hydrogen atom or a monovalent organic group, provided that at least one of $R^1$ and $R^2$

is a group represented by the following general formula (3),

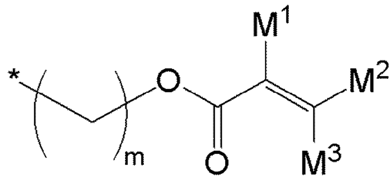
(3)

wherein $M^1$, $M^2$, and $M^3$ each independently represent a hydrogen atom or an organic group having 1 to 3 carbon atoms; "m" represents an integer of 2 to 10; and "*" represents an attachment point.

3. The negative photosensitive resin composition according to claim 1 or 2, further comprising (B) a polymerizable compound having two or more ethylenically unsaturated groups.

4. The negative photosensitive resin composition according to any one of claims 1 to 3, wherein the W in the general formula (1) of the component (D) is a tert-butyl group.

5. The negative photosensitive resin composition according to any one of claims 1 to 3, wherein the W in the general formula (1) of the component (D) is a benzyl group.

6. The negative photosensitive resin composition according to any one of claims 1 to 5, containing 1 to 10 parts by mass of the component (D) based on 100 parts by mass of the component (A).

7. The negative photosensitive resin composition according to any one of claims 1 to 6, comprising, as (F) a heat crosslinking agent, one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (F-1), and a compound containing two or more nitrogen atoms each having a glycidyl group represented by the following formula (F-2),

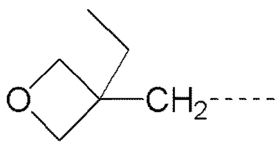
(F-1)

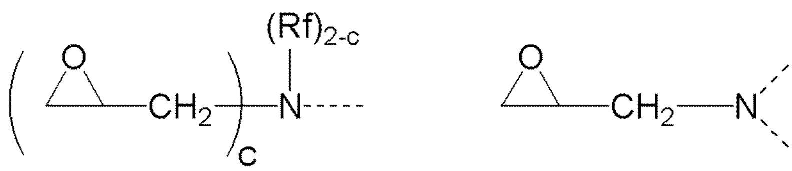
(F-2)

wherein a dotted line represents an attachment point; Rf represents a linear, branched, or cyclic alkyl group having 1 to 6 carbon atoms; and "c" represents 1 or 2.

8. The negative photosensitive resin composition according to any one of claims 1 to 7, further comprising (G) an antioxidant.

9. The negative photosensitive resin composition according to any one of claims 1 to 8, further comprising (H) a silane compound.

10. The negative photosensitive resin composition according to any one of claims 1 to 9, further comprising (I) a polymerization inhibitor.

**11.** A patterning process comprising the steps of:

(1) applying the negative photosensitive resin composition according to any one of claims 1 to 10 onto a substrate to form a photosensitive material film;
(2) subsequently performing heat treatment and then exposure of the photosensitive material film with a high-energy beam having a wavelength of 190 to 500 nm or an electron beam through a photomask; and
(3) after the exposure, performing development using a developing solution of an organic solvent.

**12.** A method for forming a cured film, comprising heating and post-curing a patterned film obtained by the patterning process according to claim 11 at a temperature of 100 to 300°C.

**13.** An interlayer insulating film, being a cured film of the negative photosensitive resin composition according to any one of claims 1 to **10.**

**14.** A surface protective film, being a cured film of the negative photosensitive resin composition according to any one of claims 1 to **10.**

**15.** An electronic component comprising the interlayer insulating film according to claim 13, or
an electronic component comprising the surface protective film according to claim **14.**

Europäisches Patentamt
European Patent Office
Office européen des brevets

# EUROPEAN SEARCH REPORT

Application Number
EP 25 17 1116

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y<br><br>A | US 10 457 779 B2 (SHINETSU CHEMICAL CO [JP]) 29 October 2019 (2019-10-29)<br>* claims 7, 11, 15, 18 *<br>* column 10, line 30 - line 32 *<br>* column 79, line 56 - column 83, line 23 *<br>* column 86; table 4 *<br>----- | 1-5,7-15<br><br>6 | INV.<br>G03F7/037<br>G03F7/038 |
| Y,D<br><br>A | JP 2022 159241 A (ASAHI KASEI CORP) 17 October 2022 (2022-10-17)<br>* paragraph [0001] - paragraph [0003] *<br>* paragraph [0090]; claim 22 *<br>----- | 1-5,7-15<br><br>6 | |
| | | | TECHNICAL FIELDS SEARCHED (IPC) |
| | | | G03F |

The present search report has been drawn up for all claims

1

| Place of search | Date of completion of the search | Examiner |
|---|---|---|
| Munich | 12 June 2025 | Hönes, Roland |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 25 17 1116

This annex lists the patent family members relating to the patent documents cited in the above-mentioned European search report.
The members are as contained in the European Patent Office EDP file on
The European Patent Office is in no way liable for these particulars which are merely given for the purpose of information.

12-06-2025

| Patent document cited in search report | Publication date | Patent family member(s) | Publication date |
|---|---|---|---|
| US 10457779 B2 | 29-10-2019 | EP 3235803 A1 | 25-10-2017 |
| | | JP 6487875 B2 | 20-03-2019 |
| | | JP 2017193500 A | 26-10-2017 |
| | | KR 20170119643 A | 27-10-2017 |
| | | TW 201738198 A | 01-11-2017 |
| | | US 2017298186 A1 | 19-10-2017 |
| JP 2022159241 A | 17-10-2022 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 49115541 A
- JP 55045746 A
- JP 2007056196 A
- JP 7436606 B
- JP 2022159241 A
- WO 2017188153 A1
- WO 2015199219 A1
- JP 2014191002 A
- WO 2011080992 A1
- JP 2014191252 A
- JP 2014041264 A
- WO 2014097594 A1
- JP 2011128358 A
- JP 6414060 B
- WO 2016140024 A1
- JP 5987984 B
- JP 2017044964 A
- JP 2013015701 A
- JP 2009283711 A
- JP 2011059656 A
- JP 2012194520 A